# EUROPEAN PATENT SPECIFICATION

(11) **EP 4 467 631 B1**
(45) Date of publication and mention of the grant of the patent: **14.05.2025**
(21) Application number: 23174607.4
(22) Date of filing: 22.05.2023
(51) Int. Cl.: C09K 11/06, H10K 50/00, C07F 5/02, H10K 85/30

(54) **MIXTURE COMPRISING EUROPIUM-ORGANIC COORDINATION COMPOUND AND METHOD FOR PRODUCING THE SAME**
MISCHUNG MIT EUROPIUM-ORGANISCHER KOORDINATIONSVERBINDUNG UND VERFAHREN ZUR HERSTELLUNG DAVON
MÉLANGE COMPRENANT UN COMPOSÉ DE COORDINATION ORGANIQUE À L'EUROPIUM ET SON PROCÉDÉ DE PRODUCTION

(43) Date of publication of application: 27.11.2024
(73) Proprietor: beeOLED GmbH, 01257 Dresden (DE)
(72) Inventor: Imbrasas, Paulius, 01097 Dresden (DE); Bärschneider, Toni, 01069 Dresden (DE); Mewes, Jan-Michael, 53129 Bonn (DE); Rothe, Carsten, 01099 Dresden (DE)
(74) Representative: Altmann, Andreas

(56) References cited:
- EP-A1- 4 161 941
- WO-A1-2011/090977
- WO-A1-2019/191328
- CN-A- 113 801 148
- CN-A- 113 801 150
- NADI SUAD ET AL: "Solid-Supported Synthesis of Polymerizable Lanthanide-Ion Chelating Lipids for Protein Detection", INORGANIC CHEMISTRY, vol. 44, no. 7, 1 April 2005 (2005-04-01), Easton , US, pages 2234 - 2244, XP093089986, ISSN: 0020-1669, DOI: 10.1021/ic048885t
- RADECKA-PARYZEK W ET AL: "New supramolecular dinuclear Schiff base complexes of yttrium and lanthanides", JOURNAL OF ALLOYS AND COMPOUNDS, ELSEVIER SEQUOIA, LAUSANNE, CH, vol. 323-324, 12 July 2001 (2001-07-12), pages 173 - 176, XP027389862, ISSN: 0925-8388, [retrieved on 20010712]

## Description

### Technical Field

The invention concerns a mixture of a metal-organic coordination compound with a second charge-neutral organic compound wherein the coordination compound comprises one divalent europium coordinated by a polycyclic organic ligand, and organic electronic devices containing the mixture, as well as methods for forming the same.

### Background

Electroluminescent devices that make use of organic light emitting diodes (OLEDs) are state-of-the-art for flat panel display applications used in everyday consumer electronics. For OLEDs, special organic materials, so-called emitters, are employed for the purpose of converting electrical excitation into light emission. For consumer display applications red, green, and blue emitters are needed. However, the development is most exclusively focused on blue emitter materials. The reason is twofold: First, while existing red and green emitter materials do offer high efficiency combined with saturated colors and good chemical stability, today only blue emitter materials with poor light generation efficiency offer reasonable chemical stability. Secondly, advanced consumer display layouts use color conversion to generate the red and green spectral portions from the short wavelength blue emission as this provides certain advantages in manufacturing. Therefore, only blue emitting electroluminescent OLED devices are needed in future displays. Thus, there is an urgent need for a color-saturated deep blue emitter with high efficiency and with high good chemical stability.

Here, coordination compounds based on the intrametallic transition of divalent Europium offer very promising properties: The ground state configuration features a half-filled 4d-shell, resulting in a single narrow Gaussian peak in the emission spectrum. At the same time, the emitting state is the lowest excited state of the materials; no undesired longer-lived states are possible. Moreover, as a heavy metal, Europium readily interconverts singlet and triplet excitons that form upon charge-recombination on organic host materials, such that both can be harvested for light generation with Eu-based emitters, leading to high electroluminescence efficiency. Chemical engineering of the organic ligand allows to tune the emission color through the whole visible spectrum. Especially using electronically hard ligands with N and O as donor atoms, deep-blue and color-pure emission, i.e., with desirable narrow spectral band width and high quantum-yield can be achieved. All of those features that are ideally-suited for display applications have readily been disclosed in prior art WO 2021/244801A1.

Further, the transition responsible for light emission from Eu(II) complexes is intrametallic and thus strongly confined on the Eu atom. Thus, electronically exciting the complex does not weaken any chemical bonds, offering the potential of exceptional chemical stability. Yet, during electroluminescent device operation, hole-trapping on Eu frequently occurs, which corresponds to an oxidation of Eu(II) to Eu(III). Consequently, another mandatory requirement for stable OLED operation is a reversible oxidation/reduction, requiring a stabilization of Eu(II) over Eu(III). This creates a certain challenge, since the most stable oxidation state of Eu is typically the trivalent one. In other words, a stabilization of trivalent europium after it has captured a positive charge must be avoided. This can be accomplished by using rigid coordination environments and chemically soft anions. In this respect, polymacrocyclic (cryptands) ligands are well-suited to provide the necessary rigid chemical environment. Since the ionic radius of Eu(III) is significantly smaller than that of Eu(II), adapting the cavity size of the polymacrocyclic ligand specifically to Eu(II) stabilizes the divalent over the trivalent oxidation state. By coordinating divalent europium using rigid symmetrical polymacrocyclic ligands, yellow-green (Li, J., Wang, L., Zhao, Z. et al. Highly efficient and air-stable Eu(II)-containing azacryptates ready for organic light-emitting diodes. Nat Commun 11, 5218 (2020)) and blue (WO 2021/244801A1) electroluminescent devices have been demonstrated.

Although OLEDs have been demonstrated with Eu(II) emitters based on such symmetric polycyclic ligands, those particular emitters mostly cannot be employed for the mass production of consumer displays. The vast majority of all consumer OLED displays are produced using thermal evaporation or sublimation, which is mostly not possible using the deep-blue-emitting materials based on symmetrical ligand designs disclosed in WO 2021/244801A1. In fact, the green-emitting devices disclosed in Li, J., Wang, L., Zhao, Z. et al. Highly efficient and air-stable Eu(II)-containing azacryptates ready for organic light-emitting diodes. Nat Commun 11, 5218 (2020) were processed using thermal sublimation. However, the sublimation yield was only about 10%. Additionally, significant thermal decomposition has been observed during the sublimation process, which renders this material not suitable for OLED mass production using sublimation. WO 2022/218562A1 discloses, twofold negatively charged polymacrocyclic ligands for Eu(II) for improved thermal vacuum sublimation. The concept is based on the same basic symmetrical cryptand design as Li, J., Wang, L., Zhao, Z. et al. Highly efficient and air-stable Eu(II)-containing azacryptates ready for organic light-emitting diodes. Nat Commun 11, 5218 (2020) and WO 2021/244801A1. However, again mostly only green-emitting Eu(II) compounds are practiced and, once more, the sublimation yield is mostly well below 100%. CN 113 8011 0 A (D1) discloses Europium complexes containing 2 ligands. Each ligand contains hetero aromatic groups linked in a linear sequence, see Eu-1 to Eu-5 in claim 2 and example 1, where for example the hydrotris(3-methyl pyrazolyl) borate is employed as ligand. This ligand resembles the above-mentioned polycyclic aromatic ring systems which have one carbon common to two adjoining rings (like for example in biphenyl). However, the ligands employed are not bicyclic or polycyclic ligands as defined herein.

Thus, as of today, no deep-blue-emitting Eu(II) coordination compound employing a size-discriminating polymacrocyclic ligand that can be processed by thermal evaporation or sublimation with high yield and without significant decomposition is known. The underlying problem is a fundamental one: As long as a pseudo-C3 symmetrical cryptand ligand design is used (consisting of three equally-sized macrocyclic rings) in combination with twofold positively charged Europium, an intrinsically unfavorable chemical structure of the metal-organic complex is obtained in most cases. This is because the asymmetrical arrangement of two anions or anionic groups (which may as well be covalently attached to the ligand) around the C3 symmetric cage typically leads to high dipole moments, resulting in low volatility of the complexes. Alternatively, and resulting in lower dipole moments, small and chemically hard anions or anionic groups may be introduced which form less polar bonds with the central metal. However, this also shifts the emission color from the highly desired deep blue to green, yellow, or even red, compare WO 2022/218562A1. A solution would be the use of asymmetrical aza-cryptand ligand designs that consist of 2 or 3 differently sized macrocyclic rings. By employing such ligands, it is possible to create complexes in which the local dipole moments associated with placing two negative charges next to the central cation largely cancel each other out, resulting in a small total dipole while retaining the deep blue emission color. Therefore, favorable divalent Europium organic emitter molecules should preferably be based on asymmetrical aza-cryptand ligands.

In OLEDs, the emitter molecules are usually embedded into charge transport matrices, usually called hosts. Here, the yellow-green-emitting material based on symmetrical ligand design and disclosed in [Li, J., Wang, L., Zhao, Z. et al. Highly efficient and air-stable Eu(II)-containing azacryptates ready for organic light-emitting diodes. Nat Commun 11, 5218 (2020)] only showed bright emission in a surprisingly small selection of host materials. In most of the disclosed materials, the emission was fully or partially quenched. Qualitatively, this observation is consistent with our own findings regarding highly volatile divalent Europium complexes based on asymmetrical aza-cryptand designs: While mostly highly luminescent in solution, the emission of the complexes was significantly quenched in the vast majority of solid host materials. Only after screening a wide range of emitter - host combinations did we uncover a peculiar set of conditions that helps to maintain the excellent photophysical properties of divalent Europium emitters in solid mixtures.

It is an objective of this invention to provide mixtures of metal-organic Eu(II) complexes comprising asymmetrical aza-cryptands with substantially organic materials that are sufficiently chemically stable and emit deep blue light with high efficiency after both, optical and electrical, excitation. The mixtures are particularly intended for the design of highly efficient multilayer OLED devices by means of gas transfer processes. It is thus a further objective of this invention to enable the excellent photophysical properties of divalent Europium metal organic complexes for mass production of consumer electronics, especially consumer displays and especially using sublimation or evaporation techniques.
The objective is achieved according to the present invention by a mixture of
(a) at least one charge neutral metal-organic coordination compound, comprising a divalent Europium coordinated by a polycyclic organic ligand having the formula (1-1) 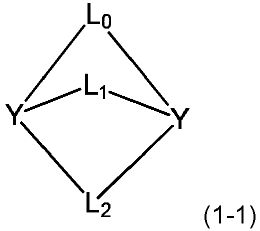 with
   - **Y** independently in each occurrence being selected from Si-R, C-R, B, N, P, preferably N, with **R** being a monovalent organic group formed by removing a hydrogen atom from an organic molecule containing at least one hydrogen atom, and
   - **L₀, L₁, L₂** being independently each a divalent organic group formed by removing two hydrogen atoms from an organic molecule containing at least two hydrogen atoms, with
   - the shortest sequence of atoms linking the two **Y** atoms as part of **L₁,** and **L₂** each being 4 to 7, preferably 5 atoms, with one of those 4 to 7, preferably 5 atoms, preferably one non-terminal carbon atom thereof, each independently being selected from B, N, P, S, O, preferably N, or O, and with
   - the shortest sequence of atoms linking the two **Y** atoms as part of **L₀** being 8 or more atoms, and
(b) at least one second organic compound, which is a charge-neutral host material, wherein the second charge-neutral organic compound has a higher electron binding energy than the charge-neutral metal-organic coordination compound, preferably wherein the second charge-neutral organic compound (b) has an electron binding energy higher than 4.5 eV, preferably higher than 5.3 eV and most preferably higher than 6.0 eV, and wherein compounds (a) and (b) are physically mixed or wherein the second charge-neutral compound (b) has a molecular weight Mₙ above 1000 g/mol and the coordination compound (a) and the second charge-neutral compound (b) are chemically linked with each other, for example by a covalent or coordinative chemical bond
   and by the use of a mixture of the invention as active emitting material in electroluminescent electronics applications.
   and by an organic electronic device, comprising:
      a first electrode,
      a second electrode, and
      a first organic layer arranged such that it is electrically interposed between the first and second electrodes, wherein the first organic layer comprises a mixture of the invention,
      wherein the organic electronic device preferably is an organic light emitting diode,
      emitting preferably substantially in the blue spectra region at <500 nm and by a method of forming an organic electronic device according to one of the invention, the method comprising:
      forming a layer of a mixture of the invention, by deposition from a gas phase,
      preferably using a evaporation and/or sublimation and/or carrier gas process, or by deposition from solution
      and by an organic electronic device, comprising:
         a first electrode,
         a second electrode, and
         an organic layer arranged such that it is electrically interposed between the first and second electrodes, wherein the organic layer comprises a metal organic complex, wherein the metal organic complex comprises a divalent Europium and two singly negatively charged anions selected from (3-1) or two covalently attached anionic fragments selected from (3-4) or (3-5): 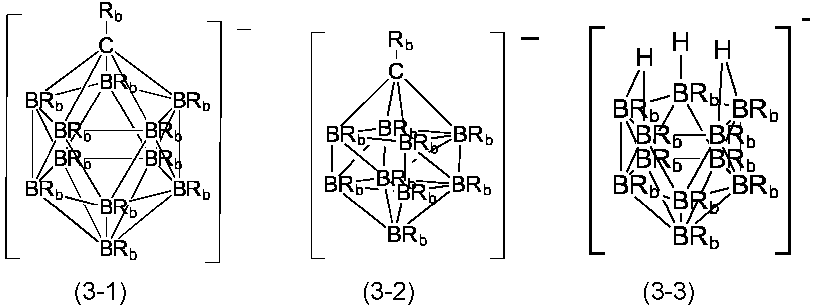 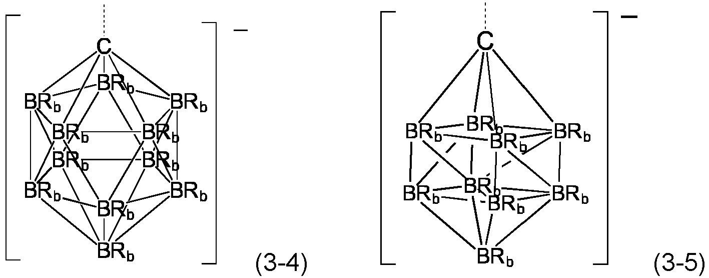 with
            - the dashed lines indicating the covalent linkage to the remainder of the metal organic complex, and
            - **R_{b}** independently in each occurrence represents either hydrogen, deuterium, fluorine, chlorine, bromine, or an alkyl chain, preferably methyl.

The organic layer is deposited from a gas phase, preferably using an evaporation and/or sublimation and/or carrier gas process.

In particular, it was found that in the prior art coordination compounds, the cavity size of the mostly symmetrical polycyclic organic ligands did, in fact, not match the central cation too well, as it was often far too large. Mostly, too large cavity diameters have been employed, since the polycyclic organic ligands were typically based on ring sizes containing 18 atoms. Thus, it is part of this invention to provide geometric stabilization using a rigid polycyclic organic ligand with a cavity size that perfectly matches the size of divalent Europium. This is achieved by allowing only 4-7 atoms as the shortest sequence of **L₁** and **L₂** between the two nitrogen bridgehead atoms. This significantly reduces the cavity size relative to the cryptands disclosed in the prior art where typically 8 atoms form the shortest sequence between the two nitrogen atoms. Additionally, the ligand contains a plurality of hard donor atoms to achieve electronic stabilization and deep blue color point.

Furthermore, a feature of the present invention is to provide distinct asymmetrical polycyclic organic ligands, since at least one of the chemical linkages between the two nitrogen bridgehead atoms is different to the other two. The desired asymmetry allows two singly negatively charged anionic species to integrate in a way that they simultaneously stabilize the central divalent Europium and achieve a small dipole moment of the overall charge-neutral complex, thereby significantly improving its volatility. In combination with the high oxidation-stability of the complexes, or in other words their high electron binding energy, their high chemical stability, high volatility, and highly efficient deep blue emission, the provided metal-organic coordination compounds are perfectly suited for display mass production.

Furthermore, the invention features strict rules on how to choose the charge-transporting host materials such that the favorable emission characteristics of the divalent Europium complex are maintained. In this context, we surprisingly found that the organic host material must have a higher electron binding energy (approximately corresponding to the absolute value of the energy of highest occupied molecular orbital [HOMO] of the organic material) than the Europium coordination compound. Divalent Europium in the metal-organic complex cannot trap an electron as this is energetically extremely unfavorable. Instead, in electroluminescent device configuration the mandatory first step in the light generation process is to capture a hole, which corresponds to oxidizing the Eu(II) in the complex to Eu(III). Thus, the higher electron binding energy of the organic host material relative to the divalent neutral Europium compound (charge neutral metal-organic coordination compound) ensures that the hole is confined to the emitter molecule.

The individual components of the mixture, i.e., the coordination compound (charge neutral metal-organic coordination compound) comprising the asymmetrical ligand according to formula (1-1) and divalent Europium as well as many organic host materials are sufficiently volatile and as such ideally suited for processing using sublimation or evaporation techniques, as used in the mass production of consumer displays today. At the same time, the mixtures are highly luminescent. The combination of the above-mentioned properties enables the straightforward design of very efficient deep-blue-emitting OLED devices with high operational stability. With this combination of ideal emission characteristics, good processing characteristics, and freedom of OLED design the mixtures according to the invention are ideally suited as active emitting materials in electroluminescent (consumer) electronics applications.

### Summary of the invention

In various aspects of this invention mixtures of metal-organic coordination compounds comprising divalent Europium and asymmetrical aza-cryptands with organic materials, methods for making the mixtures, organic electronic devices comprising the same, and methods for synthesizing divalent Europium compounds with asymmetrical aza-cryptands are provided.

The objective is achieved by a mixture of a metal-organic coordination compound (a) with an organic material (b) as defined above and in claim 1. To make use of the potentially excellent emission properties of divalent Europium the luminescent active cation must be sufficiently chemically stabilized to avoid undesired irreversible oxidation of divalent to trivalent Europium. The key ingredient here is the polymacrocyclic ligand according to structure (1-1). Here, **L₁** and **L₂** are connected by two atoms selected from substituted or non-substituted Si, C, B, N, P to form a cyclic crown-ether like fragment, herein referred to as basis ring. In a preferred embodiment, those connecting atoms are two nitrogens. In any case the two atoms are further linked to each other by means of **L₀,** finally forming a polycyclic organic ligand, which in case of nitrogen bridgehead atoms is an aza-cryptand. Critically, to achieve chemically stable complexes, the basis ring must be smaller than the typically used 18-crown-6 motif and as such the shortest sequences of **L₁, L₂** must only be 4-7 atoms, preferably 5 atoms long. Additionally, for good complexation **L₁, L₂** must contain each at least one complexing heteroatom selected from B, N, P, S, O. Yet, polarizable donor-atoms may cause an undesirable red-shift of the emission energy, so preference is given to the heteroatoms N and O. While **L₁** and **L₂** might be identical with up to 7 atoms each, **L₀** must be at least 8 atoms long. Thus, the polymacrocyclic ligand according to formula (1-1) is asymmetrical as the lengths of the shortest sequences of atoms linking **L₀, L₁, L₂** to the bridgehead-atoms Y are different. Here, the two negative charges present in the coordination compound (to charge-neutralize the Eu(II)) are arranged in a way that can result in a low total dipole, which ensures high volatility and, in turn, enables gas-transfer processing. Finally, the organic host material present in the mixture according to the invention must have a higher electron binding energy compared to the Europium coordination compound (1-1). This ensures that a positive charge - a perquisite for electroluminescent light generation - is confined on the coordination compound.

In a preferred embodiment, the second charge-neutral organic host compound (b) has an electron binding energy higher than 4.5 eV, preferably higher than 5.3 eV and most preferably higher than 6.0 eV. Generally, high electron binding energies correlate with chemical stability, especially during reversible oxidation and reduction in electroluminescent device operation. As the electron binding energy of the host material sets the upper limit for the metal-organic coordination compound imbedded into it, this preferred embodiment also ensures the desirable high oxidation stability for the divalent Europium-based emitter. Component (a) is imbedded in the host material in the final application. The above embodiments describe what is commonly known as hole-trapping on the emitter molecule. In a second step, the so-called charge-recombination, the positively charged emitter molecule accepts an electron into a 5d orbital, forming the charge-neutral emitting molecule in an electronically excited state. In order to ensure high luminescence efficiency, the captured electron as well as the excitation energy should be confined to the emitter in the electronically excited state. The lowest excited state of the vast majority of organic molecules is the first excited triplet state. Thus, in a preferred embodiment, the second charge-neutral organic compound (b) has a higher triplet energy compared to the energy of the coordination compound (a) in its lowest electronically excited state to avoid transfer of the excitation energy from the emitter to the host.

Typically, compound (b) is the only host material. Same content of additional host materials is possible, but not preferred. If present, the following applies: Preferably, at least 50 wt-%, more preferably at least 70 wt-%, most preferably at least 95 wt% (with a maximum of 100 wt-% which is most preferred) of the host material in the mixture and in an emitting layer of an organic electronic device are composed of the at least one compound (b) as defined herein. The amount of additional host components should not impair or affect the electronic relationship between compounds (a) and (b) in the mixture of the invention.

In a preferred embodiment, the mixtures according to the invention emit substantially in the deep blue spectral region below 496 nm, preferably below 477 nm, or even more preferred below 459 nm. To confine the excitation energy on a such deep blue emitting coordination compound, in a preferred embodiment, the second organic host compound (b) has a triplet energy preferably higher than 2.5 eV, more preferably higher than 2.6 eV, and most preferably higher than 2.7 eV. In this context, "substantially" means that at least 50%, preferably at least 65%, more preferably at least 80% of the emission or of the integral under the wavelength emission spectrum are below the above thresholds and/or that the peak of a Gaussian emission spectrum is a shorter wavelength compared to the preferred boundary wavelength defined above.

Once the coordination compound is excited, either optically or electrically, another requirement for efficient light emission is that the excitation, or, in other words, the excited electron is also confined to the coordination compound. This mainly implies that the electron excited from the 4*f* to the 5*d* shell should preferably not be transferred from the electronically excited coordination compound to the surrounding host material, thereby forming a charge-transfer state. Thus, in a preferred embodiment, the second charge-neutral organic compound (b) has an electron affinity or electron binding energy (approximately corresponding to the absolute value of the energy of the lowest unoccupied molecular orbital [LUMO]) that is lower than the electron binding energy of the metal-organic coordination compound (a) in its lowest electronically excited state. LUMO and thus the electron binding energy can be determined by for example be quantified using simple Quantum mechanical methods, as for example demonstrated in detail in the experimental section below.

Considering the typical energy levels involved in metal-organic complexes with divalent Europium, we derive that a preferred embodiment, the second organic compound (b) has an electron affinity or electron building energy higher than 2.0 eV.

The concentration of the emitting coordination compound (a) inside the second organic material (b) may span a very wide range. Rather low concentrations may be preferred if they are intended for color-conversion applications. Somewhat higher concentrations may be preferred if the mixture is used in an electroluminescent device, where efficient charge trapping is needed. Therefore, in preferred embodiments the coordination compound (a) is imbedded into the at least one second charge-neutral organic compound (b) at preferably 0.1 - 99.0 vol%, more preferably at 1 - 90 vol%, and most preferably at 3 - 30 vol%, based on the mixture which is 100 vol%.

In order to avoid geometric relaxation, leading to undesired large Stokes Shifts and large stabilization of Eu(III) over Eu(II), rigid ligands are generally preferred. This may be achieved and rigid ligands of formula (1-1) can be obtained by incorporation of one or more, preferably 1 to 6, more preferably 1 to 4, most preferably 1 to 3 aryl and/or heteroaryl groups as part of the complexing parts of the polycyclic ligand, i.e., in **L₀, L₁** and/or **L₂.** Such (hetero) aromatic units may as well improve the charge transport or charge capture properties of the metal organic coordination compounds. Yet, preference is given to (hetero) aromatic groups with sufficiently high triplet energy to confine the excitation to the central Europium atom and, again, preference is given to relatively strong electron-donating aromatic groups without heteroatoms or with only oxygen or nitrogen as heteroatoms. Each (hetero) aromatic group(s) preferably contain(s) 1 to 5, more preferably 1 to 4, most preferably 1, 2 or 3, preferably fused or annelated, ring structures, preferably (hetero) aromatic) ring structures that contain 0 or 1 non (hetero)aromatic ring, like in a benzofuran group. Therefore, in preferred embodiments, the polycyclic organic ligand according to formula (1-1) is selected from aza-cryptands according to the generic formulae (1-2) to (1-4): 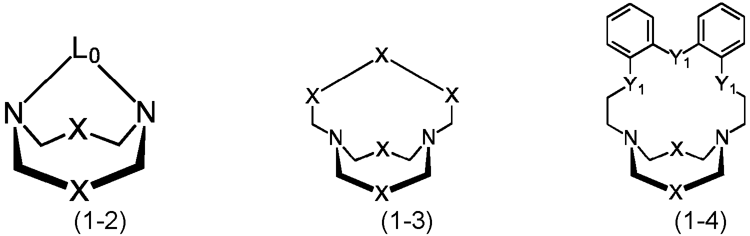 with
- **X** being independently in each occurrence selected from (2-1) to (2-9), preferably from (2-2), (2-4), or (2-5): 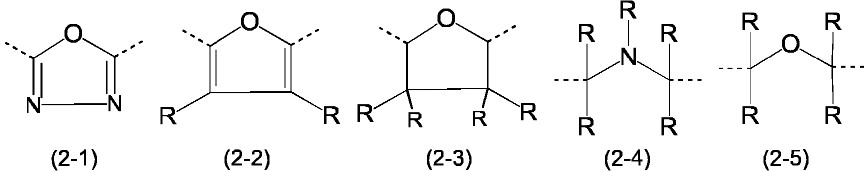 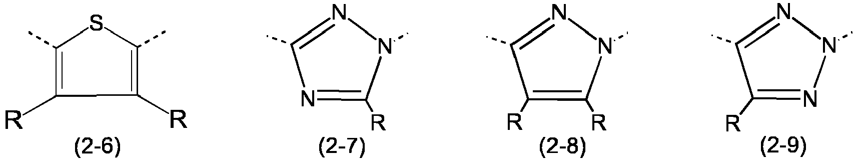
- **Y₁** being independently in each occurrence selected from B-R, N-R, P-R, O, S, preferably from N-R, O, and with
- **R** being **H,** D, or any covalently bound substituent being identical or different in each occurrence, and
- the dashed lines indicating the covalent linkage to the remainder of the polycyclic ligand.
These embodiments are all based on the ideal-sized 12-crown-4 motif with just 5 atoms as part of the shortest sequences of L1, L2 i.e., as basis ring giving sufficient stabilization of divalent over trivalent Europium.

The europium in the emissive coordination compound (a) as part of the mixture is twofold positively charged. In various embodiments the coordination compound comprises an asymmetrical ligand according to formula (1-1) and two singly negatively charged anions that are not covalently linked to the polycyclic organic ligand according to formula (1-1). This is to ensure charge-neutrality once the organic ligand is coordinating the positively charged cation. If, for example, the polymacrocyclic organic ligand according to formula (1-1) is charge-neutral and combined with divalent Eu, then two singly negatively charged anions are necessary to form the overall charge-neutral coordination compound (a). Those negatively charged counterions or anions can be any desired molecules that fulfil the above-mentioned requirements, i.e., preferably having sufficiently high triplet energy and no strong chemical interaction with Europium, so that the above electron binding requirement is fulfilled. Yet, in a preferred embodiment, those two singly negatively charged anions each individually comprise more than 1 atom, preferably more than 3 atoms and/or may have a mass of more than 128 g/mol. This prevents an undesired drift of the non-covalently bound anions of the coordination compound within the mixture according to invention, especially in an electroluminescent device configuration. Additionally, preferred anions are chemically inert, lightweight, do not strongly interacting with the central Eu, which typically requires the anions to be chemically soft, and do not absorb light with a wavelength in the range of 380-700 nm, more preferably in the range 430-500 nm. Anions with these desired properties are preferably selected from *closo*-carborates or *nido*-borane clusters, preferably from closo-carborates according to formula (3-1) and (3-2) or nido-borane clusters according to formula (3-3) 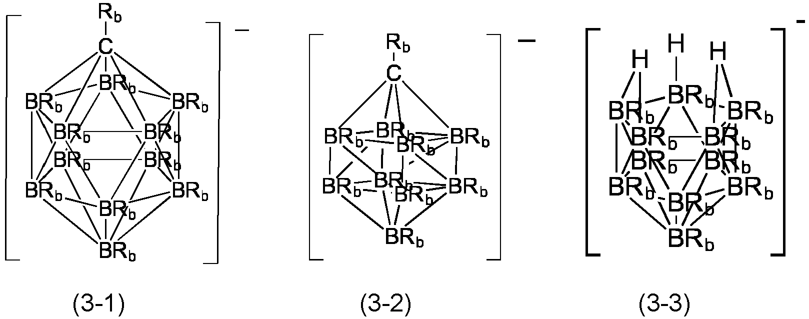 with **R_{b}** independently in each occurrence representing either hydrogen, deuterium, fluorine, chlorine, bromine, or a C₁₋₁₂-, preferably C₁₋₆-, more preferably C₁₋₃-alkyl chain - preferably methyl.

In another embodiment the polymacrocyclic ligand according to formula (1-1) itself is already twofold negatively charged. Thus, in combination with the divalent Eu cation a coordination compound of neutral charge is formed, and no free anions are present as part of the coordination compound and therefore as part of the mixture according to the invention. Such compounds (1-1) without free (i.e., non-covalently bonded) negatively charged anions might be beneficial in electroluminescent device applications, where those anions may drift during operation in high electrical fields, leading to short device lifetimes and hysteresis effects.

There are various ways to introduce and covalently attach the two negative charges into the ligand according to formula (1-1). In one embodiment, the two negative charges are present in form of two anionic side groups. Again, in view of the desire to have a sufficiently high triplet level, low polarizability, chemical stability, low molecular weight, and suitable energy levels, are preferable, so preference is given to covalently attached carborate cluster fragments, preferably selected from (3-4) or (3-5) 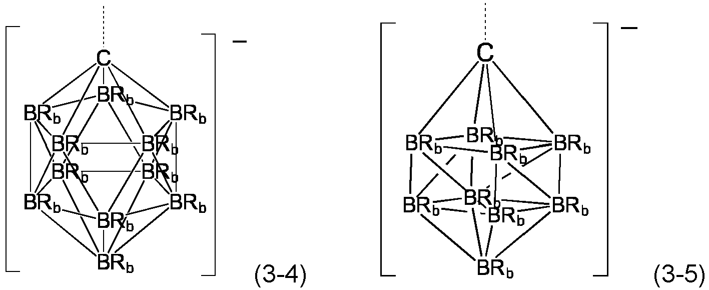 with the dashed lines indicating the covalent linkage to the remainder of the polycyclic ligand, and **R_{b}** independently in each occurrence representing either hydrogen, deuterium, fluorine, chlorine, bromine, or an C₁₋₁₂-, preferably C₁₋₆-, more preferably C₁₋₃-alkyl chain - preferably methyl.

In further preferred embodiments, the coordination compound (a) present in the mixture according to the invention is selected from E01 to E08: 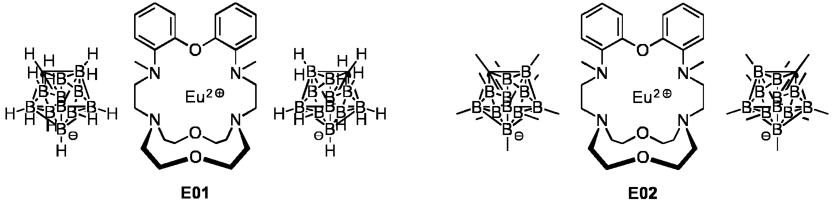 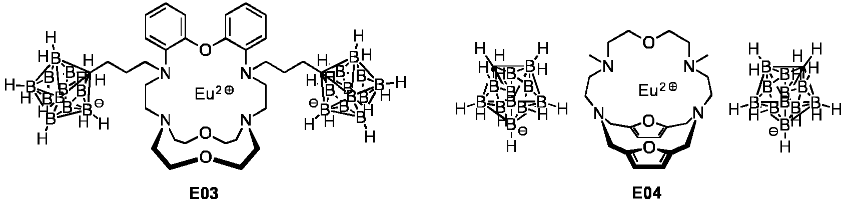 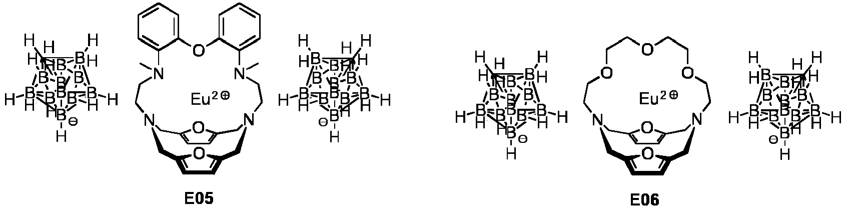 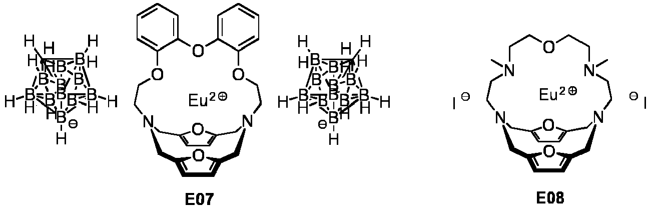 This molecular design ensures a favourable size of the basis ring, i.e., the cyclic crown ether motif comprises the two shortest sequences of atoms of **L₁** and **L₂** linked by the two bridging nitrogen atoms of 5 atoms each. Simultaneously, the basis rings exclusively comprise of complexing units that do not cause an undesired red-shift of the emission color, i.e., oxygen or furan as hetero atom or hetero aromatic group. **L₀** is much longer compared to **L₁** and **L₂,** with a shortest sequence of 11 atoms, giving a distinctly asymmetrical ligand according to formula (1-1). As a result, the anions or anionic groups can coordinate to the metal cation by entering the two identical larger crown-type ring structures formed by **L₁** and **L₀;** and **L₀** and **L₂,** respectively. Finally, the free anions, (e.g. closo-carborates, or iodides) or the covalently attached anions like covalently attached (closo-)carborates cluster fragments, are lightweight, chemically inert, do not absorb light with a wavelength in the range of 380-700 nm, more preferably in the range of 430-500 nm, and are chemically soft to ensure the desired deep blue emission from the metal-organic coordination compound.

In various embodiments, the second organic material (b) may serve as charge transporting host to enable electrical excitation of the coordination compound (a) present in the mixture according to the invention. To achieve this desired functionality without severely compromising the triplet energy level, the second charge-neutral compound in preferred embodiments comprises (hetero)arene fragments derived from benzene, pyridine, pyrrole, furan, carbazole, dibenzofuran, triazine, triazole, or benzofuran by removing one or two hydrogen atoms.

In various alternative embodiments the second charge-neutral compound (b) has a molecular weight Mₙ above 1000 g/mol, and the coordination compound (a) and the second charge-neutral compound (b) are chemically linked with each other, for example by a covalent or coordinative chemical bond. Here the mixture is a polymeric compound, which might have benefits in terms of very high glass transition temperatures, or it may ease the processing of the mixtures using wet solution techniques.

In various preferred embodiments, the mixture according to the invention is used in an organic electronic device, comprising a first electrode, a second electrode, and a first organic layer arranged such that it is electrically interposed between the first and second electrodes, wherein the organic layer comprises a mixture according to the various embodiments described above, preferably a composition containing at least 50 vol%, more preferably at least 80 vol%, most preferably at least 95 vol% of the mixture of (a) and (b) as emitter and host materials. Preferably no host apart from compound (b) is employed in the (first) organic layer. Further preferred are embodiments, with the organic electronic device being an organic light emitting diode, emitting preferably substantially in the blue spectra region at < 500 nm. The term "substantially" is defined as above. In other words, the electroluminescent device emits mostly in the desired deep blue spectral region urgently needed for consumer display applications. In many organic device embodiments, the organic layer comprising the mixture that includes the coordination compound (a) according to various embodiments described above is in physical contact with a second substantially organic layer, which contains an organic material, i.e., they form a sequence or a stack. In such situation, it is preferred that the organic material present in the second layer
(i) has a higher electron binding energy than the charge-neutral coordination compound (a), (ii) and/or has a higher triplet energy than the emission energy of the coordination compound (a), and (iii) and/or has an electron affinity that is lower than the electron binding energy of the coordination compound (a) in its lowest electronically excited state. This ensures that the same favourable conditions for the organic material that are needed to confine the excitation on the coordination compound within the mixture are equally present at the interface of the layer comprising the mixture according to the invention with neighbouring layers typically present in organic electronic devices.

In another embodiment, the (first) organic layer comprising mixture including the luminescent coordination compound (a) has no further organic materials present. In organic device configuration, light emission will typically take place at the interface with neighbouring charge transport materials. Again, in this situation it is preferred that the excitation and the charges are confined on the coordination compound (a) present in the pure layer of the mixture of (a) and (b), thereby avoiding excitation or charge leakage into the nearby charge transport materials. Thus, in preferred embodiments, an organic electronic device comprises a first electrode, a second electrode, and a sequence of a first and a second organic layer arranged such that they are electrically interposed between the first and second electrodes, wherein the first organic layer consists substantially of a metal organic coordination compound (a) comprising divalent Europium and compound (b), and wherein the second organic layer comprises an organic material that has (i) a higher electron binding energy than the charge-neutral coordination compound (a), (ii) and/or having a higher triplet energy compared to the emission energy of coordination compound (a) present in the first organic layer being in its lowest electronically excited state, (iii) and/or having an electron affinity that is lower than the electron binding energy of the coordination compound (a) in the first organic layer in its lowest electronically excited state.

In another embodiment, a layer comprising a mixture according to any of the embodiments described above is deposited, preferably from gas phase, in particular using evaporation and/or sublimation and/or carrier gas processes. Indeed, thermal sublimation and/or evaporation are the standard processes used in industrial consumer display production processes. Alternatively, the coordination compound applied in the organic electronic device is deposited from solution, which may offer advantages in terms of throughput or production cost.

### Brief Description of the Drawings

In the drawings, like reference characters generally refer to the same parts throughout the different views. The drawings are not necessarily to scale, emphasis is instead generally being placed upon illustrating the principles of the invention. In the following description, various aspects of the invention are described with reference to the following drawings, in which:
**FIG. 1** exemplifies ligands that might be part of the metal-organic compound comprised in the mixture according to the invention.
**FIG. 2** exemplifies metal-organic complexes that might be present in the mixture according to the invention.
**FIG. 3** illustrates various organic materials which can be present in the mixture according to the invention.
**FIG. 4, FIG. 5,** and **FIG. 6** illustrate schematic cross sections of organic electronic devices according to various aspects.
**FIG. 7** depicts emission spectra of various coordination compounds potentially present in the mixture according to the invention.
**FIG. 8** depicts excited state lifetime data of various mixtures according and not according to the invention.

### Detailed Description

The following detailed description refers to the accompanying drawings that show, by way of illustration, specific details and aspects in which the invention may be practiced.

The word "exemplary" is used herein to mean "serving as an example, instance, or illustration". Any aspect or design described herein as "exemplary" is not necessarily to be construed as preferred or advantageous over other aspects or designs.

Various embodiments relate to mixtures comprising a metal-organic coordination compound containing divalent Europium coordinated by a polycyclic organic ligand and the applications of those compounds.

In this description, a coordination compound is taken to mean a compound where the central active metal, Europium, is coordinated without a direct metal carbon bond. The terms complex, (metal-organic) coordination compound, and emitter (molecule) will be used interchangeably.

Polymacrocyclic, poly-macrocyclic or polycyclic, bis-cyclic are used interchangeably and refer to a molecule where two given atoms selected from Si, C, B, N, P are at least three times linked with each other using at least partially aliphatic organyl groups. In this particular description the two threefold linked atoms are preferably nitrogen atoms, resulting in molecules known as aza-cryptands.

The "aza" designation in the fragments described herein, i.e., aza-cryptate, etc. means that one or more carbon atom or (other) heteroatom of a parent compound is replaced by a nitrogen atom, without any limitation. For example, in a crown ether, -O-is replaced by -NH- to give the respective aza-crown ether. One of ordinary skill in the art can readily envision other nitrogen analogs of the aza-derivatives, and all such analogs are intended to be encompassed by the terms as set forth herein.

As used herein, "deuterium" refers to an isotope of hydrogen. Deuterated compounds can be readily prepared using methods known in the art.

It is to be understood that when a molecular fragment is described as being a substituent or otherwise attached to another moiety, its name may be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

The terms "halo," "halogen," and "halide" are used interchangeably and refer to fluorine, chlorine, bromine, and iodine.

In this description, the arylene is a divalent organic fragment that is derived from an aromatic or heteroaromatic hydrocarbon (arene or heteroarene) by removing two hydrogen atoms from the aromatic or heteroaromatic hydrocarbon, preferably from different carbon and/or hetero atoms. One example is a (hetero) aromatic hydrocarbon that has had hydrogen atoms removed from two, preferably adjacent, hydrogen-bearing atoms (in case of aromatic hydrocarbon two carbon atoms, in case of heteroaromatic hydrocarbons two atoms selected from carbon and heteroatoms). An aromatic hydrocarbon or arene (or sometimes aryl hydrocarbon) is a cyclic hydrocarbon comprising only sp²-hybridized carbon atoms, leading to a delocalized π-system. An alkylene is a divalent organic fragment that is derived from an alkyl group by removing one additional substituent.

The term "alkyl" refers to and includes both straight and branched alkyl chain radicals and can furthermore also include cycloalkyl radicals. Preferred alkyl groups are those containing from one to fifteen, preferably one to ten, more preferably one to five carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group is optionally substituted, e.g., by halogen, preferably fluorine, or cycloalkyls.

The term "cycloalkyl radical" refers to and includes monocyclic, polycyclic, and spiro alkyl radicals. Preferred cycloalkyl groups are those containing 3 to 12, preferably 3 to 8 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group is optionally substituted, e.g., by halogen, deuterium, alkyl or heteroalkyl.

The terms "heteroalkyl" or "heterocycloalkyl" refer to an alkyl or a cycloalkyl radical, respectively, having at least one carbon atom replaced by a heteroatom. Preferably the at least one heteroatom is selected from O, S, N, P, B, and Si, more preferably O, or N. Preferably 1 to 5, more preferably 1 to 3, most preferably 1 or 2 heteroatoms are present in the radical. The radical can be covalently linked with the remainder of the molecule via a carbon or heteroatom (e.g., N). Additionally, the heteroalkyl or heterocycloalkyl group is optionally substituted as indicated for alkyl and cycloalkyl.

The term "alkenyl" refers to and includes both, straight and branched chain alkene radicals. Alkenyl groups are essentially alkyl groups with more than one carbon atom that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one, preferably 1 to 5, more preferably 1 to 3, most preferably 1 or 2 carbon atoms replaced by a heteroatom. Preferably, the at least one heteroatom is selected from O, S, N, P, B, and Si, more preferably O, S, or N. Preferred alkenyl/cycloalkenyl/heteroalkenyl groups are those containing two/three/one to fifteen carbon atoms. Additionally, the alkenyl, cycloalkenyl, or heteroalkenyl group is optionally substituted, as indicated above.

The terms "aralkyl" or "arylalkyl" are used interchangeably and refer to an alkyl group that is substituted with an aryl group. Additionally, the aralkyl group is optionally substituted, as indicated for alkyl and aryl.

The term "heterocyclic group" refers to and includes aromatic and non-aromatic cyclic radicals containing at least one, preferably 1 to 5, more preferably 1 to 3 heteroatoms. Preferably at least one heteroatom is selected from O, S, N, P, B, and Si, more preferably O, S, or N. Hetero-aromatic cyclic radicals may be used interchangeably with heteroaryl. Preferred hetero-non-aromatic cyclic groups are those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted, e.g., by halogen, deuterium, alkyl or aryl. The heterocyclic group can be covalently linked with the remainder of the molecule via carbon and/or heteroatoms, preferably one carbon or nitrogen atom. The heterocyclic group can as well be linked to the remainder of the molecules with two carbon and/or heteroatoms. In such a case, the heterocyclic group can be part of the scaffolding of the polymacrocyclic ligand according to formula (1-1).

The term "aryl" refers to and includes both, single-ring aromatic hydrocarbon groups and polycyclic aromatic ring systems. The polycyclic rings may have two or more rings in which two carbons are common to two adjoining rings (the rings are "fused"), or wherein one carbon is common to two adjoining rings (e.g., biphenyl), wherein at least one of the rings is an aromatic hydrocarbon group, e.g., the other rings can be cycloalkyls, cycloalkenyls, aryl, heterocycles, and/or heteroaryls. Preferred aryl groups are those containing three to eight aromatic carbon atoms. Especially preferred is an aryl group having six carbons. Suitable aryl groups include phenyl and radialene. Most preferred is phenyl that can be substituted by non-aromatic groups. Additionally, the aryl group is optionally substituted, e.g., by halogen, alkyl, heteroalkyl, or deuterium. The aryl group is connected to the remainder of the ligand via one or two carbon atoms.

The term "heteroaryl" refers to and includes both, single-ring aromatic groups and polycyclic aromatic ring systems that include at least one heteroatom. The heteroatoms include, but are not limited to and are preferably selected from O, S, N, P, B, and Si. In many instances, O, S, or N are the preferred heteroatoms. Heteroaromatic ring systems with a single heteroatom are preferably single rings with five or six ring atoms, and the ring can have from one to five or six, preferably one to three heteroatoms. The hetero-polycyclic ring systems can have two or more rings in which two atoms are common to two adjoining rings (the rings are "fused"), or wherein one carbon is common to two adjoining rings (e.g., bipyridine), wherein at least one of the rings is a heteroaryl, e.g., the other rings can be cycloalkyls, cycloalkenyls. The hetero-polycyclic aromatic ring systems can have from 1 to 5, preferably 1 to 3 heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyrrole, pyrazole, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably 1,3,4-Oxadiazole, furan, thiophene, 1,2,4-triazole, 1,2,3-triazole, and pyrazole groups, from which one hydrogen atom has been removed from a hydrogen-bearing carbon or heteroatom to form the covalent link to the remainder of the molecule. The heteroaryl group with two hydrogens removed can as well be linked with two carbon and/or heteroatoms with the remainder of the molecules, in which case the heteroaryl group can be part of a larger cyclic group. Additionally, the heteroaryl group is optionally substituted, e.g., by halogen, deuterium, alkyl or aryl.

Generally, aryl and heteroaryl groups with triplet level > 2.5 eV or more, preferably >2.6 eV, or most preferably > 2.7 eV such as the groups derived from benzene, furan, dibenzofuran, dibenzoselenophene, carbazole, imidazole, pyridine, pyrazine, pyrimidine, triazine, and the respective aza-analogs of each thereof are of particular interest. There are many possible ways to probe the triplet energy level of an organic molecule. A simple way is to use suitable quantum mechanical calculations. A more experimental way takes the onset of the phosphorescence spectrum, which is usually detected using gated spectroscopy, as pioneered by Romanovskii et al. "Phosphorescence of π-conjugated oligomers and polymers." Physical Review Letters 84.5 (2000): 1027. In combination with high triplet energy, generally preference is given to benzene or weakly polarizable, chemically hard heteroaryl groups, such as 1,3,4-Oxadiazole, furan, thiophene, 1,2,4-triazole, 1,2,3-triazole, and pyrazole carbazole, dibenzofuran, and benzofuran groups.

The alkyl, cycloalkyl, heteroalkyl, heterocycloalkyl, alkenyl, cycloalkenyl, heteroalkenyl, alkynyl, aralkyl, heterocyclic group, aryl, and heteroaryl groups or residues, as used herein, are independently unsubstituted, or independently substituted, with one or more (general) substituents, preferably the substituents mentioned below. Any type of substituent can replace a hydrogen atom in an organic or heterorganic group of compound (a) or (b) or the second organic layer above, as long as it results in a chemical compound which is stable under conditions that occur in an OLED display device or organic electronic device and which does not chemically react with other compounds and components of the OLED display device or organic electronic device.

Preferably, the (general) substituents are selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof with the number of carbon atoms and heteroatoms as defined above for the respective term. Furthermore, one or two substituents can be selected from polymer chains which can be covalently linked with the remainder of the molecule by a suitable organic spacer. Therefore, the cyclic organic ligand can be covalently linked with a polymer chain or a polymer backbone.

In some instances, the preferred general substituents are selected from the group consisting of deuterium, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term.

In yet other instances, the more preferred general substituents are selected from the group consisting of deuterium, alkyl, cycloalkyl, aryl, heteroaryl, and combinations thereof with the number of carbon atoms and heteroatoms as defined above for the respective term.

The terms "substituted" and "substitution" refer to a substituent other than H that is bonded to the relevant position, e.g., a carbon or nitrogen. For example, when R represents mono-substitution, then one R must be other than H (i.e., a substitution). Similarly, when R represents di-substitution, then two of R must be other than H. Similarly, when R represents no substitution, R, for example, can be a hydrogen for available valencies of straight or branched chain or ring atoms, as in carbon atoms for benzene and the nitrogen atom in pyrrole, or simply represents nothing for ring atoms with fully filled valencies, e.g., the nitrogen atom in pyridine. The maximum number of substitutions possible in a straight or branched chain or ring structure will depend on the total number of available valencies in the ring atoms or number of hydrogen atoms that can be replaced. All residues and substituents are selected in a way that a chemically stable and accessible chemical group results.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include thirty to forty atoms that are not hydrogen or deuterium, or those that include up to 30 atoms that are not hydrogen or deuterium counted for all substituents of a given molecule, or for the respective molecule in total. In various embodiments, a combination of substituent groups will include up to twenty atoms that are not hydrogen or deuterium, counted for all substituents of a given molecule.

In some instances, a pair of adjacent residues can be optionally joined (i.e., covalently linked with each other) or fused into a ring. The preferred ring formed therewith is a five-, six-, or seven-membered carbocyclic or heterocyclic ring, including both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, or 2,3-positions in a phenyl, or 1,2-positions in a piperidine, as long as they can form a stable fused ring system. In some instances, a pair of non-adjacent substituents can be optionally joined usually by an, at least partial, alkane or heteroalkene chain of atoms, thereby forming another macrocyclic ring system as part of the polymacrocyclic ring present as part of the coordination compound. In some instances, a pair of substituents present on the same carbon atom can be optionally joined, i.e., into an aryl or heteroaryl group, thus, forming a spiro linkage at the given carbon atom.

In this description, the term organyl refers to any chemically stable organic arrangement of atoms where one or more hydrogen atom has been removed such as to use those free vacancies to covalently link the organic group with another molecular entity. Thus, the term organyl encompasses the majority of the above defined organic groups e.g., fluorine, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term. The term organyl shall especially as well encompass sufficiently chemically stable negatively charged species, such as anions, or anionic side groups.

Organic groups are derived or formed by removing one or more hydrogen atoms from organic molecules containing at least a corresponding number of hydrogen atoms. For example, benzene results in phenyl or phenylene groups by removing one or two hydrogen atoms, resulting in a monovalent or divalent organic group.

Suitable organic molecules and groups are as identified above, e.g. alkyl, aryl, heteroaryl groups. Sequences of atoms linking the two Ys are composed of atoms present in organic molecules, preferably of covalent carbon chains, in which one or more (preferably non-neighboring) carbon atoms can be replaced by heteroatoms. Preferably the (carbon) atoms covalently attached to Y are not replaced.

The term "substantially" may refer to (relative) amounts of a compound and typically means at least 80 wt%, preferably at least 90 wt%, more preferably at least 95 wt%, specifically 100 wt%, not considering impurities or additives. It may define ranges of 80 to 100 wt% etc. for the content or purity of a compound. This definition refers e.g. to amounts like weight or volume or other parameters like wavelength. For single values, "substantially" allows for a variation or deviation from a given number by 20% or less, preferably 10% or less, more preferably 5% or less, specifically 1% or less. An emission substantially in the deep blue spectral region below 500 nm means that at least 80% of the light emission integrated over wavelength are below 500 nm etc., e.g. of a measured integral of the emission intensity over wavelength. A substantially organic substrate contains at least 80% of organic substances. When not indicated otherwise, % means wt%.

In this description, an electroluminescent coordination compound is any material that is able to emit light upon electrical excitation, resulting from recombination of electrons and holes. It shall be irrelevant in this context whether the recombination of the electrons and holes takes place directly on the electroluminescent compound or first an excitation is formed on a different compound and subsequently transferred to the electroluminescent compound. Further, it shall be irrelevant in this context whether the light emitted is visible for the human eye or not. Especially, compounds emitting infrared and near ultra-violet emission shall be explicitly included. Further, the mixture comprising the electroluminescent coordination compound does not necessarily have to be used in an electronic device but, for example, may be used as a dye or a contrast enhancement medium for magnetic resonance tomography. In particular it may be used for down-converting high energy photons after optical excitation.

In the OLED community, the emission of metal organic coordination compounds is usually classified as fluorescence, if it is originating from an aromatic chromophore and decays within a few nanoseconds, or as phosphorescence if the emission is originating from a spin-forbidden, meta-stable transition, such as from the first excited triplet state of aromatic molecules. The emission from the first electronically excited state of the metal-organic complex comprising divalent Europium is a spin allowed 5d-4f transition with a typical excited state lifetime of 1.2 µs. It is thus clearly neither fluorescent nor phosphorescent in the classical sense used in OLED community. We refer to it as an intrametallic transition.

All embodiments of the invention include a mixture of
a metal-organic coordination compound (a),
with a second charge-neutral organic compound (b) as described above, wherein the second charge-neutral organic compound (b) has a higher electron binding energy than the charge-neutral coordination compound (a).

With respect to formula (1-1), the two atoms **Y** are threefold linked with each other via the linkers **L₀, L₁,** and **L₂.** They thus form a polymacrocyclic, specifically a bis-cyclic ligand, which is an aza-cryptand in case both **Y** are chosen from nitrogen, which is the preferred bridgehead atom. The intended use of this cryptand is to complex divalent Europium. Consequently, heteroatoms suitable to complex metals such as B, N, P, S, O are independently in both occurrences present as part of **L₁,** and **L₂.** Therefore, the cryptand is a multidentate ligand.

The two covalently bonded linkers **L₁,** and **L₂** together with the two bridgehead atoms **Y** form a basic cyclic crown ether, which might be referred to as di-aza-crown ether in case of **Y** in both instances being N. This macrocyclic ring (excluding any optional substituents) contains at most 16 ring-forming atoms, in case both linkers **L₁,** and **L₂** are equal to 7 atoms in their shortest sequence connecting the two atoms Y (7+7+two Y). It thus offers a substantially smaller cavity size than the often used 18C6 motif, which, when used as a basis ring, is in fact often too large to form stable complexes with divalent Europium. More preferred are macrocyclic basis rings which (excluding any optional substituents) contain at most 12 ring-forming atoms, for example by choosing both linkers **L₁,** and **L₂** equal to 5 atoms in their shortest sequence connecting the two atoms Y (5+5+two Y = 12). In many instances, such a 12C4 motif, i.e., 12 macrocyclic atoms of which 4 are heteroatoms as part of the polymacrocyclic ligand according to formula (1-1) yields very chemically stable coordination compounds in combination with divalent Europium. Moreover, the macrocyclic basis ring should not be too small in diameter and should especially not be smaller than a 10C4 macrocyclic ring, as such ligands would not be able to form stable complexes with divalent Europium.

The polycyclic ligand according to formula (1-1) is completed by connecting those two atoms Y with the linker **L₀.** Unlike the linkers **L₁,** and **L₂, L₀** must at least contain 8 atoms in its shortest sequence connecting the two atoms **Y,** excluding any possible substitutions. (For explanation: If any L were 1,4-phenylene, it would have 4 atoms between the two linkages. In 1,3-phenylene it would have 3 atoms in the shortest sequence, and not 5.)
Thus, the polymacrocyclic ligand according to formula (1-1) is distinctively asymmetrical with respect to the three shortest sequences of **L₀, L₁,** and **L₂** that connect the two bridgehead atoms **Y.** This important modification allows anionic species to enter the two nominal macrocycles comprising **L₀,** and **L₂,** as well as **L₁** and **L₀,** respectively, which often results in a low total dipole moment for the charge-neutral coordination compound. In other words, the number of atoms present in the shortest sequences of **L₀, L₁,** and **L₂** linking the bridgehead atoms **Y** is important to define the asymmetry that enables low dipole moments and thus greater volatility. In contrast, all bis-cyclic cryptands with the shortest sequence of atoms present in **L₀, L₁,** and **L₂** linking the bridgehead atoms **Y** being identical are considered as being symmetrical. In this context, it is largely irrelevant whether **L₀, L₁,** and **L₂** are substituted differently, as such modifications do not significantly alter the cavity size of the polycyclic ligand; they remain symmetrical.

All linkages between **L₀, L₁,** and **L₂** and the two bridgehead atoms **Y** are aliphatic single bonds (non-aromatic) to ensure high triplet energy of the polycyclic ligand according to the invention. **L₀, L₁,** and **L₂** in their further sequence of atoms may contain for example C-C double bonds or aromatic bonds as found in 1,4-, 1,3- or 1,2-phenylene groups, i.e. they include one or more aromatic ring structures as shown below.

For chemical stability reasons, general preference is given to symmetrical linkers **L₁** and **L₂** such that the shortest sequence of **L₁** and **L₂** between the two bridgehead atoms is 7 or 5 atoms, preferably 5 atoms and the coordinating heteroatom present in **L₁** and **L₂** is in the centre of this shortest odd-numbered sequence. Further, preference is given to nitrogen being the bridgehead atom in both instances of **Y** present in formula (1-1). Thus, the preferred embodiment for the shortest sequences of **L₁** and **L₂** between the two bridgehead nitrogens is of the type -C-C-Y₂-C-C-, with **Y₂** being a heteroatom selected from B, N, P, S, O, preferably N, O and more preferably O, with C being a substituted or non-substituted carbon atom otherwise saturated with hydrogen. In this context, the term substituted also includes the carbon atoms being part of an aryl, heteroaryl or other ring system.

Examples of polycyclic ligands according to formula (1-1) with nitrogen being the bridgehead atom **Y** and the shortest sequence of **L₁** and **L₂** between the two nitrogens being 5 atoms are illustrated by the generic formulae (1-2) to (1-4): 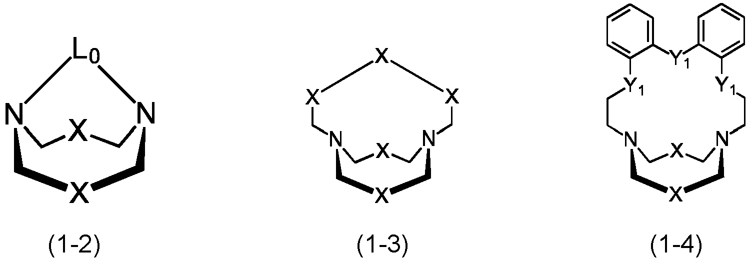 with **X** being independently in each occurrence selected from (2-1) to (2-9): 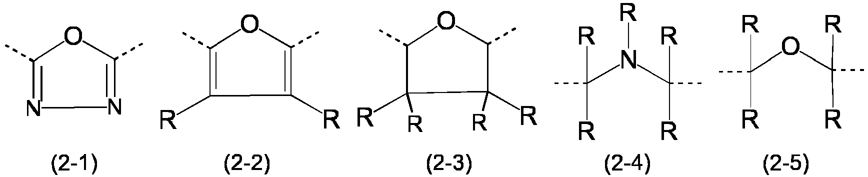 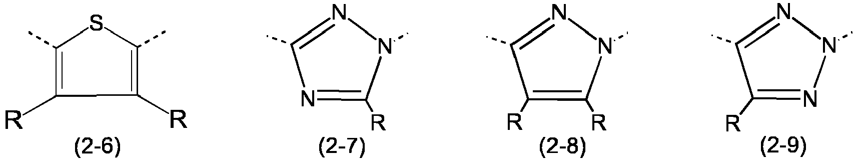 with **Y₁** being independently in each occurrence selected from B-R, N-R, P-R, O, S, preferably from N-R, O, and with **R** being H, D, or any covalently bound substituent being identical or different in each occurrence, and the dashed lines indicating the covalent linkage to the remainder of the polycyclic ligands according to formulae (1-2) to (1-4). Here, the at least one heteroatom present in **L₁** and **L₂** is selected from S, N, and O. In other words, it is of the above described preferred -C-C-Y₂-C-C- type with Y₂ being in this embodiment O, N, or S. For the generic formulae (1-2) to (1-4) combined with X selected from (2-7) to (2-9) the coordinating heteroatom, this time nitrogen, is still in the center of a 5 membered sequence. Yet, obviously, the sequence is not symmetrical anymore as two heteroatoms are present in the shortest sequence of **L₁** and **L₂** linking the two bridgehead nitrogens. The shortest sequence of atoms is thus -C-C-N-N-C-. Combining two such sequences selected from (2-7) to (2-9) includes isomers as part of the basis ring. All linkers **L₀, L₁,** and **L₂** can be further substituted, for example at positions indicated with R in formulae (2-1) - (2-9). The substitution might be present on the coordinating heteroatom such as indicated in formula (2-4), or on one or more carbon atoms present in the shortest sequence of atoms linking the two bridgehead nitrogens, such as indicated in (2-4) and (2-5). In (2-1) to (2-3) and (2-6) to (2-9) substitutions from two atoms present in the linker are linked together thus forming a heteroalkyl group as in (2-3) or a heteroaryl group as in the other examples. Thereby, the substituents of two carbon atoms may be linked as for example in formula (2-1), thereby forming an oxadiazole motif, or the substituents of one carbon and one nitrogen as for example exemplified in formula (2-7) to (2-9) forming various triazole motifs. Each of those fused cyclic organyl groups may be further substituted on suitable carbon or heteroatoms as (for example) indicated by R in formula (2-2), thus replacing hydrogen atoms. Generally preferred are substituted or non-substituted ethyleneoxy, azaethylene, and dimethylfuran fragments as the shortest sequences of **L₁** and **L₂,** which are obtained by selecting X present in the generic formulae (1-2) to (1-4) from formula (2-2), (2-4), or (2-5).

Within the scope of this invention, a wide range of linkers **L₀** as part of formula (1-1) is chemically easily accessible, preferably chosen from substituted or non-substituted alkane, arene, or heteroarene by removing two hydrogen atoms. In order to ensure stable complex formation as part of the metal-organic coordination compound, the preferred linker has a shortest sequence of more than 7 atoms. In preferred embodiments, the shortest sequence is more than 8 atoms yet less than 15 atoms, and even more preferred are sequences of 11 atoms. The shortest sequence **L₀** of atoms between the two bridgehead atoms Y as part of formula (1-1) may only contain substituted or non-substituted carbon atoms. Yet, preferred are linkers that do comprise a plurality of heteroatoms, preferably selected from Si, B, N, P, or O. More preferred are relatively hard and chemically innocent heteroatoms such as N or O. In preferred embodiments, 2 to 4 atoms which are part of the at least 8 atoms forming the shortest sequence of atoms (as part) of **L₀** between the two Y atoms in formula (1-1) are heteroatoms. Most preferred are ligands **L₀** with 3 heteroatoms present that are separated by C atoms and not in terminal position. Preferably all, preferably 3, hetero atoms are separated by 1,2-alkylene groups. To allow for more stable symmetrical configurations, the preferred linker **L₀** has an odd number of atoms in its shortest sequence, preferably 9, 11, or 13, while 11 atoms is most preferred.

Preferably, in formula (1-1), the shortest sequences of atoms in **L₀, L₁,** and **L₂** together with both Y form a bicyclic cage in which all heteroatoms that are inserted into or part of the two shortest sequence or chain length cycles are separated by, preferably 2, carbon atoms each.

Further preferred polycyclic ligands with respect to **L₀** and in view of the above preferences may be selected from the generic formulae (1-3) or (1-4). In those embodiments the shortest sequence of atoms as part of **L₀** between the two Y atoms in formula (1-1) are 11 atoms. Additionally, in those embodiments three coordinating heteroatoms, selected from P, B, N, O, or S are present as part of **L₀.** Furthermore, one of those coordinating heteroatoms is in the centre of the shortest sequence. Again, **L₀** may be non-substituted or substituted, for example on positions R shown in formulae (2-1) to (2-9). In particular, in two instances in formula (1-4), adjacent carbon atoms are fused into an aromatic substituted benzene ring. This is an example where 4 substitutions present on two neighbouring carbon atoms are fused into a cyclic group. In this context, the specific organyl groups (2-1) to (2-3) can be considered as an embodiment of the more generic (2-5) with substitutions on two carbon atoms being fused into a cyclic group. Similarly, (2-7) to (2-9) constitute specific embodiments of (2-4). The majority of the carbon atoms present in the generic formulas (1-2) to (1-4) may be substituted, however, for clarity most of those optional groups have been omitted, which, however, shall not limit the scope of this invention. Indeed, suitable substitutions, such as deuterium or short alkyl groups like methyl or ethyl may be beneficial for thermal stability or to improve the solubility and or volatility. For chemical stability reasons and to avoid an undesired red-shift of the emission color of the complex, preference is generally given to symmetrical substitution pattern with respect to the two bridgehead nitrogen atoms. For example, in (2-2) the two Rs shown would preferably be equal. Similarly, if anionic negative side groups are attached to the ligands according to the generic formulas (1-1), then preferably two such groups are attached symmetrically, and preferably chemically soft groups that do not absorb light with a wavelength in the range of 380-700 nm, more preferably in the range of 430-500 nm, are chosen. Suitable anionic substitutions are found in the class of *closo*-carborate clusters.

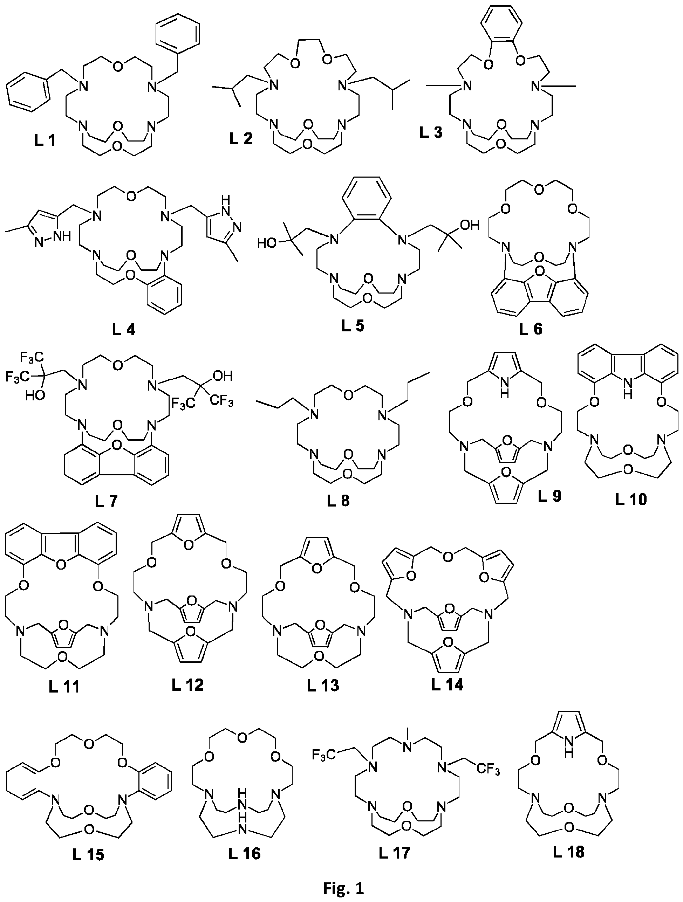

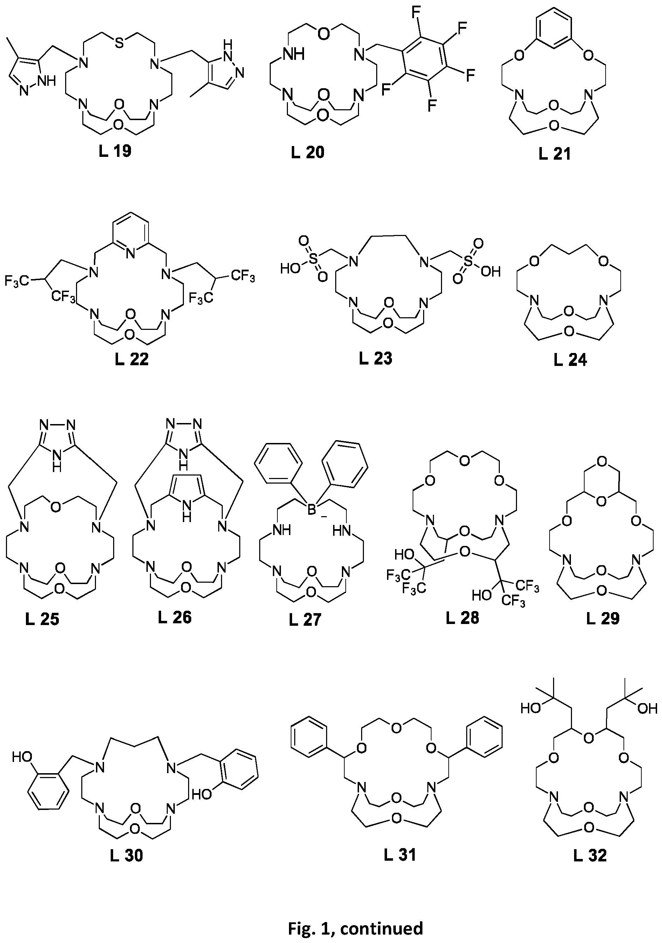

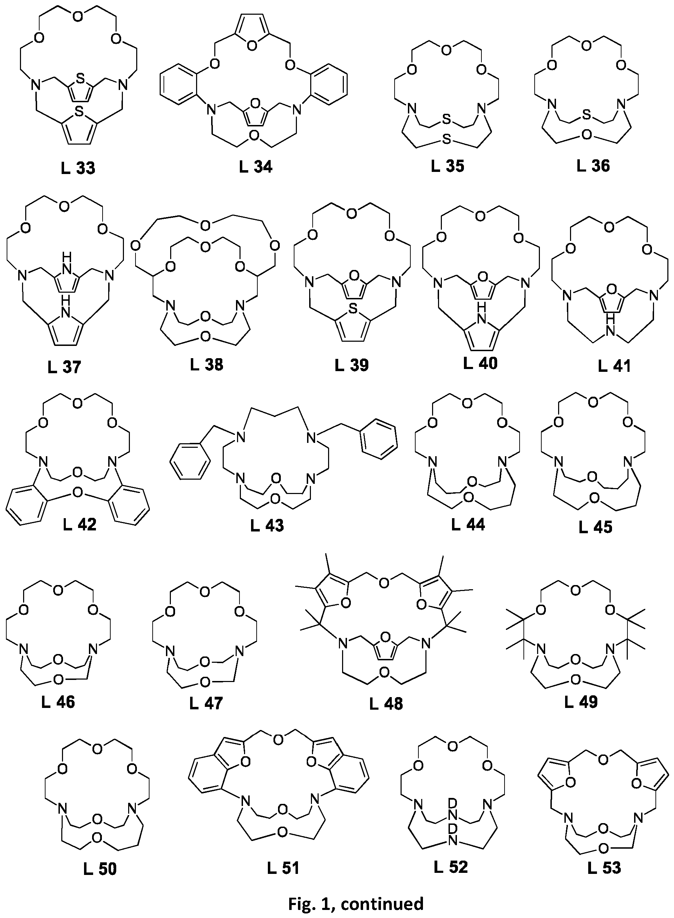

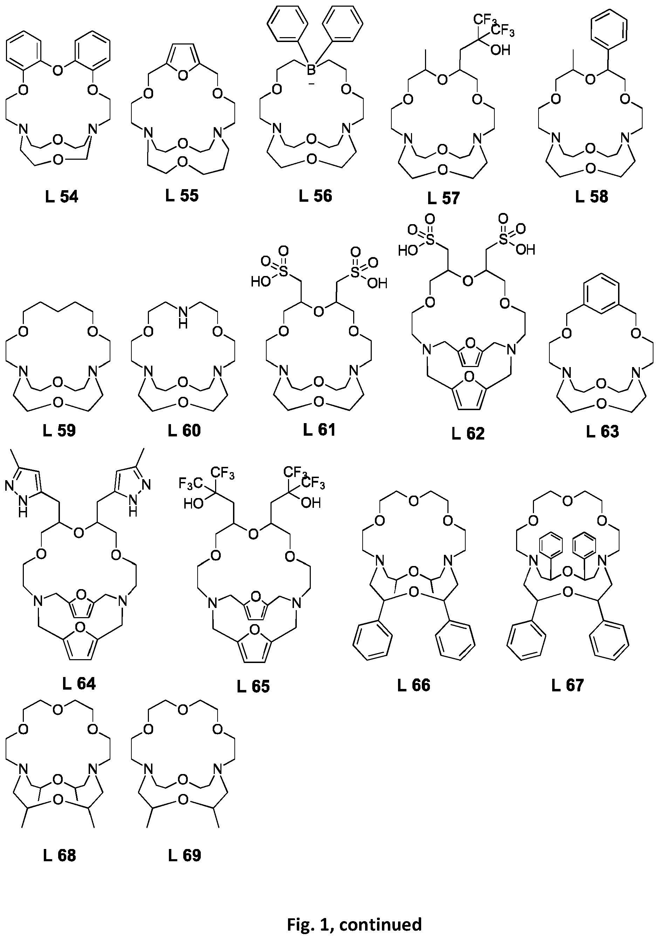

Without limiting the scope of the invention, **L1** to **L69** shown in **FIG. 1** further illustrate examples of the organic ligand present as part of the coordination compound (a) being mixed with a second organic material (b) according to various embodiments and represented by the generic formulae (1-1) with linkers, **L₁, L₂,** and **L₀.**

In all examples depicted in **FIG. 1** the bridgehead atom, Y, as part of formula (1-1) is in both instances chosen to be N. In most examples, the shortest sequence of the two linkers **L₁,** and **L₂** is 5 atoms and the one hetero atom is in the center of this 5 atom sequence. Examples with different shortest sequence of **L₁,** and **L₂** are **L44-L47, L50,** and **L53-L55,** where either **L₁** or **L₁,** and **L₂** possess of 4 or 6 atoms. For example, in **L44, L50,** and **L55** the shortest sequence of **L₁** is 5 atoms, while it is 6 atoms for **L₂.** Similarly, in **L46, L53,** and **L54,** the shortest sequence of **L₁** is 5 atoms, while it is 4 atoms for L₂. **L45** and **L47** illustrate the situation of both **L₁,** and **L₂** being 6 and 4 atoms, respectively, in their shortest sequence of atoms between the two bridgehead nitrogens. Indeed, such a modified length of **L₁** and **L₂** does alter the diameter of the basis di-aza-crown ether, which may be beneficial to adapt the cavity of the polymacrocyclic ligand according to formula (1-1) to perfectly match the diameter of the divalent Europium cation. Therefore, preferably **L₁** can be four atoms long and **L₂** six atoms long in (1-1).

In the majority of examples depicted in **FIG. 1** the one heteroatom that is present in the shortest sequence of the two linkers **L₁,** and **L₂** is nitrogen, or the more preferred oxygen. Indeed, other heteroatoms are possible as well such as S, B, P. For example, **L33, L35, L36,** and **L39** illustrate the integration of a 5 atom shortest sequence of a diethylthio-fragment in either **L₁** or **L₁** and **L₂.** Preferably, the heteroatom present in **L₁** and **L₂** is the same, yet different heteroatoms in both linkers are possible too, which may for example be easier synthetically accessible and as such in the scope of this invention. For example in **L36** and **L39** with O and S two different heteroatoms are present in **L₁** and **L₂** whilst **L40** and **L41** illustrate the same situation for the heteroatoms O and N.

Whilst **L₁,** and **L₂** contain a heteroatom each in their shortest sequence between the two bridgehead Y nitrogen atoms, **L₀** may contain one or more heteroatoms. Preferably there are 2 to 4 heteroatoms selected from B, P, N, S, or N present in the shortest sequence of atoms linking the two Y bridgehead atoms. For example **L2** and **L3** illustrate the situation of just four heteroatoms being present in **L₀** while **L5, L21, L23, L24, L30, L43, L59, L63** depict the situation of two heteroatoms being present in L₀. However, preference is given to macrocyclic ligands according to formula (1-1) with L₀ comprising 3 heteroatoms in the shortest sequence of atoms linking **L₀** to the remainder of the macrocyclic ligands. Preferably those heteroatoms are selected from B, N, P, S, O, preferably form N, and O, and even more preferably from O. If more than one heteroatom is present as part of **L₀,** they may be identical or different. For example, **L1** to **L4** illustrate the situation of N and O being simultaneously being present as part of **L₀,** whilst in **L27** one B and two N are present. Similarly, the heteroatoms that are part of **L₁,** and **L₂** are selected independently of any optionally present heteroatom in **L₀.** For example, in **L11** to **L15** only O is present as heteroatom in **L₁, L₂,** and **L₀,** whilst **L22** and **L23** exemplifies the case of O being the mandatory heteroatom as part of **L₁,** and **L₂** and a plurality of N being present as part of **L₀.** In various embodiments of this invention the linker **L₁, L₂,** and **L₀** present in (1-1) only comprise of hydrogen, and/or deuterium, carbon, and oxygen. This situation is for example illustrated in examples **L6, L11** to **L15, L21, L24, L29, L31,** or **L32** in **Fig 1****.**

In general, **L₁,** and **L₂** are 4 to 7 atoms in their shortest sequence between the two **Y** according to formula (1-1), while **L₀** must be 8 or more atoms. Yet, preference is generally given to **L₁,** and **L₂** being 5 and **L₀** being 11 atoms. Here the background is that most stable cryptands are usually based on a repeating -C-C-X- pattern with X being a hetero atom. In other words, in most stable macrocyclic compounds two "neighboring" heteroatoms are separated from each other by two carbon atoms. Thus, the ideal number of atoms for linking to heteroatoms Y in shortest sequence in **L₀, L₁,** or **L₂** taken together as part of formula (1-1) is 3n+2 with n being integer number representing the number of heteroatoms present in the linker **L₀, L₁,** and **L₂.**

In various embodiments of this invention, at least two atoms present in the shortest sequence of atoms of either **L₀, L₁,** or **L₂** are substituted and their substitutions are fused with each other, such that they become part of a benzene, pyridine, pyrrole, pyrazole, furan, carbazole, dibenzofuran, or benzofuran ring structure, whereby preference is given to furan and benzene. For example in **L3** and **L4,** two carbon atoms present in the shortest sequence of **L₀** and **L₁,** respectively are fused into a benzene ring. Similarly, in **L15** and **L42,** four carbon atoms present in the shortest sequence of **L₀** and **L₁,** respectively are part of two non-fused benzene rings. In **L10** and **L11** 5 atoms present in the shortest sequence of **L₀** are part of a dibenzofuran and carbazole ring structure, respectively. However, preference is given to furan aromatic ring structures, which is exemplified for the case of introduction into **L₀** in structures in **L12, L13,** and **L34,** and for the case of introduction into either **L₁,** or **L₂** in structures **L9, L11, L12, L13,** and **L14** for example. In even more preferred situations, both **L₁,** and **L₂** comprise of a furan unit as part of their shortest sequence of atoms, which is exemplified in **FIG. 1** in **L9, L12, L14,** and so on. "Shortest sequence" shall always be the shortest sequence (i.e., number) of atoms that link the two bridgehead atoms **Y,** preferably nitrogens, in case of **L₀, L₁,** or **L₂** according to formulae (1-1). By example of **L44** to **L58,** the shortest sequence of **L₀** is 11 atoms in all cases.

While the heteroarene groups may be introduced into the shortest sequence of **L₁, L₀,** or **L₂** in various ways, general preference is given to connecting them symmetrically relative to the one heteroatom or heteroatoms. Further and preferentially, heteroaromatic groups are introduced into the shortest sequence of **L₁, L₀,** or **L₂** in a way that the heteroatom itself is part of the shortest sequence of **L₁, L₀,** or **L₂.** Thus, for example in the case of the five membered heteroaryl groups furan, thiophene, or pyrazole the preferred connecting carbon atoms are the 2 and 5 positions neighbouring the heteroatom, while for carbazole and dibenzofuran the preferred connection points are the 1 and 8 positions as illustrated in examples L9 - L14 in **FIG. 1****.**

According to various embodiments the linkers, **L₁, L₂,** or **L₀,** as part of the polymacrocyclic ligand according to formula (1-1) present in the mixture according to invention may contain a plurality of substituents, which are not equal to hydrogen. For example, in the generic formulae (2-4) to (2-5) nitrogen or carbon atoms may be substituted at the positions indicated with R. Similarly, carbon atoms present in (2-1), (2-2), (2-3), (2-6) are substituted in a way that heteroaryl groups are formed and in (2-7) to (2-9) nitrogen and carbon atoms are fused to form further aza-heteroaryl rings. As exemplified in (2-2), the substitution itself - in this particular case forming a furan ring - may be further substituted. Preferably 0 to 20, more preferably 0 to 10 of these substituents can be present.

In general, substituents may be any chemical fragment that can be covalently attached in accordance with formula (1-1). Examples of suitable substituents include alkyl, heteroalkyl, cycloheteroalkyl, halogens, aryl, or heteroaryl groups. Alternatively, two or more carbon atoms may simultaneously be substituted by a single substituent, whereby the two or more substituted carbon atoms may become part of an aryl or heteroaryl ring structure or cycloalkane or cycloheteroalkane structure, or a spiro linkage is formed. Therefore a wide variety of substitution patterns can be considered and may be preferable in various embodiments of this invention. In **FIG. 1** often potential substitutions **R,** are set to hydrogen for sake of clarity. This, however, shall not limit the general scope of the invention, as any chemical fragment that can be covalently attached is in the scope of the invention. Examples where some of the possible substituents are explicitly specified include **L1** to **L5,** where various substitutions are covalently attached to two nitrogen atoms. In **L48,** and **L49,** some of the carbon atoms present in the scaffold of the ligand are twofold substituted. In **L52,** two hydrogens are substituted by deuterium. In **L3** or **L15,** two neighboring carbon atoms present in **L₀** are substituted to form benzene rings, whereas in **L18** and **L34** two non-neighboring carbon atoms are substituted to form a furan and pyrrole heteroaryl group, respectively. Besides such a fusion of two or more carbon atoms into aryl or heteroaryl groups, it is as well possible that two substituents are linked with each other to form a non-aromatic cyclic group, for example becoming part of cyclohexane. To further exemplify such embodiments, **L29** and **L38** illustrate cases where two R are linked together to form a hetero alkane. Generally, substitution patterns may reduce the symmetry of the polycyclic ligand relative to the unsubstituted base structure. For example, in **L66** and **L69, L₁** is differently substituted from **L₂.** Similarly, in **L57** and **L58, L₀** is substituted twice with different substituents and therefore the symmetry of this linker is reduced. While substitution patterns that reduce the symmetry of the ligand are clearly within the scope of the invention, they are not the preferred options as asymmetrical substitution patterns often lower the chemical stability of the complex, may cause an undesired red-shift of the emission energy, and/or increase the dipole moment of the complex. On the other hand, asymmetrical substitution patterns may improve the solubility of the final coordination compounds or reduce their tendency to crystalize.

Substituents may be charge-neutral, for example alkane or alkene fragments with two or more covalent links to two or more carbon atoms of the polycyclic ligands according to the invention. Otherwise, for example, linear or branched alkane side chains may be chosen if a good solubility in non-polar solvents is needed. For other applications, coordination compounds with high thermal stability, for example suitable for evaporation or sublimation, may be needed. In this case, small and light weight substituents are preferably employed, i.e., organyl fragments with individually less than 20 atoms and or individually a molecular weight of less than 100g/mol. Similarly, halogenated, particularly fluorinated, side groups, such as depicted in **L20** or **L28** in **FIG. 1** may improve volatility and/or stability of the coordination compound according to the invention. In case the intended application of the coordination compound of the invention is light generation, for example by electroluminescence, the ligand preferably may be chosen such that the excitation of the coordination compound is confined to the central Eu cation. In other words, ligand-to-metal or metal-to-ligand change transfer character in the excited state is preferably avoided. In this way, an intrametallic transition with highest efficiency is obtained. With respect to the choice of the substituents, preferred are side groups that are not easily polarized and that have a sufficiently high triplet level above the transition of the first electronically excited state of the emitter molecule. Low polarizability is ensured for aliphatic or heteroaliphatic substituents or using small aryl- or heteroaryl systems with less than 8 conjugated atoms or heteroatoms. In case heteroatoms are part of conjugated side groups, preference is generally given to the heteroatoms N and O, and even more preference is given to O. In various embodiments, side groups with a triplet energy > 2.5 eV, or preferably > 2.7 eV are used. Sufficiently high triplet energy > 2.7 eV is generally observed for organyl groups comprising of aliphatic or heteroaliphatic fragments or for fragments comprising only small aryl- or heteroaryl systems with less than 8 conjugated atoms or heteroatoms, which thus should preferably be employed substituents if a deep blue electroluminescent emitter is the intended use of the mixture according to the invention.

Nowadays, triplet energies of organic molecules can be calculated easily and with sufficient accuracy using a wide range of open source or commercial density functional theory (DFT) and time-dependent (TD)-DFT software packages. Alternatively, triplet energies can be experimentally probed, for example as described in van Dijken, A., et al. "Carbazole compounds as host materials for triplet emitters in organic light-emitting diodes: polymer hosts for high-efficiency light-emitting diodes." Journal of the American Chemical Society 126.24 (2004): 7718-7727.

As a simple rule, suitable high triplet energy building blocks of the polymacrocyclic organic ligand according to formula (1-1) are preferably either non-aromatic (aliphatic) or comprises aromatic building blocks containing at most 8 aromatic carbon or hetero atoms, whereby various aromatic building blocks are being separated from each other by at least one nonaromatic carbon or heteroatom. In this context, the nitrogen and oxygen present in carbazole and dibenzofuran are considered a nonaromatic heteroatom.

In various embodiments, the polycyclic organic ligand according to formula (1-1) that coordinates to a divalent Europium cation within the coordination compound being part of the mixture according to invention may itself already be singly or multiply (dualy) negatively charged. In various embodiments, suitable anionic groups are covalently attached to the polycyclic organic ligand according to formula (1-1) for example at positions **R.** Without limiting the scope of the invention, examples of such anionic substitutions may be any singly or doubly negatively charged organyl groups that are sufficiently chemically stable. Generally, preference is given to anionic groups that do not absorb light with a wavelength in the range of 380-700 nm, more preferably in the range of 430-500 nm. Further preference is given to lightweight anionic groups with molecular weight of less than 1000 g/mol, preferably less than 500g/mol. Further preference is given to anions that do not strongly interact with the excited Eu cation present in the coordination compound. In other words, preferred are weakly coordinating anions with a distinct three-dimensional structure that distributes the negative charge over a plurality of atoms.

Examples of twofold negatively charged polycyclic ligands according to formula (1-1) include **L4, L5, L7, L23, L30, L32, L61, L62, L64,** and **L65** in **FIG. 1** with two substituted or non-substituted singly negatively charged anionic groups being covalently attached to the remainder of the macrocyclic ligand (1-1) via a carbon or nitrogen atom. In those examples, the hydrogenated neutral version of the polycyclic ligand is depicted. However, it is understood that a twofold negatively charged ligand is easily obtained after deprotonation of the respective most acidic side group, such as the pyrazole fragments or alcohol side groups. **L57** represents an example of a singly negatively charged ligand comprising covalently attached fluorinated and branched alcohol becoming an anionic alcoholate after deprotonation.

Instead of covalently attaching anionic groups, the polymacrocyclic organic ligand may as well comprise negatively charged hetero atoms, such as borates or negatively charged aryl groups, such as pyrrolate as part of the scaffold of the polycyclic organic ligand. For example, this can be achieved by deprotonation of the aromatic pyrrole or triazole building blocks depicted as **L9, L10, L18** and **L25, L26** in **FIG. 1****,** respectively. The optional negative charge present in the ligand may as well be substantially localized on a particular heteroatom that is part of the scaffold of the organic ligand according to the invention that is generically represented by formula (1-1). For example in **L27** of **FIG. 1****,** a negatively charged borate is part of the linker **L₀,** illustrating a singly negatively charged ligand according to formula (1-1).

In preferred embodiments of the coordination compounds being present in the mixture of the present invention, the sum of the negative charges of the covalently attached anionic groups matches the charge of the central divalent Eu cation, such that the resulting metal-organic coordination compound is charge-neutral. In such a configuration, no unbound negatively charged anions are present, which elegantly avoids anion drift in device configuration under applied electric fields. Therefore, preferred are negatively charged ligands containing exactly two singly charged anionic groups or exactly one twofold negatively charged anionic group. Thus, ligand examples such as **L23, L26, L30,** or **L32** are preferably chosen.

The negatively charged anionic side groups exemplified in **FIG. 1** shall not limit the scope of the invention. In various embodiments, anionic groups covalently linked to the organic polycyclic ligand may be twofold or even higher charged, for example by attaching sulfate, phosphate, or chromate anionic groups. Similarly, the polycyclic organic ligand may carry more than two negative charges. In such a case, a charge neutral compound may be obtained by incorporation of additional suitable organic or inorganic cations, such as ammonium, alkali, alkaline earth metal cations or similar into the coordination compound being part of the mixture according to invention. While any of the anionic side groups depicted in **FIG. 1** may be used, preference is generally given to chemically soft side groups that do not strongly interact with the electronically excited Eu cation. As such, preference is given to anionic side groups that do not tend to form covalent chemical bonds with the central cation, but where the interaction is mainly of electrostatic nature. Accordingly, bulky anions or anionic groups in which the negative charge is distributed over many atoms are preferred. Additionally, preference is given to anions that do not absorb light with a wavelength in the range of 380-700 nm, more preferably in the range of 430-500 nm. Very well suited in this context and therefore preferred are covalently attached carborate cluster fragments selected from (3-4) or (3-5) 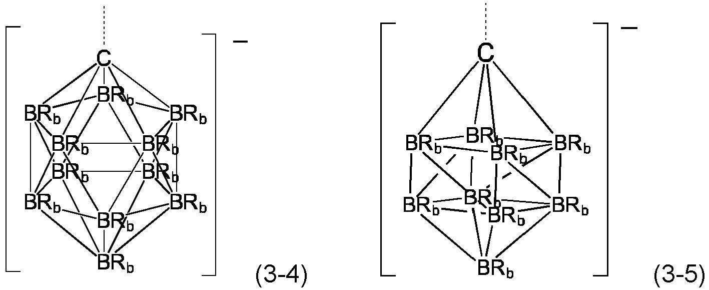 with the dashed lines indicating the covalent linkage to the remainder of the polycyclic ligand, and **R_{b}** independently in each occurrence represents either hydrogen, deuterium, fluorine, chlorine, bromine, or an alkyl chain - preferably methyl.

Further possible covalently-linked anionic side groups are disclosed in WO 2021/244801 and WO 2022/218562.

In various embodiments, the coordination compound may include at least one negatively charged anion that is not covalently bound to the polycyclic organic ligand according to formula (1-1). The negatively charged anion may be a small inorganic anion such as, but not limited to, halogens, such as chloride or iodide, BF₄, PF₆, and so on. When an external field is applied to a layer comprising the coordination compound according to invention, for example in operative OLED device configuration, anions may drift towards oppositely charged electrodes, especially when using small and non-bulky anions. Such behaviour may define a so-called light emitting chemical cell.

A light emitting chemical cell may be an embodiment of an OLED in this description. Drift of charged species within the mixture including the Europium coordination compound having an organic ligand according to formula (1-1) may lead to very low driving voltages in case of employing the mixture in an electroluminescent device, which may facilitate high power-efficiencies. This may be desirable for some applications, such as general illumination or signage. Yet, for other applications that require fast response times, for example flat panel displays, such ion drift may lead to time dependent current-voltage-luminance (IVL) characteristics, which may be difficult to control, and may not be desirable as such. Therefore, the choice of the anions may depend strongly on the application.

In various embodiments, the coordination compound may contain comparably large and bulky organic anions. Such anions may be employed if ion drift is not desired. Examples without limiting the general scope of the invention of such anions include fluorinated or non-fluorinated fullerene (C₆₀⁻, C₆₀F₃₆⁻, C₆₀F₄₈⁻) fluorinated aryls and fluorinated or non-fluorinated aryl or heteroaryl-borates.

The negatively charged anion may include more than one atom, preferably more than three atoms. Such larger anions are generally bulkier and, as such, are better suited for applications where drift of anions is not desired. Furthermore, the anion may have a molecular weight of at least 128 g/mol. Suitable anions are disclosed in WO 2021/244801.

In various embodiments, anions without substantial absorption at wavelengths in the range of 380-700 nm, more preferably in the range of 430-500 nm, may be used. In case there are two non-covalently bound anions present, they may be the same or of different type.

In various embodiments, a doubly negatively charged anion is present in the coordination compound according to the invention, such as for example the closoborate [B₁₂H₁₂]²⁻ or the borane cluster *fac*-[B₂₀H₁₈]²⁻.

As with the embodiments using covalently attached anionic groups, preference is given to anions that do not strongly interact with the electronically excited central Eu cation. As such, preference is given to anionic side groups that do not tend to form covalent chemical bond with the central cation, but where the interaction is mainly of electrostatic nature. Accordingly, bulky anions or anionic groups in which the negative charge is distributed over many atoms are preferred. Further preferred are light weight anions with individually less than 1000 g/mol and more preferably less than 500 g/mol. Very well suited in this context, and therefore preferred, are substituted or non-substituted *closo-* and/or *nido-* (car)borate cluster anions. Ideally, two identical anions selected from (3-1) to (3-3) are chosen: 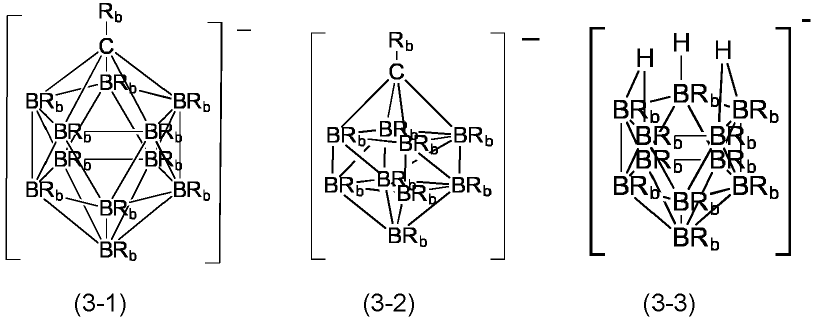 with **R_{b}** independently in each occurrence representing either hydrogen, deuterium, fluorine, chlorine, bromine, or an alkyl chain - preferably methyl.

These particular anions also show the desired property of high triplet energy (> 2.7 eV) combined with low absorption in the visible spectral region. At the same time, they are bulky to avoid anion drift, yet light weight for high volatility.

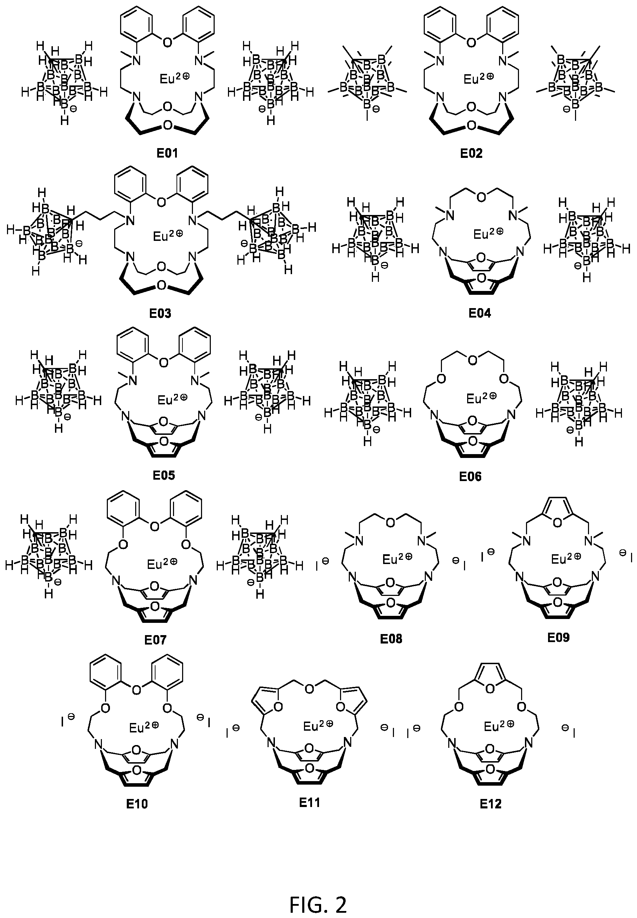

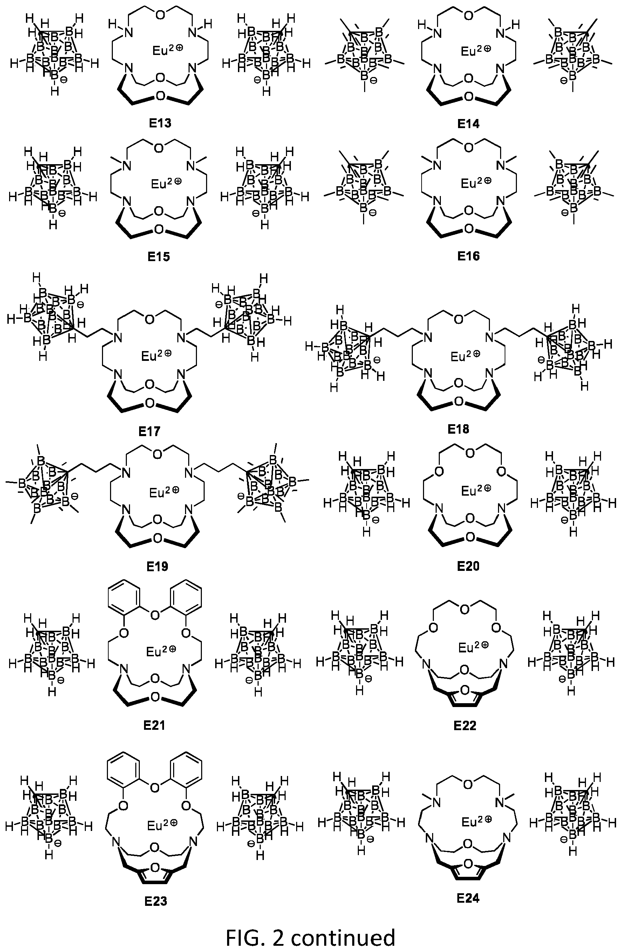

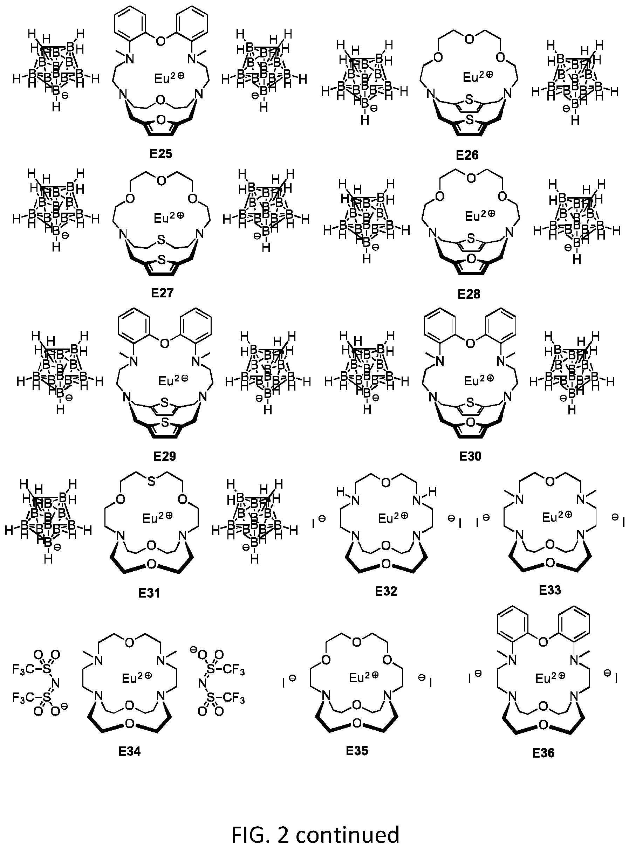

Examples of charge-neutral coordination compounds being present in the mixture according to the invention are shown as **E01 - E36** in **FIG. 2****.** In all examples depicted in this figure, both bridgehead atoms **Y** according to formula (1-1) are chosen to be nitrogen. The shortest sequence of **L₁** and **L₂** reflects the preferred situation of 5 atoms, while it is 11 for **L₀.** Also, substitutions are symmetrically with respect to the linkers **L₀, L₁** and **L₂** (one symmetry plane may be preferably present in (1-1)). All **L₁** and **L₂** contain exactly one heteroatom in their shortest sequence between the two bridgehead atoms **Y** according to formula (1-1), which is either O or S. In all examples, **L₀** contains exactly three heteroatoms in its shortest sequence between the two bridgehead atoms **Y** selected from N, O, or S. All ligands are examples of the preferred situation, where neighboring heteroatoms are separated from each other by exactly two carbon atoms. In some cases, such as **E23** to **E30,** the heteroatom is part of an heteroaryl fragment, in particular a furan or thiophene. Those heteroaryl fragments are integrated into the scaffold of the organic ligand in the 2,5 positions to ensure that the heteroatom present in furan and thiophene is part of the shortest sequence of atoms linking the two bridgehead atoms **Y** in formula (1-1), and, to ensure that the heteroatoms are able to coordinate the central divalent Europium. **E01** to **E05** exemplify further substitutions, where for example nitrogen atoms are substituted by methyl groups or benzene rings are fused into the scaffold of the ligand.

With the exception of **E03** and **E17** to **E19,** all ligands are charge-neutral and two identical anions are present in the coordination compound. While triflimide is exemplified in **E34,** iodide is used in **E08** to **E12** and **E32, E33, E35,** and **E36.** In the other examples, the more preferred closoborate type anion is used. For example, in **E01** a CB₁₁H₁₂ type closoborate is used, while in **E02,** the fully methylated version of this anion in exemplified.

**E03** and **E17** to **E19** illustrate the situation of a twofold negatively charged organic ligand according to formula (1-1), in which two identical closoborate-type cluster anions are covalently attached to the ligand. In all 4 examples, the anionic side groups are attached on nitrogen atoms present in **L₀** using ethyl or propyl spacers. The anionic side group itself is either CB₁₁H₁₂ as in **E03, E17,** or **E18,** while the fully methylated analogue is exemplified in **E19.**

In all embodiments of the invention, the coordination compound (a) is mixed with a second charge-neutral organic compound (b). The second organic material (b) may be chosen from a wide range of generic classes of substantially organic materials, including but not limited to small organic molecules, preferably with a molecular weight less than 1500 g/mol, large molecules or polymers with organic weight of more than 1500 g/mol, dendrimers, metal-organic complexes, or organic materials not comprising any metals. Generally, the second organic material may as well be processed in a low molecular weight form and later be combined into a higher molecular weight form. Examples here are metal organic frameworks or crosslinkable polymers. Generally preferred are second organic materials that add a desired functionality to the mixture according to the invention. Such a functionality can be, without limitation, improved air or moisture stability, improved thermal stability, improved charge transport properties, improved dispersion of the coordination compound according to formula (1-1), improved optical characteristics - such as lowering the refractive index of the mixture or improved processing to name just a few.

In various embodiments, the coordination compound (a) is imbedded into the at least one second charge-neutral organic compound (b) at 0.1 - 99.0 vol%, preferably at 1 - 90 vol%, and most preferably at 3 - 30 vol%, based on the mixture which is 100 vol%. Thus, in various embodiments, the coordination compound might take a majority or a minority of the overall volume of the mixture. Yet, in more preferred embodiment, the coordination compound (a) takes a minority part of the volume and has the function of an organic dopant, whereas the one or more organic materials (b) take a majority part of the volume for example to funnel energy or charges towards the coordination compound.

In various embodiments, the second organic material being part of the mixture according to various embodiments may be a matrix having suitable optical properties, such as, for example, a high transparency in certain desired parts of the visible spectrum. If this matrix is brought in optical contact to a light source emitting at a sufficiently short wavelength, this light may be absorbed by the coordination compound and reemitted at a substantially longer wavelength. A suitable light source may for example be a light emitting diode, emitting light at a wavelength substantially shorter than 430 nm, which may be reemitted by the coordination compound present in the mixture at a wavelength longer than 430 nm. The matrix may have any physical dimensions. It may for example be a thin layer of 10 nm to 10,000 nm. The matrix may as well be of granular form or in form of small particles of average diameter between 10 nm and 100,000 nm. For use in optical devices, in the latter cases, the matrix may be applied inside another host material for support.

In various preferred embodiments, the mixture according to the invention is used as emitting material, particularly to generate color-pure deep blue emission from the intrametallic transition after direct or indirect optical or electrical excitation. The excitation on the coordination compound qualitatively consists of an electron and a hole. To emit light with high efficiency while imbedded into a second organic material, it is mandatory that the positive charge, commonly referred to as hole, is confined to the coordination compound. Thus, a mandatory requirement is that the second charge-neutral organic compound has a higher electron binding energy than the charge-neutral coordination compound. In other words, the most weakly bound electron in the coordination compound should be less strongly bound than the most weakly bound electron of the second organic material. The requirement thus means that for a hole being present in the mixture according to invention, it is energetically favorable to reside on the coordination compound as opposed to residing on the second organic material.

Measuring the transport levels of organic materials is an established field based on a wide selection of methods and a wide variety of techniques have been published in the literature. However, for the purpose of various embodiments, the particular technique of how to measure the electron binding energy and or the electron affinity is not essential, e.g., only the relative order of the materials being present in the mixture according to the invention, i.e., between the coordination compound and the second organic materials, may be of importance.

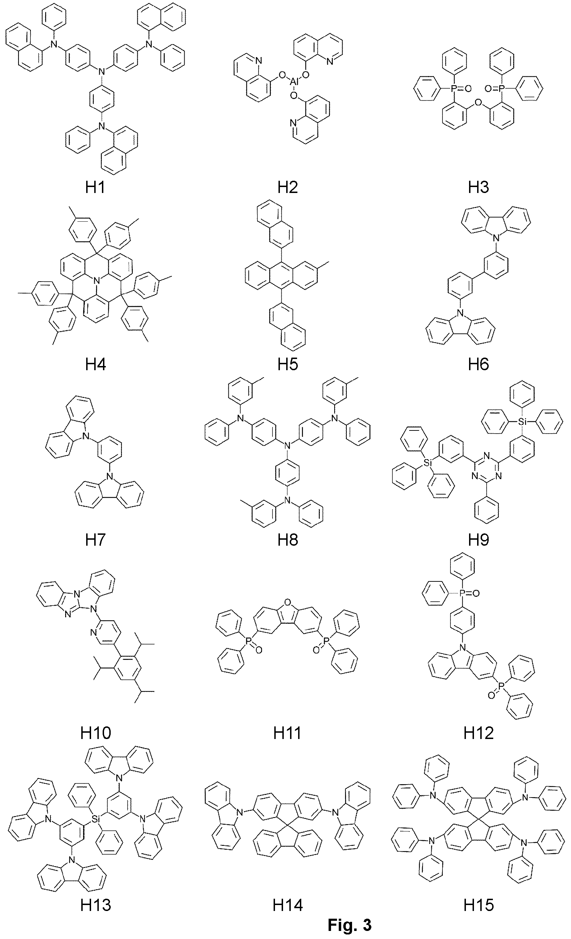

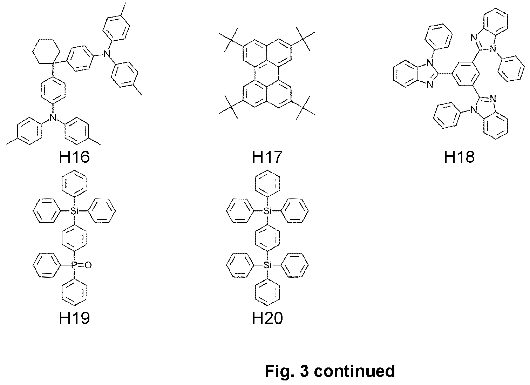

With the recent huge advances in quantum mechanical computing techniques and progress in the development of density functional theory, an easy way to deduct electron binding energies (EBEs) and electron affinities are DFT calculations. Experimental methods involve cyclic voltammetry in solution. For solid films UPS or AC-2 (Riken Keiki) are often used. Further experimental techniques are very well known in the art, e.g. see R.J.Cox, Photographic Sensitivity, Academic Press, 1973, Chapter 15. Without limiting the general scope of the invention, a very modest selection of possible charge transport materials is illustrated as **H1** to **H20** in **FIG. 3** and their corresponding EBEs are given in **Table 1** below. Additionally, calculated electron binding energies of various neutral coordination compounds are tabulated in **Table 2** below. As a side remark, the use of the term "HOMO" for Eu(II) coordination compounds is scientifically not correct. This is because the term commonly refers to the highest fully (doubly) occupied orbital, whereas divalent Eu has seven partially (singly) occupied orbitals that lie energetically above its highest fully (doubly) occupied orbital. Since those singly occupied orbitals are much more relevant for the photophysical processes than the doubly occupied one, we use the more general term electron binding energy (EBE) instead of the more common but incorrect term HOMO energy. EBE is a more modern expression for the ionization potential (IP). Both, HOMO and EBE (and IP) refer to the binding energy of the most weakly bound electron in a molecule, though the value given for the HOMO is typically of opposite sign. Accordingly, removing an electron from or, in other words, accepting a hole on divalent Europium leaves six electrons in its originally half full 4f-shell, which corresponds to the following change in its electronic configuration: [Xe] 4f⁷5d⁰6s⁰ → [Xe] 4f⁶5d⁰6s⁰. Formally, this process yields trivalent europium, or Eu(III), and requires to overcome the electron binding energy. Furthermore, to describe the electron-binding energy in electronically excited metal-organic compounds comprising Eu(II), we use the term excited-state electron binding energy (ES-EBE), which is related to what is commonly known as the electron affinity or LUMO energy of most organic materials.

In various preferred embodiments, the second charge-neutral organic compound has an electron binding energy higher than 4.5 eV, preferably higher than 5.3 eV and most preferably higher than 6.0eV. Generally, organic materials with deeper HOMO (corresponding to a higher EBE) generally allow to design more chemically stable organic devices. Additionally, the coordination compound present in the mixture according to invention is preferably emitting deep blue light with a substantial fraction of the emitted light at emission energies higher than 2.5 eV. With an electron binding energy of no more than 4.5 eV, this would imply an electron binding energy in the lowest excited state (ES-EBE) of the emitter molecule of no more than 2.0 eV, which might still yield a chemically stable emitter, yet stronger bound excited electrons are preferred.

No requirements on the second organic material are needed to ensure electron confinement on the charge-neutral coordination compound, as Eu(I) is energetically not accessible. In other words, the typical coordination compounds comprising divalent Europium according to invention typically do not trap electrons. Or in yet other words: an excited divalent Europium would not create a charge transfer state by transferring a hole to a surrounding matrix, whilst leaving the excited electron on the coordination compound.

Yet, while electron transfer from the second organic material (b) to the metal-organic coordination compound (a) is unlikely, excitation energy transfer from the metal-organic coordination compound to the second organic material may occur. Therefore, in preferred embodiments, the second charge-neutral organic compound (b) has a triplet energy that is higher than the emission energy of the coordination compound (a).

In passing, we note that the multiplicity of the coordination compound in both, its ground state and first electronically excited state is neither a triplet nor a singlet but, as already mentioned above, a multiplet with seven unpaired electrons. The emission proceeds via the spin-conserving and thus parity- and Laporte-allowed 5d-4f transition: [Xe] 4f⁶5d¹6s⁰→ [Xe] 4f⁷5d⁰6s⁰. In contrast, for organic materials, the lowest electronic energy levels are in most cases the triplet levels. Therefore, to confine the energy on the emitting coordination compound the surrounding matrix should have a higher triplet energy vs the emission energy of the coordination compound.

There are many possible ways to probe the triplet energy level of an organic molecule. A simple way is to use suitable quantum mechanical calculations. Experimentally, the onset of the phosphorescence spectrum is taken as triplet energy, which is usually detected using gated spectroscopy, as pioneered by Romanovskii et al. "Phosphorescence of π-conjugated oligomers and polymers." Physical Review Letters 84.5 (2000): 1027. Without limiting the general scope of the invention, a very modest selection of possible organic materials that might be present as second organic material in the mixture according to invention is illustrated as **H1** to **H20** in **FIG. 3** and their corresponding triplet levels are given in **Table 3** below. Similarly, calculated energies of the first excited state of various coordination compounds are tabulated in **Table 2** below. In preferred embodiments, the mixture according to invention emits in the deep blue spectral region substantially at wavelength shorter than 496 nm, preferably less than 477 nm, most preferably less than 459 nm. Consequently, the second organic compound has preferably a triplet energy higher than 2.5 eV, preferably higher than 2.6 eV and most preferably higher than 2.7 eV to still ensure sufficient energy confinement on the coordination compound.

While the coordination compound in its first electronically excited state will not transfer a hole to the nearby matrices, it might transfer an electron leaving behind the positively charged coordination compound comprising Eu(III). For high emission efficiency from the coordination compound, such a transfer of charge/electrons from the excited emitter molecule is preferably prevented by confining the excited electron to the coordination compound. Therefore, the preferred second charge-neutral organic material (b) being part of the mixture according to the invention has an electron affinity that is lower than the electron binding energy of the coordination compound in its lowest electronically excited state (ES-EBE). In this context, electron affinity is associated with the energy of the lowest unoccupied molecular orbital (LUMO) of the organic material.

Similar to hole transport, also electron transport levels of organic materials can easily be probed by a wide variety of methods. Again, quantum chemical calculations are most straightforward and cyclic voltammetry in solution offers experimental access, though with some limitations since the measurement takes place in solution environment and not in a thin film, which may significantly affect those levels. For the few materials illustrated as **H1** to **H20** in **FIG. 3****,** the corresponding electron affinities are quoted in **Table 3,** while calculated electron binding energies of various electronically excited coordination compounds are provided in **Table 2** below. As explained previously, chemically stable mixtures that efficiently emit light are generally obtained for materials where the charges are confined to the emitter. Thus, it is preferred that the second organic compound has an electron affinity higher than 2.0 eV.

The combination of unique emission properties with the ease of processing makes mixtures comprising the coordination compounds based on divalent Europium in combination with an asymmetrical ligand according to formula (1-1) highly attractive for application in organic electronic devices. In this description, an organic electronic device may be any device or structure including substantially organic layers or subunits, where an electro-magnetic stimulus may be converted into an electrical field or current or vice versa, or where an input electrical current or electrical field may be used to modulate an output electrical current or electrical field.

In one embodiment, the organic electronic device including the mixture according to various embodiments may be used as semiconducting organic layer in an organic field-effect transistor or an organic thin-film transistor.

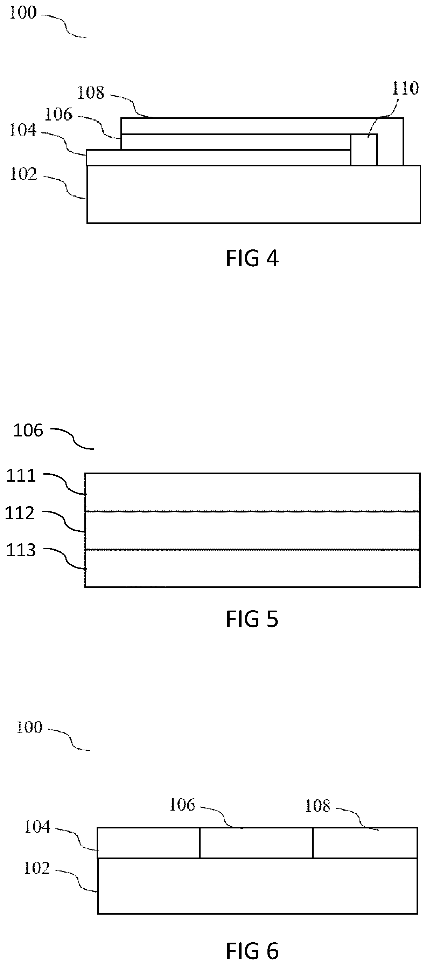

**FIG. 4** and **FIG. 6** illustrate embodiments of an organic electronic device 100 configured as optically active device. The organic electronic device may include a first electrode 104, e.g., on a substrate 102 or as the substrate; a second electrode 108; and an organic layer 106 arranged such that it is electrically interposed between the first and second electrodes 104, 108. The first and second electrodes 104, 108 may be electrically insulated from each other by an insulating structure 110, e.g. a resin or polyimide. The first and second electrodes 104, 108 may be stacked over each other (FIG. 4) or may be arranged in a common plane (**FIG. 6**).

The organic layer 106 may include the mixture according to any of the described or illustrated embodiments, e.g., the layer may contain just the mixture, or the mixture might comprise of further organic or non-organic materials. The organic layer may be a single layer or contain a plurality of layers. **FIG. 5** illustrates the situation where the organic layer 106 comprises a plurality of layer 111, 112, and 113. The mixture according to invention may be part partly or exclusively contained in one or more layers present in the overall organic layer 106.

In various embodiments, the organic electronic device 100 may be an optoelectronic device, the optoelectronic device being at least one of an organic light emitting diode (OLED), a light emitting cell (LEC), an organic photodetector, or a photovoltaic cell. That is, photons from an external electromagnetic field may be absorbed in the organic layer 106 and converted into current by means of an electrical field between the first and second electrodes 104, 108. Such a device would be a photodiode (OPD) and its primarily use may be to sense external light. It would be an organic photovoltaic (OPV) device, if the primarily use is to convert light into current.

The organic layer 106 is arranged electrically between the first and second electrodes 104, 108, such that an electronic current may flow from the first electrode 104 through the organic layer 106 to the second electrode 108 and vice versa during operation, e.g., in light emission applications. Alternatively, in photoelectric applications, a charge carrier pair may be formed in the organic layer 106 and charge carriers of the charge carrier pair may be transported to the first and second electrodes 104, 108 respectively. In other words, in light emission applications, upon application of sufficient voltage, holes and electrons are injected from the anode and the cathode, respectively, and drift towards the organic layer 106, where charges of opposite sign recombine to form a short-lived localized excited state. The short-lived excited state may relax to the ground state thereby giving rise to light emission.

The first and second electrodes 104, 108 may be substantially unstructured layers, e.g., for general lighting applications, or may be structured, e.g., for light emitting diodes or transistors for pixels in a display application.

The organic electronic device 100 may be configured to emit substantially monochromatic light such as red, green, blue, or polychromatic light such as white. The light may be emitted through the first electrode 104 (bottom emitter), through the second electrode 108 (top emitter), or through first and second electrodes 104, 108 (bidirectional emitter). The light may as well be substantially emitted in a direction parallel to the organic layer 106 using suitable opaque electrodes 104, 108. In such a layout, lasing may be achieved, and the device may be an organic laser, which, in this description, may be considered as a specific type of electroluminescent devices.

The mixtures according to various embodiments may have excellent emission properties, including a narrow deep blue emission spectrum with short excited state lifetime. Given their high atomic weight and open shell electronic structure, the optical transitions of Eu(II) complexes are widely indifferent to excitation with either spin 1 or spin 0 electron-hole pairs. In other words, both singlet and triplet excitations are harvested, resulting in very efficient light emission. As such, the mixtures according to various embodiments may be ideally suited for application in organic electroluminescent devices, such as organic light emitting diodes (OLED). In this description, an electroluminescent device may be any device including an organic layer disposed between and electrically connected to an anode 104/108 and a cathode 108/104. Upon application of sufficient voltage, holes and electrons may be injected from the anode 104/108 and the cathode 108/104, respectively, and drift towards the organic layer 106, where charges of opposite sign recombine to form a short-lived localized excited state. The short-lived excited state may relax to the ground state thereby giving rise to light emission. Relaxation pathways without light emission, such as thermal relaxation, may be possible too, but may be considered undesirable, as they lower the conversion efficiency of current into light of the device. Organic light emitting cells (LECs) may be considered as a subclass of OLED devices comprise of mobile charged species inside the active organic layer 106, which are able to drift inside an external applied electrical field. As such OLEDs encompass LEC type devices.

Further layers may be formed and in electrical connection between the first and second electrodes 104, 108, e.g., configured for charge carrier (electron or hole) injection, configured for charge carrier transport, configured for charge carrier blockage or configured for charge generation. For example, FIG. 5 may represent the situation where the mixture according to invention is present in layer 112 whereas the nearby layers 111 and or 113 may be configured as charge transport or charge blocking layers. The recombination of electrons and holes may as well happen at the interface of the organic layer 106, which contains the mixture according to the invention and an adjacent layer, such as an electron blocking layer. For example, in case layer 112 depicted in FIG. 5 contains the mixture according to invention comprising a hole transporting second organic materials and the layer in physical contact 111 is configured to be an electron transporting layer, then charge recombination may happen at the interface between layer 111 and 112 with subsequent energy or charge transfer to the coordination compound present in layer 112. Further optically functional layers, e.g., a further electroluminescent material and/or a wavelength conversion material may be formed electrically between the first and second electrodes 104, 108 and in the optical path of the organic layer 106, e.g., on top of the second electrode 108 and/or on the opposite side of the substrate 102. In addition, encapsulation structures may be formed encapsulating the electrically active area, e.g., the area in which electrical current flows and may be configured to reduce or avoid intrusion of oxygen and/or water into the electrically active area. Further optically functional layers, e.g., an antireflection coating, a waveguide structure and/or an optical decoupling layer may be formed within the optical light path of the organic layer 106.

As example, hole or electron blocking layers may be used to optimize the individual hole and electron currents through the organic electronic device 100. This may be known to those skilled in the art as charge balance in order to optimize efficiency and operational stability. In various embodiments, dedicated hole or electron charge transport layers may be present in the organic electronic device 100 to space the emission region from the first and second electrodes 104, 108. For example, layers 111 and or 113 depicted in FIG. 5 may be configured as electron - and or hole blocking layer, while layer 112 contains the mixture according to the invention.

Examples of hole transport materials include known materials such as fluorene and derivatives thereof, aromatic amine and derivatives thereof, carbazole derivatives, dibenzofuran, dibenzothiophene, and polyparaphenylene derivatives. Examples of electron transport materials include oxadiazole derivatives, triazine derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and its derivative, diphenoquinone derivatives, and metal complexes of 8-hydroxyquinoline and its derivatives and various derivatives of silanes.

In various embodiments, those charge transport layers may include electrical dopant molecules or metals or may be in contact to charge injection layers.

Any of those auxiliary layers may be fully organic or may include inorganic functional moieties. For example, charge transport layers may be made of the class of Perovskite materials.

In case that the charge recombination occurs substantially close to or at the interface of the organic layer comprising the mixture according to the invention with a nearby charge transport or blocking layer then it is preferred that the organic materials being present in the charge transport or blocking layer have a higher electron binding energy than the charge-neutral coordination compound, and/or having a higher triplet energy compared to the emission energy of the coordination compound in its lowest electronically excited state, and/or having an electron affinity that is lower than the electron binding energy of the coordination compound in its lowest electronically excited state. This ensures that both charges and excitons are confined on the coordination compound being part of the mixture according to the invention instead of transferring to the nearby organic layer. For example, in case layer 112 depicted in **FIG. 5** contains the mixture according to invention comprising a hole transporting second organic material and the layer in physical contact 111 is configured to be an electron transporting layer, then charge recombination may happen at the interface between layer 111 and 112. In this situation it is preferred that organic materials present in layer 111 have a higher electron binding energy relative to the neutral coordination compound present in the mixture in layer 112. Therefore, positive charges that may be present in the mixture in layer 112 do not transfer significantly to the organic layer 111. Further preferred is a higher triplet energy and/or an electron affinity that is lower than the electron binding energy of the coordination compound in its lowest electronically excited state. Thus, in this preferred arrangement of layer 111 and 112, electrons, holes, and excitations are confined on the coordination compound being present in layer 112 instead of transferring to the organic materials present in layer 111.

The mixture according to the invention as illustrated or described in any one of the embodiments may be used as a thin substantially organic emission layer 106 of any thickness in the range of 0.1 to 100 nm, preferably in the range of 3 to 20 nm. The concentration of the coordination compound throughout the cross section of the organic layer may be constant or varied. Typical variable concentrations are in the range of 0 to 100 vol%, i.e., the layer may be partially containing either no coordination compound or just coordination compound. Such situations are indeed frequently observed if mobile evaporation sources are employed to co-sublime the organic material with the coordination compound. The emission layer 106 may as well be configured as a plurality of mixtures according to the invention having different concentrations of coordination compound. For example, in **FIG. 5****,** layer 111, 112, and 113 may all contain the second organic material present in the mixture according to the invention and three layers may contain 0, 3, 20 vol% of the metal-organic coordination compound, respectively. The emission layer 106 may as well be configured such that the metal organic coordination compound is present in two adjacent layers, for example 112 and 113 depicted in **FIG. 5****,** but the second organic material being present in the mixture according to the invention is different in both layers. It may for example be a substantially hole transporting material in layer 112, yet a substantially electron transporting organic material in layer 113.

The requirements for adjacent organic materials are similar if the mixture according to the invention has a very high volume or weight or molar concentration of the coordination compound. In the extreme case, the mixture may contain only 1% or less or the second organic material, i.e., it is a substantially pure layer containing the divalent Europium coordination compound having an asymmetrical ligand according to formula (1-1). It might for example be beneficial to avoid co-deposition but instead to sandwich a nearly pure and thin layer of the coordination compound within two suitable organic layers. In such a situation the substantially pure layer containing the coordination compound may be rather thin, i.e., between 0.2 to 10 nm, or preferably 1 to 3 nm. The interface of such a substantially pure layer of coordination compound with the adjacent organic layers may still be considered as a mixture according to the invention. Therefore, the same requirements as for the second material present in the mixture according to the invention are beneficial. The situation is further illustrated by referring to **FIG. 5****.** Here, layer 112 may be configured as substantially pure layer of coordination compound, while layer 111 and or layer 113 may contain organic material, in particular charge transport or charge blocking materials. In such situation, it is preferred that the organic materials being present in the charge transport or blocking layer 111 and or 113 have a higher electron binding energy than the charge-neutral coordination compound, and/or having a higher triplet energy compared to the emission energy of the coordination compound in its lowest electronically excited state, and/or having an electron affinity that is lower than the electron binding energy of the coordination compound in its lowest electronically excited state. This ensures that both charges and excitons are confined on the coordination compound being present in layer 112 instead of transferring to the nearby organic layers.

The second organic material being present in the mixture according to the invention being part of the organic layer 106 may in various embodiments be a charge transport material to improve charge transport into and through the organic layer 106 or to facilitate charge recombination. Charge transport materials may be any material that are able to transport either holes or electrons or both types of charges upon applying a suitable electrical field. In particular a charge transport material may be any aryl, or heteroaryl organic compound or any metal complex or any mixture thereof. Examples of materials present in the light emitting layer 106 include carbazole derivatives, including carbazole-phosphine oxide materials, oxadiazole derivatives, triazine derivatives, silane derivatives and any other material or combination of materials with sufficiently high triplet level that may transport charges or otherwise benefit the device performance. Without limiting the scope of the invention, a small selection of possible charge transport materials is depicted as **H1** to **H20** in **FIG. 3****.**

The organic layer 106 that contains the mixture according to the invention may contain any further organic or inorganic material in a range of 0.1 to 99.0 vol% that is not intended to transport charges. For example, the organic layer 106 may include polymers (in a mixture or as a compound) which may be added to improve film quality and prevent crystallization. Other materials may be added to evenly space the coordination compound inside the organic layer 106.

In color conversion materials, the mixtures according to various embodiments may allow the ease of processing using vacuum based techniques. In other words, the evaporation temperature of the mixtures including the coordination compound and the second organic material may be sufficiently low to allow for thermal vacuum processing techniques to be used. Reduced evaporation temperatures can be achieved according to the invention by using the metal-organic coordination compounds with their asymmetrical ligand according to formula (1-1) as here the ionic character of the compounds is strongly suppressed, if compared to similar organic salts based on symmetrical ligand design. Consequently, the evaporation temperature is reduced and incorporation into organic electronic devices becomes possible using state-of-the-art vacuum deposition techniques.

In various embodiments, the organic electronic device 100 includes two or more subunits each including at least one light emitting layer. The subunits may be stacked over each other physically separated and electrically connected by a charge generation layer or, alternatively, may be arranged side by side. The subunits may be subpixels of a pixel in a display or general lighting application. The light emitted by the subunits may be mixed to generate a light of a predetermined color. Each subunit may emit light of the same or a different color. The overall light emitted by such organic electronic device 100 may contain a narrow spectral region, such as blue, or may contain a wide spectral region such as white, or a combination thereof. The mixture according to the invention comprising the divalent Europium compound illustrated or described in any one of the embodiments may or may not be present in all subunits of the organic electronic device 100.

In various embodiments, the light emitted by the organic electronic device 100 may be in optical contact to at least one optically active layer, including any optically active materials such as organic molecules or quantum dots. The optically active layer may be a spectral filter element, which may absorb part of the light emitted by the organic electronic device 100. In another embodiment, the optically active layer may absorb at least part of the light emitted by the organic electronic device 100 and may reemit it at longer wavelength (wavelength conversion), e.g., by quantum dots. As example, the organic layer 106 may be configured to emit light substantially at wavelengths shorter than 500 nm and the optically active layer may be configured to substantially reemit light at wavelengths longer than 500 nm. The optically active layer may be placed in between the anode and cathode of the organic electronic device 100 or outside of it. The optically active layer may as well be part of the organic layer 106.

The organic electronic device 100 may be configured as a large area OLED device used for illumination, signage, or as a backlight. Alternatively, the organic electronic device 100 may include a plurality of OLEDs arranged in a pixelated layout (plurality of OLED pixels) that are individually connected electrically, e.g., for flat panel display applications. Here, individual pixels may have the capability of emitting light of substantially narrow spectral portions; especially of red, green, and blue. The mixture may or may not be present in any of the individual pixels.

In another embodiment, the individual pixels may be configured to emit white light. Red, green, and blue spectral portions are generated by using suitable filter elements in optical contact with the respective pixelated OLEDs.

In another embodiment, the OLED pixels emit blue light, and the red and green spectral portions may be generated by using a suitable color conversion element in optical contact with the OLED pixels.

In another embodiment, the OLED pixels emit substantially in the near-UV spectral region with wavelength < 450 nm and the red and green and blue spectral portions may be generated by using a suitable color conversion element in optical contact with the OLED pixels.

In various embodiments, the organic electronic device 100 includes an anode 104; a cathode 108; and an organic layer 106 disposed between the anode 104 and the cathode 108. The organic layer 106 includes a mixture according to various embodiments. The mixture includes - divalent Europium coordinated by a polymacrocyclic organic ligand according to the present invention according to formula (1-1).

An organic electronic device 100 according to various embodiments may be fabricated using a wide range of commonly used techniques, including, but not limited to, deposition of all or some layers, from gas phase vacuum deposition, solution phase, or gas phase using a carrier gas method.

Due to the asymmetry of the polymacrocyclic ligands according to formula (1-1) many Europium organic complexes according to the invention show a relatively low dipole moment allowing for thermal deposition from gas phase with high yields. Thus, in various embodiments, deposition via the gas phase in vacuum may be used, whereby the coordination compound may either undergo sublimation or evaporation and may be co-deposited with the second organic materials being present in the mixture. The coordination compounds being part of the mixture according to the invention show an improved sublimation/evaporation yield. The transfer into the gas phase may be improved by using a carrier gas technology, whereby an inert gas that may not be deposited into the organic layer comprising the mixture may be helping the sublimation or evaporation of the coordination compound or the mixture to be deposited. During the deposition process from gas phase, the coordination compound may be co-deposited with the second organic material using two separate thermal sources, in other words, the mixture is formed in-situ after deposition. During such co deposition two or more additional materials may be deposited using a triple or quadruple evaporation, whereby the mixture according to the invention is further diluted. Alternatively, the mixture may as well be thermally processed from one crucible. In other words, the mixture or a precursor thereof is already present before sublimation or evaporation. A precursor may for example be an additional auxiliary ligand present as part of the coordination compound that dissociates during thermal evaporation and that is substantially not built into the organic layer comprising the mixture according to the invention. Preferred in this situation are similar volatilities for the second organic material and the coordination compound. Alternatively, the coordination compound and the second organic material may form a frozen glass, thereby forcing the individual components to sublime at similar temperatures.

Another preferred technique to fabricate layers including the mixture according to various embodiments may be deposition from a liquid phase using a mixture of or a single organic solvent, whereby the mixture according to various embodiments may be dissolved or forms a suspension within the organic solvent; in this description may be referred to as the ink. The ink using this deposition process may include a wide variety of other materials apart from the two materials present in the mixture according to various embodiments to allow fabrication of triple or higher-order mixed layers from solution. Additives within the ink may for example, but may not be limited to, be organic or inorganic materials capable of transporting charges, materials that improve the film formation, materials that improve the distribution of the mixture within a third material, organic or inorganic materials that improve the efficiency of the device, e.g., by reducing the refractive index. The deposition from solution may not be limited to any specific technique. Examples of the deposition from solution include spin coating, casting, dip coating, gravure coating, bar coating, roll coating, spray coating, screen printing, flexographic printing, offset printing, inkjet printing. The improved solubility of the coordination compounds being present in the mixtures according to the present invention in non-polar solvents eases the deposition from solution and makes it advantageous. In particular, solvents with relatively low polarity index such as tetrahydrofuran or toluene may be used as part of the ink formulation.

Various post processing techniques may be applied to improve the performance or stability of the organic electronic device. In one embodiment, some or all layers of the organic electronic device include functional groups capable of chemically crosslinking upon thermal or optical exposure thereby forming larger covalently bound molecules with improved physical properties. In another embodiment the functional groups are present in the second organic material and after crosslinking the second organic material becomes a polymer. In yet another embodiment the functional groups capable of crosslinking are present on both, the coordination compound and the second organic layer, and after crosslinking, a single polymeric material comprising both materials is formed.

In various embodiments, the coordination compound as part of the mixture may be formed in-situ using deposition from solution. Here, the organic ligand according to formula (1-1) of the present invention including the second organic materials, but excluding the divalent Europium, may first be deposited onto a suitable substrate or other organic layer thereby forming a seed layer. Any suitable technique may be used to fabricate this seed layer. This seed layer including the organic ligand and second organic material may include any further material. Preferred may be further additional inert organic or inorganic materials that aid the layer formation or improve its thermal stability or improve the distribution of the organic ligand or second organic material within this seed layer. In a next deposition step and sequential to forming the seed layer including the organic ligand and the second organic material according to the invention excluding the metal, a layer including a molecular salt comprising the divalent Europium may be fabricated using a solution process. The Europium compound may be any charge neutral compound including Eu(II) and one or two suitable anions. The anions may as well be covalently bound to a suitable polymer. The ink including the Europium compound may as well include one or more additives to fabricate mixed layers. These additives may be organic or inorganic materials to aid charge transport, may be organic or inorganic materials that improve the efficiency of the device, or may be any material that improves the film formation. At the interface of the seed layer including the organic ligand being part of the mixture according to the invention, the solubilized divalent Europium compound will interact with the polymacrocyclic organic ligand according to formula (1-1) to form the coordination compound as part of the mixture according to various embodiments in-situ. Alternatively, the process of first forming the layer containing the ligand and secondly processing the lanthanide compound may be inverted.

For one or more aspects, at least one of the components set forth in one or more of the preceding figures may be configured to perform one or more operations, techniques, processes, and/or methods as set forth in the example section below.

### EXAMPLES

The examples set forth herein are illustrative and not exhaustive.

### Synthesis of various divalent Europium coordination compound with asymmetrical ligand according to formula (1-1)

**Table 1 Overview of coordination compounds comprising asymmetrical ligand according to formula (1-1) that are used in mixtures according to the invention and in referenceexamples. The chemical structures of the compounds can be found in FIG. 2.**

| **compound** | **europium(II) salt** | **Ligand** |
|---|---|---|
| **E01** | Eu(CB)₂ | 4,18-Dimethyl-11,24,29-trioxa-1,4,18,21-tetraazatetracyclo-[19.5.5.05,10.012,17]hentriaconta-5,7,9,12,14,16-hexaene |
| **E32** | EuI₂ | 7,16,21-Trioxa-1,4,10,13-tetraazabicyclo[11.5.5]tricosane |
| **E33** | EuI₂ | 4,10-Dimethyl-7,16,21-trioxa-1,4,10,13-tetraazabicyclo[11.5.5]-tricosane |
| **E34** | Eu(TFSI)₂ | 4,10-Dimethyl-7,16,21-trioxa-1,4,10,13-tetraazabicyclo[11.5.5]-tricosane |
| **E35** | EuI₂ | p-[2-(2-{2-[2-(Tosyloxy)ethoxy]ethoxy}ethoxy)ethoxysulfonyl]-toluene |
| **E36** | EuI₂ | 4,18-Dimethyl-11,24,29-trioxa-1,4,18,21-tetraazatetracyclo-[19.5.5.05,10.012,17]hentriaconta-5,7,9,12,14,16-hexaene |

The following procedures are, unless indicated otherwise, carried out under an inert atmosphere in oven dried glassware. The solvents, starting materials and reagents can be purchased from any commercial source and are, unless otherwise stated, used without further purification.

### Syntheses of starting materials

### Bis[bis(trimethylsilyl)amide]bis(tetrahydrofuran)europium(II) (Eu(HMDS)2)

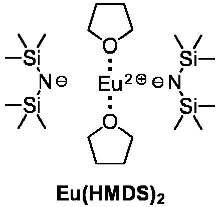

Sodium bis(trimethylsilyl)amide (2 eq, 49.2 mmol) was added under a nitrogen atmosphere to the solution of europium diiodide (1 eq, 24.6 mmol) in 300 ml of anhydrous THF. The mixture was stirred at RT overnight. THF was removed in vacuum and residue was extracted with hexane (250 ml). The extract was filtered and concentrated to ca. 50 ml volume. Cooling of the solution to 0 °C resulted in precipitation of the title product as orange-yellow crystals.

Yield: 90%.

### Europium (II) carbadodecaborate (Eu(CB)₂)

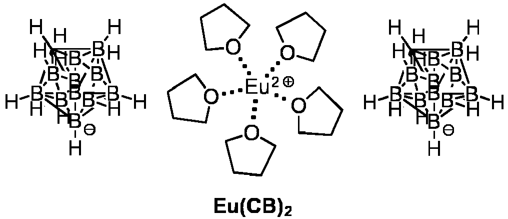

Trimethylammonium carbadodecaborate (1 eq, 4 mmol) was dried in a Glovebox for 1 h at 100 °C, then dissolved in anhydrous THF (20 ml). A solution of **Eu(HMDS)₂** (0.5 eq, 2 mmol) in anhydrous THF (10 ml) was added dropwise at RT. The mixture was stirred for 1 h. White crystals formed which were collected via suction filtration, washed with THF and dried in vacuum to yield the title compound.

Yield: 100%.

### Europium(II) bis(oxo(trifluoromesylimino)(trifluoromethyl)-λ6-sulfanolate (Eu(TFSI)₂)

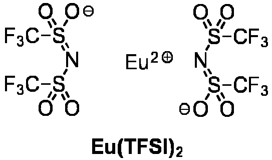

Europium(II) chloride (1 eq, 9 mmol) was dissolved in MeOH (18 ml). A solution of sodium methoxide (2 eq, 18 mmol) in MeOH (18 ml) was added and the mixture was stirred for 30 min at rt. A solution of trifluoromethansulfonimide (2 eq, 18 mmol) in MeOH (18 ml) was added and stirring continued for 30 min. The solvent was removed and the residue dried in vacuum. The white precipitate was diluted with THF (ca. 60 ml), filtered and washed with THF (3x 20 ml). The filtrate was concentrated and dried in vacuum. The residue was diluted with Et₂O (ca. 40 ml) and the mixture was stirred at rt for 30 min. The precipitate was filtered, washed with Et₂O and dried in vacuum.

Yield: 88%.

### Syntheses of the asymmetrical ligands according to formula (1-1)

The ligands used for the preparation of compounds **E32-E34** were synthesized according to the following scheme:

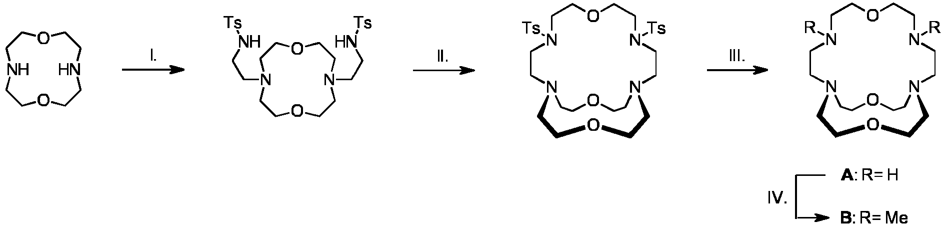

### Step I.

1-(Tosylamino)-2-(10-[2-(tosylamino)ethyl]-1,7-dioxa-4,10-diaza-4-cyclododecyl)-ethane A solution of 1,7-Diaza-12-crown-4 (1 eq, 22.9 mmol) in MeCN (110 ml) was heated to reflux. N-Tosylaziridine (2 eq, 45.8 mmol), dissolved in MeCN (120 ml), was added dropwise within 2.5 h. The mixture was cooled to RT and stirred further for 16 h. The solvent was removed in vacuum. The residue was purified by recrystallization from ethanol.

Yield: 95%; ¹H-NMR (62 MHz, CDCl₃): δ (ppm) = 2.25-3.3 (br. m. 22 H), 3.64 (br. t., 8 H), 6.79 (br. s., 2 H), 7.27 (d, J = 8.09 Hz, 4 H), 7.75 (d, J = 8.39 Hz, 4 H); MS (ESI): m/z = 569.4 [M+H]⁺, 592.4 [M+Na]⁺.

### Step II.

### 4,10-Ditosyl-7,16,21-trioxa-1,4,10,13-tetraazabicyclo[11.5.5]tricosane

A mixture of 1-(Tosylamino)-2-(10-[2-(tosylamino)ethyl]-1,7-dioxa-4,10-diaza-4-cyclododecyl)ethane (1 eq, 10 mmol), Diethylene glycol bis(p-toluenesulphonate) (1 eq, 10mmol), Tetrabutylammonium iodide (0.28 eq., 2.8 mmol), NaOH (266 eq, 2.66 mol, as 50 wt-% aqueous solution) and Toluene (600 ml) was stirred under reflux for 12-16 h. The mixture was cooled to rt and transferred to separation funnel. The organic layer is separated and dried with MgSO₄. The solvent was removed in vacuum and the residues purified by recrystallization from MeCN.

Yield: 92%; ¹H-NMR (62 MHz, CDCl₃): δ (ppm) = 2.2-3.0 (m, 18 H), 3.1-3.9 (m, 14 H), 7.3 (d, 4 H), 7.6 (d, 4 H), MS (ESI): m/z = 639.5 [M+H]⁺.

### Step III.

### 7,16,21-Trioxa-1,4,10,13-tetraazabicyclo[11.5.5]tricosane

A mixture of 4,10-Ditosyl-7,16,21-trioxa-1,4,10,13-tetraazabicyclo[11.5.5]tricosane (1 eq, 10 mmol) and H₂SO₄ (80 wt-%, 15 eq, 150 mmol) was stirred at 100 °C for 48 h. HCl_{aq}. (conc., 11 eq, 110 mmol) was then added carefully and the obtained mixture poured into acetone (400 ml). The mixture was refrigerated until the oily layer solidified. The supernatant solution was decanted off and the residue crystallized by adding MeOH. The colorless solid was filtered off, dissolved in a small amount of water and passed through an anion-exchange column (Amberlite IRA-410 (OH), eluant MeOH/H₂O 20/1). The aqueous eluate was concentrated under reduced pressure and the remaining oil was extracted with boiling hexane (3x). The solvent was removed in vacuum and the title compound obtained as a colorless oil which crystallized by refrigeration.

Yield: 70%, ¹H-NMR (62 MHz, CDCl3) δ (ppm) = 2.38-3.21 (m, 22 H) 3.42-4.04 (m, 12 H); MS (ESI): m/z = 331.4 [M+H]⁺, 353.4 [M+Na]⁺.

### Step IV.

### 4,10-Dimethyl-7,16,21-trioxa-1,4,10,13-tetraazabicyclo[11.5.5]tricosane

A mixture of 7,16,21-Trioxa-1,4,10,13-tetraazabicyclo[11.5.5]tricosane (1 eq, 2.3 mmol), Formaldehyde (37 wt-%, 43 eq, 99 mmol) and Formic acid (58 eq, 133 mmol) was stirred under reflux for 16 h. The mixture was concentrated in vacuum and the residue alkalized with NaOH_{aq}. (12.5 M) until pH 13 was reached. The aqueous layer was extracted several times with CHCl₃. The combined extracts were dried over Na₂SO₄ and concentrated in vacuum. The residue was extracted with hexane (5x) and the extracts evaporated to dryness, yielding the crude product as colorless to pale-yellow oil. Final purification was achieved by distillation using a Kugelrohr-apparatus.

Yield: 64%, ¹H-NMR (62 MHz, CDCl3): δ (ppm) = 2.31-2.55 (s, 6 H), 2.61-2.90 (m, 10 H), 3.49-3.82 (m, 16 H); MS (ESI): m/z = 359.3[M+H]⁺, 381.3 [M+Na]⁺.

The ligand used for the preparation of complex **E35** was synthesized according to the following scheme:

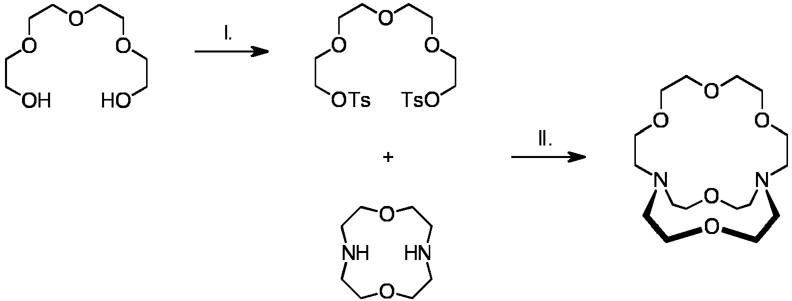

### Step I.

### p-[2-(2-{2-[2-(Tosyloxy)ethoxy]ethoxy}ethoxy)ethoxysulfonyl]toluene

The title compound was prepared using a known procedure (R.-P. Moldovan et al. J. Med. Chem. 2016, 59, 7840-7855).

The product was isolated as a colorless oil and dried in vacuum before use.

Yield: 97%.

### Step II.

### 4,7,10,16,21-Pentaoxa-1,13-diazabicyclo[11.5.5]tricosane

1,7-Diaza-12-crown-4 (1 eq, 5.74 mmol), p-[2-(2-{2-[2-(Tosyloxy)ethoxy]ethoxy}-ethoxy)ethoxy-sulfonyl]toluene (1 eq., 5.74 mmol) and sodium carbonate (242 eq., 1388 mmol) were diluted with MeCN (573 ml). The mixture was refluxed for 24 h. The reaction was cooled to room temperature and the solvent removed under reduced pressure. The solid residue was dissolved in water (920 ml) and the aqueous solution extracted with dichloromethane. The combined organic phases were dried over MgSO₄. The solvent was removed under reduced pressure and the residue passed through a pad of aluminium oxide (neutral) using THF/EtOH (100/1, 500 ml) as eluant. The solvents were removed in vacuum to give a crude, which was purified by flash-chromatography (alumina oxide, neutral, CH₂Cl₂/MeOH 0% to 5%). After evaporation of the solvents the obtained slightly yellow oil was dissolved in MeOH and acidified with HCl_{aq}. (1 M). The aqueous mixture was concentrated to dryness. The remaining white solid was dissolved in a minimal amount of H₂O and passed through a anion-exchange column (Amberlite IRA-410 (OH), MeOH/H₂O 20:1). The eluate was concentrated under reduced pressure and the obtained oil extracted with hexane. After removal of the solvent in vacuum, the obtained crude product was purified by by distillation using a Kugelrohr-apparatus to give the title compound as a colorless oil.

Yield: 54%, ¹H-NMR (62 MHz, CDCl₃): δ (ppm) = 3.77-3.38 (m, 20 H), 2.65 (qd, J = 3.4, 1.8 Hz, 12 H); ¹³C-NMR (16 MHz, CDCl₃): δ (ppm) = 70.68 (CH₂), 70.52 (CH₂), 70.10 (CH₂), 69.89 (CH₂), 57.26 (CH₂), 56.34 (CH₂); MS (ESI): m/z = 333 [M+H]+, 355 [M+Na]⁺, 371 [M+K]⁺.

The ligand used for the preparation of complexes **E01** and **E36** was synthesized according to the following scheme:

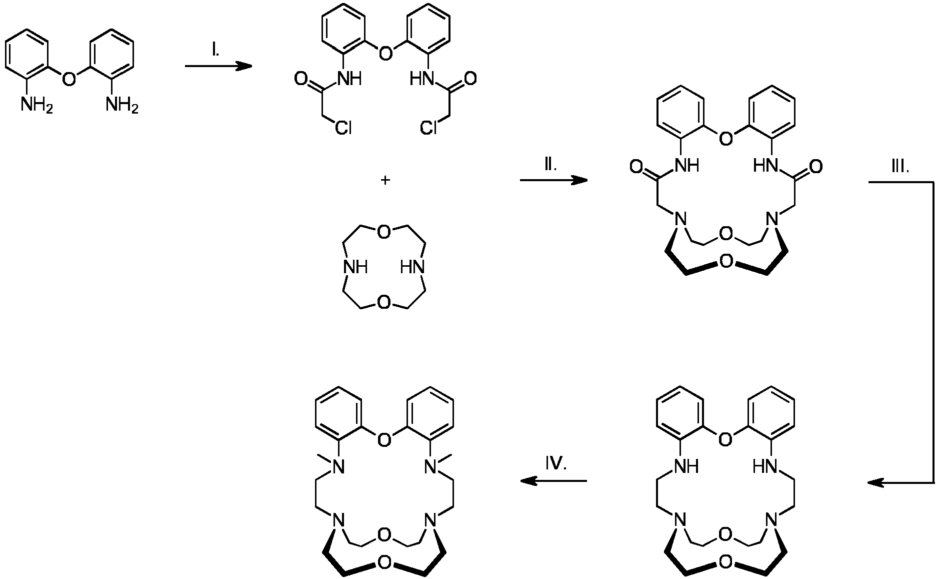

### Step I.

### N-(o-{o-[(Chloromethyl)carbonylamino]phenoxy}phenyl)chloroacetamide

To a mixture of 2,2'-Oxydianiline (1 eq, 37.5 mmol) and potassium carbonate (2.5 eq. 93.6 mmol) in CH₂Cl₂ (30 ml) was added under ice-cooling Chloroacetyl chloride (2 eq. 74.9 mmol) under within 30 min. After the addition was completed, the mixture was allowed to warm to rt and stirring was continued for 16 h. The crude product was filtered off, washed with cold MeOH and purified by recrystallization from MeOH.

Yield: 83%, ¹H-NMR (62 MHz, DMSO-d6): δ = 9.88 (s, 2 H), 7.99 (dq, J = 7.5, 4.1 Hz, 2 H), 7.05 (ddq, J = 14.4, 5.9, 3.5 Hz, 5 H), 4.36 (s, 4H); ¹³C-NMR (16 MHz, DMSO-d6) δ = 165 (C_{q}), 147 (C_{q}), 128 (C_{q}), 126 (CH), 124 (CH), 123 (CH), 118 (CH), 43 (CH₂).

### Step II.

### 11,24,29-Trioxa-1,4,18,21-tetraazatetracyclo[19.5.5.0^{5,10}.0^{12,17}]hentriaconta-5,7,9,12,14,16-hexaene-3,19-dione

To a refluxing mixture of *N*-(o-{o-[(Chloromethyl)carbonylamino]phenoxy}phenyl)-chloroacetamide (1 eq, 14.2 mmol) and sodium carbonate (20 eq, 283 mmol) in MeCN (1 l) was added a solution of 1,7-Diaza-12-crown-4 (1 eq, 14.2 mmol) in MeCN (250 ml) within 1 h. Stirring under reflux was continued for 16 h. The mixture was filtered, washed with MeCN and the filtrate concentrated under reduced pressure. The oily residue was purified by flash-chromatography (neutral alumina oxide, CH₂Cl₂/MeOH 0 to 2 %). The title compound was yielded as a colorless solid.

Yield: 78%, ¹H-NMR (62 MHz, CDCl₃): δ = 9.73 (s, 2 H), 8.05-8.26 (m, 2 H), 6.79 - 7.33 (m, 6 H), 3.61-3.92 (m, 8 H), 3.35 (s, 4 H), 2.68-3.11 (m, 8 H); ¹³C-NMR (16 MHz, CDCl₃): δ = 170,34 (C_{q}), 147.34 (C_{q}), 128.73 (C_{q}), 128.73 (CH), 125.24 (CH), 124.10 (CH), 123.98 (CH), 117.98 (CH); 70.13 (CH₂), 69.08 (CH₂), 62.06 (CH₂), 56.66 (CH₂), 54.76 (CH₂); MS (ESI): m/z = 477 [M+Na]⁺.

### Step III.

### 11,24,29-Trioxa-1,4,18,21-tetraazatetracyclo[19.5.5.0^{5,10}.0^{12,17}]hentriaconta-5,7,9,12,14,16-hexaene

1124,29-Trioxa-14,18,21-tetraazatetracyclo[19.5.5.0^{5,10}.0^{12,17}]hentriaconta-5,7,9,12,14,16-hexaene-3,19-dione (1 eq, 1.82 mmol) was dissolved in THF (25 ml). A solution of Lithium aluminium hydride (2.4 M, 10 eq, 18.2 mmol) was added and the mixture heated to reflux for 19 h. After cooling to 0 °C, the reaction was quenched by adding slowly H₂O. The mixture was filtered, washed with THF and the filtrate concentrated under reduced pressure. The oily residue was purified by flash-chromatography (neutral alumina oxide, CH₂Cl₂/MeOH 0 to 5 %). The title compound was yielded as a colorless solid.

Yield: 57%, ¹H-NMR (62 MHz, CDCl₃): δ = 6.79-7.33 (m, 8 H), 5.25-5.51 (m, 2 H), 3.45-3.82 (m, 8 H), 2.25-3.34 (m, 16 H); ¹³C-NMR (16 MHz, CDCl₃) δ = 144.48 (C_{q}), 140.36 (C_{q}), 123.78 (CH), 117.02 (CH); 116.70 (CH), 111.76 (CH), 70.36 (CH₂), 57.14 (CH₂), 56.96 (CH₂), 41.95 (CH₂); MS (ESI): m/z = 427 [M+H]⁺, 449 [M+Na]⁺.

### Step IV.

### 4,18-Dimethyl-11,24,29-trioxa-14,18,21-tetraazatetracyclo[19.5.5.0^{5,10}.0^{12,17}]-hentriaconta-5,7,9,12,14,16-hexaene

A mixture of 11,24,29-Trioxa-1,4,18,21-tetraazatetracyclo[19.5.5.0^{5,10}.0^{12,17}]-hentriaconta-5,7,9,12,14,16-hexaene (1 eq, 1 mmol), Formaldehyde_{aq} (37 %, 200 eq, 200 mmol) and Formic acid (200 eq, 200 mmol) was heated to reflux for 23 h. The reaction mixture was concentrated to dryness in vacuum. The residue was dissolved in a minimal amount of H₂O and passed through a anion-exchange column (Amberlite IRA-410 (OH), MeOH/H₂O 20:1). The eluate was concentrated under reduced pressure and the obtained oil extracted with hexane. After removal of the solvents in vacuum, the obtained crude product was purified by distillation using a Kugelrohr-apparatus to give the title compound as a colorless oil.

Yield: 35%, ¹H-NMR (62 MHz, CDCl₃): δ = 6.79-7.33 (m, 8 H), 3.45-3.82 (m, 12 H), 3.34 (s, 6 H), 2.25-3.34 (m, 16 H); MS (ESI): m/z = 456 [M+H]⁺, 478 [M+Na]⁺.

### General procedure for preparation of metal organic compounds:

The europium(II) salt (1 eq) and the ligand (1.05 eq) were dissolved separately in an appropriate solvent (THF or methanol). The solution, containing Eu(II), was added dropwise to the stirred solution of the ligand at RT. If the product precipitated, it was separated by filtration, washed with THF, hexane and dried. In other cases, the reaction mixture was evaporated to dryness, the residue triturated with THF or diethyl ether, the precipitated product separated by filtration, washed with THF (diethyl ether), hexane and dried. The compounds being made are tabulated in **table 1.**

The coordination compounds were further purified using a three-temperature zone sublimation tool (CreaPhys, DSU-5) being installed in a nitrogen glovebox. Here, the weight of the sublimed material was measured relative to the weight of the material in the sublimation source, giving the sublimation yield.

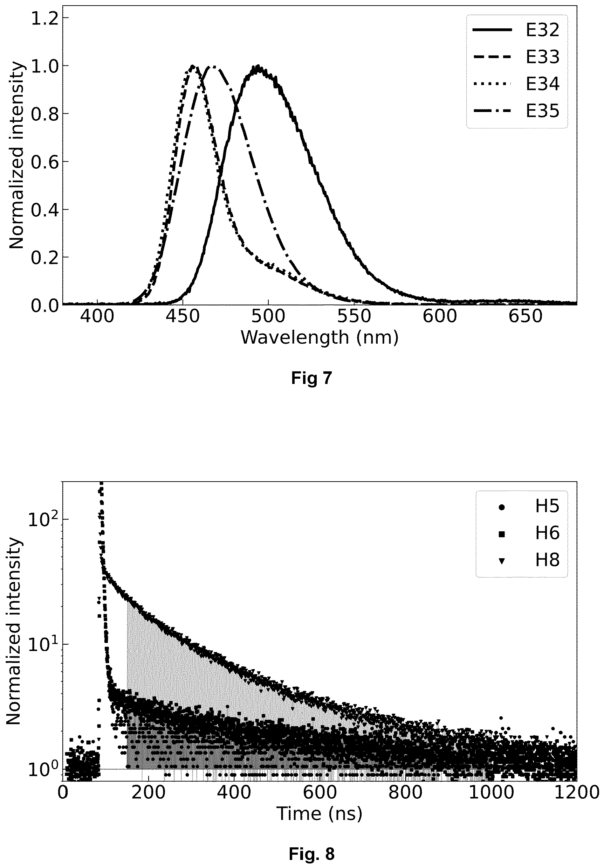

Photo-emission spectra of E32 to E35 dissolved in water and oxygen free methanole are depicted in **FIG. 7** testifying to the deep blue emission of those coordination compounds.

### Quantum-Chemical Methods to calculate relevant parameters of Europium coordination compounds

### Computational Protocols

The computational protocol to determine structures, emission energies (**EE**), and the electron binding energies of Eu(II) complexes in their electronic ground (4*f⁷*5*d⁰*) (**EBE**) and first (energetically lowest) excited (4*f⁶*5*d*¹) (**ES-EBE**) state consists of 3 main steps, all of which can be accomplished with freely available open-source software (xTB: https://github.com/grimme-lab/xtb; CREST https://github.com/crest-lab/crest; CENSO https://github.com/grimme-lab/CENSO) and the commercially available quantum-chemical program package ORCA (https://www.faccts.de/orca/).

These three steps are firstly, the generation of a large comprehensive ensemble of all possible structures of given complex in a large energy window with fast semi-empirical methods, secondly a multi-level energetical screening, optimization, and reranking of the structures in the large ensemble with increasingly accurate density-functional theory (DFT) to determine the relevant (energetically lowest) conformer(s), and thirdly the calculation of the desired properties with a (TD)-DFT methodology.

In principle, any quantum-chemistry software can be used for these calculations and would provide near-identical results if the methods described in detail below (functionals, dispersion corrections, basis sets, geometric Counter Poise corrections, effective core potentials, solvent models and parameters) are applied in the same way. Due to the statistical (non-deterministic) nature of the simulations in step one of this approach, the results are not exactly reproducible. However, if the simulation times are sufficiently long, the approach will always yield the same relevant (lowest energy) conformer after step 2, which will have very similar properties in the calculations in step 3. As a very conservative estimate, the precision of the predicted dipole moments (over repeated runs for the same molecule) should be ±1 D and ±0.1 eV for emission energies and ionization potentials.

The three main steps of the computation approach are:
1. **Generation of a comprehensive conformer ensemble** with the CREST program version 2.12 using the implemented semi-empirical tightbinding model GFN2-xTB and the Analytical Linearized Poission-Boltzmann (ALPB) solvation model with parameters for toluene as implemented in the xTB software version 6.4.1.
   The conformer generation uses at least two iterations with seven parallel metadynamics simulations, each with at least 30 picoseconds (ps) of simulation time (420 ps total), but more can be necessary for specific complexes.
   Since CREST by default excludes all molecules with topological changes in the bonding pattern compared to the starting structure (as these are isomers not conformers), changes on the central Eu-atom have to be explicitly allowed by excluding Eu from the topology check (--notopo Eu). This is required to ensure that structures with different coordination geometries and numbers of ligandatoms attached to Eu are also considered (e.g. an iodine coordinated to Eu(II) can move away and coordinate to an NH-proton instead).
   If isolated (not covalently bound) anions are included in the complex like iodide or closoborane, the NCI mode of CREST is invoked (-nci -wscal 1.5).
   All structures within 8 kcal/mol of the lowest structure are kept in the ensemble (and are thus included in step 2).
   Commandline prompt for the input-structure input.xyz:
      *crest input.xyz -gfn2 -alpb toluene (-nci -wscal 1.5) -mdlen 30 -nmtd 7 -notopo Eu -ewin 8*
2. **Multi-level screening, optimization, and reranking of the conformer ensemble** from 1. in 4 sub-steps with DFT methods of increasing accuracy using the CENSO program as driver and ORCA 5.0.3 to carry out the DFT calculations.
   **(A) Prescreening** based on PBE-D4/def2-SV(P)+gCP, single-point energies using the structures from step 1 (notation PBE-D4/def2-SV(P)+gCP//GFN2/ALPB(toluene)). Solvent effects are included by adding the GFN2-xTB/ALPB free energy of solvation (CENSO default) and the 28-electron def2-ECP effective core potential is used for Eu and all atoms heavier than krypton (ORCA default). All conformers whose energy is within 7 kcal/mol of the lowest conformer at this level of theory are included in step 2B. *Commandline prompt: censo -inp crest_conformers.xyz -solvent toluene -u 7* - *chrg 0 -prog orca -part0 on -func0 pbe-d4 -part0_threshold 7*
   **(B) Screening** based on r2SCAN-3c, single-point energies calculated for the structures from step 1 using the SMD model with parameters for toluene to include solvent effects (r²SCAN-3c/SMD(toluene)//GFN2-xTB/ALPB(toluene)). The resulting single-point energies are combined with thermostatistical contributions (zero-point vibrational energy, entropic and enthalpic vibrational, translational and rotational contributions) evaluated at the GFN2-xTB/ALPB(toluene) level of theory using the modified rigid-rotor harmonicoscillator (mRRHO) approximation (CENSO default) to obtain free energies. All conformers with a free energy that is within 4.5 kcal/mol of the lowest conformer at this level of theory are included in step 2C.
      *Commandline prompt: censo -inp crest_conformers.xyz -solvent toluene -u 7* - *chrg 0 -prog orca -part0 on -func0 pbe-d4 -part0_threshold 7 -part1 on - part1_threshold 4.5*
   **(C) Reoptimization** of the structures (from step 1) with r²SCAN-3c using the SMD solvent model with parameters for toluene and the "lax" convergence criteria setting of CENSO. Entropic and enthalpic contributions are included at the GFN2-xTB/ALPB(toluene) theory level using mRRHO approximation combined with the single-point Hessian approach (CENSO default). All conformers with a free energy that is within 1.5 kcal/mol of the lowest conformer at this level of theory are included in step 2D.
      *Commandline prompt: censo -inp crest_conformers.xyz -solvent toluene -u 7* - *chrg 0 -prog orca -part0 on -func0 pbe-d4 -part0_threshold 7 -part1 on - part1_threshold 4.5 -part2 on* -*optlevel2 lax -part2_threshold 1.5*
   **(D) Final Reranking** of the structures from 2C using single-point energies calculated with the wB97X-V functional using the def2-TZVPP basis set and def2-ECPs and the SMD(toluene) model for solvent effects. Thermostatistical corrections (enthalpy, entropy) are taken from step 2C.
      If there is more than one structure within 1.0 kcal/mol of the lowest structure at this level of theory and the respective structures are similar, then only the lowest structure is taken to the next step (3). If there are two or more structures within 1 kcal/mol with different coordination geometries (different atoms coordinating to Eu, different coordination geometry), they are all included in the next step.
      *Command-line prompt: censo -inp crest_conformers.xyz -solvent toluene -u 7* - *chrg 0 -prog orca -part0 on -func0 pbe-d4 -part1 on -part2 on -part3 on -func3 wb97xv -basis3 def2-tzvpp*
3. **Calculating of EE, EBE, and ES-EBE** from 2D with the wB97X-D3 dispersion-corrected density functional (ORCA keyword !wB97X-D3) using the def2-TZVP basis set and def2-ECPs 28-electron pseudopotential for Eu, the def2-SVP basis set (and if necessary def2-ECPs) for all other atoms, the geometrical Counter Poise correction (ORCA: gCP(DFT/SVP)) for basis set incompleteness error, and the SMD solvation model with (slightly modified, see below) parameters for anisole. Convergence thresholds for geometry optimizations in ORCA are set to "loose" (!LOOSEOPT).
   - **EE: Emission energies** are calculated by optimizing the lowest electronically excited state of the lowest conformer from 2D with time-dependent (TD-)DFT/ωB97X-D3 in the Tamm-Dancoff approximation (TDA) using the basis sets, corrections as specified in 3. For the excited-state optimization, the electronic part of the SMD solvation model (C-PCM) is replaced with the linear-response polarizable-continuum model (LR-PCM) using equilibrium solvation for the gradient calculation during the optimization, and non-equilibrium solvation for final emission energies (ORCA default). The emission energy corresponds to the energy of the first excited state after the optimization is converged.
   - **EBE: Electron binding energies of the neutral coordination compound** are calculated as the difference between the electronic energy of the fully relaxed complex with ground-state Eu(II) and the energy of the fully relaxed complex with Eu(III) (singly positively charged) according to the following equation: EBE = E(Eu2) - E(Eu3). The optimizations use the wB97X-D3 level of theory as specified in 3.
   - **ES-EBE: Electron binding energy of Eu(II) in the lowest electronically excited state** is calculated as the electronic energy difference between the geometry-optimized complex with Eu(II) in its first excited state and the corresponding geometry-optimized complex with Eu(III) (Eu3, singly positively charged) according to the following equation: ES-EBE = E(Eu2*) - E(Eu3). Optimization of the electronically excited Eu(II) complex uses the same TDA-wB97X-D3 level of theory specified in 3B. Optimization of the Eu(III) complex uses the same wB97X-D3 level of theory specified in 3 (sample inputs S2 and S3).

### Technical Details and Sample Inputs:

The workflow described in step 1. and 2. of this protocol is taken from the following article with some modifications to the default energy cutoffs and methods:
*Efficient Quantum Chemical Calculation of Structure Ensembles and Free Energies for Nonrigid Molecules*
S. Grimme, F. Bohle, A. Hansen, P. Pracht, S. Spicher, and M. Stahn
J. Phys. Chem. A 2021, 125, 19, 4039-4054
(https://pubs.acs.org/doi/pdf/10.1021/acs.jpca.1c00971)
All ORCA calculations for steps 2 and 3 employ the resolution-of-the-identity (RI) and chain-of-spheres-exchange (COSX) approximation with the implemented fitting basis sets (def2/J) and default integration grids.

The following sample jobs (S#) include all keywords relating to the methods described above. However, additional keywords and settings might be required in some or all cases to avoid technical problems (e.g. SCF convergence issues). As these settings depend on the individual case, they are not provided here.
*S1: Ground-State-Optimization of Eu(II) complex (Dipole Moment 3A and Ionization Potential 3C)* 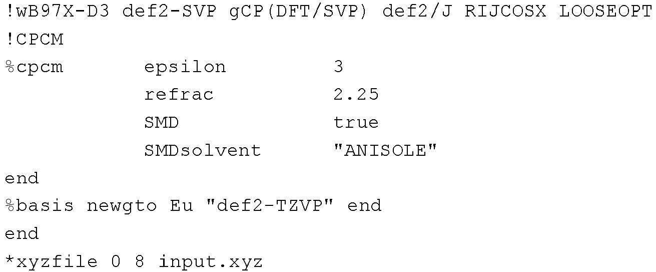
*S2: Excited-State-Optimization of Eu(II) complex (Emission energy 3B and Ionization Potential 3D)* 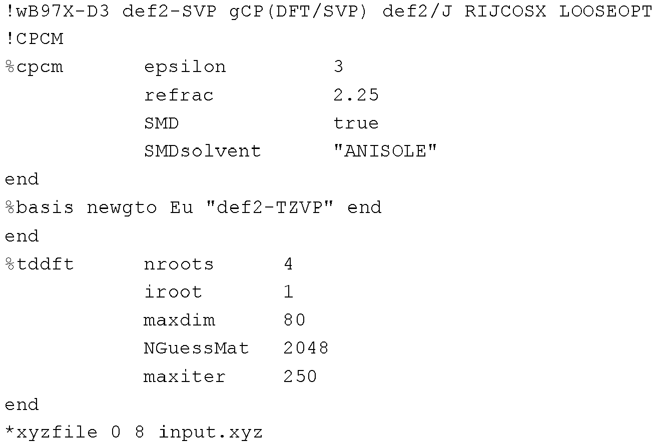
*S3: Ground-State-Optimization of Eu(III) complex (Ionization Potentials 3C and 3D)*

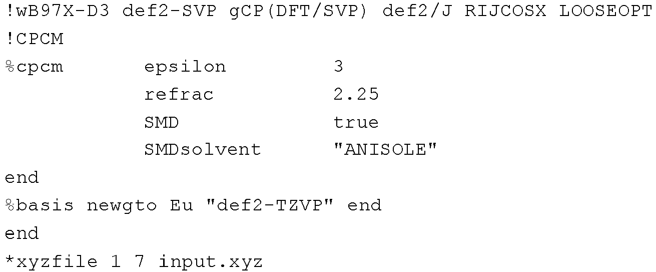

**Collection of materials parameters of coordination compounds that might be present in mixtures according to the invention or various comparative examples:**

**Table 2 Summary of experimental data for various coordination compounds according to FIG. 2 and obtained using quantum mechanical calculations.**

| **Coordination compound** | ***Emission Energy, EE* / *eV*** | ***EBE* / *eV*** | ***ES-EBE* / *eV*** |
|---|---|---|---|
| E32 | 2.61 | 4.96 | 2.10 |
| E33 | 2.65 | 5.15 | 2.19 |
| E34 | 2.66 | 5.27 | 1.83 |
| E35 | 2.78 | 5.13 | 2.09 |
| E01 | 2.70 | 6.09 | 3.01 |
| E36 | 2.60 | 5.24 | 2.37 |
| E03 | 2.70 | 6.40 | 3.37 |
| E05 | 2.70 | 6.09 | 3.01 |
| E08 | 2.79 | 5.50 | 2.45 |
| E10 | 2.78 | 5.46 | 2.43 |
| E13 | 2.40 | 5.51 | 2.75 |
| E15 | 2.58 | 5.85 | 2.94 |
| E20 | 2.54 | 5.66 | 2.71 |

**Collection of second organic materials parameters that might be present in mixtures according to the invention or various comparative examples**

**Table 3 IUPAC names of various organic materials which may be present in the mixture according to invention or comparative examples. The synonyms, HOMO, LUMO and Triplet values are taken from the organic material vendors ^{1,2}.**

| Material | IUPAC name | Synonym | HOMO, eV | LUMO, eV | Triplet, eV |
|---|---|---|---|---|---|
| H1¹ | Tris[2-naphthyl(phenyl)amino]trip henylamine | 2-TNATA | 5.1 | 2.2 | 2.4 |
| H2¹ | Tris(8-hydroxyquinoline)aluminum | Alq3 | 6.3 | 3.4 | 2.0 |
| H3¹ | Bis[2-(diphenylphosphino)phenyl ]ether oxide | DPEPO | 6.8 | 2.6 | 3.0 |
| H4¹ | 4,4,8,8,12,12-Hexa-p-tolyl-4H-8H-12H-12C-aza-dibenzo[cd,mn]pyrene | FATPA | 5.2 | 1.6 | 2.8 |
| H5¹ | 2-Methyl-9,10-bis(naphthalen-2-yl)anthracene | MADN | 5.5 | 2.5 | 1.44 |
| H6¹ | 3,3'-Di(9H-carbazol-9-yl)-1,1'-biphenyl | mCBP | 6.0 | 2.4 | 2.8 |
| H7¹ | 1,3-Di(9H-carbazol-9-yl)benzene | mCP | 5.9 | 2.4 | 2.9 |
| H8¹ | 4,4',4"-Tris[(3-methylphenyl)phenylamino] triphenylamine | m-MTDATA | 5.1 | 2.0 | 2.7 |
| H9² | 2-Phenyl-4,6-bis(3-(triphenylsilyl)phenyl)-1,3,5-triazine | mSiTrz | 6.9 | 2.8 | 3.1 |
| H10² | 5-[5-[2,4,6-tris(1-methylethyl)phenyl]-2-pyridinyl]-5H-Benzimidazo[1,2-albenzimidazole | PPBI | 5.7 | 2.0 | 3.3 |
| H11² | Dibenzo[b,d]furan-2,8-. diylbis(diphenylphosphine Oxide) | PPF | 6.7 | 2.7 | 3.1 |
| H12² | 3-(Diphenylphosphoryl)-9-(4-(diphenylphosphoryl)pheny l)-9H-carbazole | PPO21 | 6.2 | 2.7 | 3.0 |
| H13¹ | Bis[3,5-di(9H -carbazol-9-yl)phenyl]diphenylsilane | SimCP2 | 6.1 | 2.5 | 3.0 |
| H14² | 2,7-Bis(carbazol-9-yl)-9,9-spirobifluorene | Spiro-2CBP | 5.0 | 1.7 | 2.6 |
| H15² | 2,2',7,7'-Tetrakis(diphenylamino)-9,9'-spirobifluorene | Spiro-TAD | 5.4 | 2.35 | 2.4 |
| H16¹ | 1,1-Bis[(di-4-tolylamino)phenyl]cyclohex ane | TAPC | 5.5 | 2.0 | 2.87 |
| H17¹ | 2,5,8,11-Tetrakis(1,1-dimethylethyl)perylene | TBPe | 5.25 | 1.8 | 1.5 |
| H18¹ | 2,2',2"-(1,3,5-Benzinetriyl)-tris(1-phenyl-1-H-benzimidazole) | TPBi | 6.1 | 2.8 | 2.7 |
| H19¹ | Diphenyl[4-(triphenylsilyl)phenyl]phosp hine oxide | TSPO1 | 6.8 | 2.5 | 3.34 |
| H20¹ | 1,4-Bis(triphenylsilyl)benzene | UGH-2 | 7.2 | 2.8 | 3.5 |

The names and relevant parameters of organic materials used in the mixtures are presented in **Table 3.** The organic materials were purchased from Ossila (labeled 1) or Lumtec (labeled 2) and their corresponding HOMO, LUMO and Triplet energy values are taken from the website of the vendors (www.ossila.com and https://www.lumtec.com.tw/) by searching for the material using its name or synonym. The chemical structures for the organic materials are shown in **FIG. 3****.** Here, HOMO and LUMO energies correspond to electron binding energy (EBE) and electron affinity (EA), respectively.

### Emission of mixtures according to the invention and comparative examples

Mixtures of a coordination compound (E) and a second organic material (H) are created by thermal co-evaporation of both materials in an ultra-high-vacuum chamber. In all cases depicted here, the ratio of the coordination compound to the organic material is 1:9 vol%, which is achieved during the sample preparation by fixing the evaporation rates of each material accordingly. The samples are produced on precleaned 25 x 25 mm quartz substrates. The resulting samples are organic thin films with a total thickness reaching 50 nm. Subsequently, there is a 100 nm layer of Aluminum deposited on the thin film to prevent any negative impact of oxygen and moisture exposure on the sample over time.

The samples are characterized by way of time-correlated single photon counting method (TCSPC). The experiment is carried out in a HORIBA Fluoromax 4P spectrofluorometer with a TCSPC extension. The excitation wavelength of the laser used in the experiment is 371 nm. The laser pulse width is < 1 ns. The slit in front of the detector is set to 1 nm and the monochromator in front of the detector is set to the peak emission of the coordination compound in solution (compare **FIG. 7**) used in the mixture.

Example decay curves of coordination compound **E32** in mixtures with three organic materials, as indicated in the graph, are plotted in **FIG. 8** in a semi-logarithmical fashion. To evaluate the efficiency of light emission from the coordination compound in the mixture, the area under each curve is calculated. Prior to the calculation, each curve is normalized to have the same noise level at 1. The initial luminescence from the mixture originates from fluorescence of the organic material used in the mixture. To include only the emission from the coordination compound, the integration is carried out in the range of 150 - 1000 ns. It is considered that a larger area under the curve is directly correlated to larger quantum efficiency of the coordination compound in the mixture. The interpretation is based on WO 2021/244801A1, wherein the excited state lifetime of a divalent europium-containing azacryptates is 1.25 µs, corresponding to a quantum efficiency of 1. Thus, in mixtures that have a lifetime component in the range of 1 µs, it is considered that this decay component originates purely from the coordination compound, and that comparing areas under the curves for each mixture is a valid way of determining which mixture has a larger quantum efficiency.

**Table 4 The area under the emission decay curve of various mixtures of organic materials H (compare FIG. 3) with coordination compounds E (compare FIG. 2). A + or - sign marks whether the condition for each mixture of the organic compound and the coordination compound is satisfied according to claim 1 (EBE), claim 3 (Triplet) and claim 5 (ES-EBE). The last column notes the area under the curve of the excited state lifetime measured for each mixture.**

| Mixture | | | EBE | ES-EBE | Triplet | Area under curve |
|---|---|---|---|---|---|---|
| # | Organic compound | Coordination compound | | | | |
| 1 | H1 | E32 | + | - | - | 2.00 |
| 2 | H2 | E32 | + | - | - | 3.00 |
| 3 | H3 | E34 | + | - | + | 3.50 |
| 4 | H4 | E32 | + | + | + | 22.66 |
| 5 | H5 | E32 | + | - | - | 0.97 |
| 6 | H6 | E32 | + | - | + | 4.78 |
| 7 | H6 | E34 | + | - | + | 3.54 |
| 8 | H7 | E33 | + | - | + | 2.37 |
| 9 | H8 | E32 | + | + | + | 25.25 |
| 10 | H9 | E32 | + | - | + | 2.22 |
| 11 | H11 | E32 | + | - | + | 2.10 |
| 12 | H12 | E34 | + | - | + | 2.71 |
| 13 | H13 | E33 | + | - | + | 3.86 |
| 14 | H14 | E32 | + | + | - | 4.12 |
| 15 | H14 | E34 | - | - | - | 0.66 |
| 16 | H15 | E32 | + | - | - | 3.97 |
| 17 | H16 | E34 | + | - | + | 4.66 |
| 18 | H17 | E32 | + | + | - | 2.16 |
| 19 | H18 | E32 | + | - | + | 2.29 |
| 20 | H19 | E32 | + | - | + | 2.83 |
| 21 | H19 | E33 | + | - | + | 0.49 |
| 22 | H20 | E32 | + | - | + | 6.85 |

The area under the decay curves for a wide range of mixtures of a second organic material, H, combined with various coordination compounds, E, are summarized in **Table 4.** The chemical structures and the names and the relevant properties of the organic materials can be found in FIG. 3 and table 2, respectively. For the Europium coordination compounds, the structures are depicted in FIG. 2, while the relevant parameters are tabulated in **Table 1** above. According to the invention, the organic compound (b), **H,** must have a higher electron binding energy than the charge-neutral coordination compound. A plus (+) in column "EBE" indicates that this criterium is met, otherwise its labeled minus (-). Preferably the organic compound has an electron affinity that is lower than the electron binding energy of the coordination compound in its lowest electronically excited state. A plus (+) in column "ES-EBE" indicates that this criterium is met, otherwise its labeled minus (-). Preferably the second organic compound has a higher triplet energy compared to the emission energy of the coordination compound from the first electronically exited state. A plus (+) in column "Triplet" indicates that this criterium is met, otherwise its labeled minus (-). The area under the decay curve corresponds to the emission quantum yield of the coordination compound. One can easily distinguish two qualitatively different cases: If all criteria with respect to EBE, ES-EBE, and triplet are met than the area under the curve is above 22, and the decay curve is nearly mono-exponential with an excited state lifetime of close to the limit of 1.25 µs. On the other hand, if any of the criteria EBE, ES-EBE, or triplet is not met than the area under the curve is less than 7; thus the emission from the coordination compound is substantially quenched. Thus, mixtures #4 and #9 are examples according to the invention, while the others are comparative examples.

## Claims

1. A mixture of
(a) at least one charge neutral metal-organic coordination compound, comprising a divalent Europium coordinated by a polycyclic organic ligand having the formula (1-1) 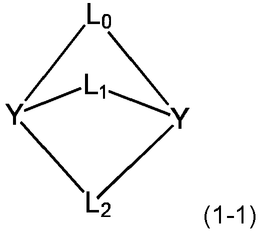 with
• Y independently in each occurrence being selected from Si-R, C-R, B, N, P, preferably N, with **R** being a monovalent organic group formed by removing a hydrogen atom from an organic molecule containing at least one hydrogen atom, and
• **L₀, L₁, L₂** being independently each a divalent organic group formed by removing two hydrogen atoms from an organic molecule containing at least two hydrogen atoms, with
• the shortest sequence of atoms linking the two Y atoms as part of **L₁,** and **L₂** each being 4 to 7, preferably 5 atoms, with one of those 4 to 7, preferably 5 atoms, preferably one non-terminal carbon atom thereof, each independently being selected from B, N, P, S, O, preferably N, or O, and with
• the shortest sequence of atoms linking the two Y atoms as part of **L₀** being 8 or more atoms, and
(b) at least one second organic compound, which is a charge-neutral host material,
wherein the second charge-neutral organic compound has a higher electron binding energy than the charge-neutral metal-organic coordination compound, preferably wherein the second charge-neutral organic compound (b) has an electron binding energy higher than 4.5 eV, preferably higher than 5.3 eV and most preferably higher than 6.0 eV, and wherein compounds (a) and (b) are physically mixed or wherein the second charge-neutral compound (b) has a molecular weight Mₙ above 1000 g/mol and the coordination compound (a) and the second charge-neutral compound (b) are chemically linked with each other, for example by a covalent or coordinative chemical bond.

2. The mixture according to claim 1,
wherein the second charge-neutral organic compound (b) has a higher triplet energy compared to the energy of the coordination compound (a) in its lowest electronically excited state, preferably
wherein the second organic compound (b) has a triplet energy higher than 2.5 eV, preferably higher than 2.6 eV and most preferably higher than 2.7 eV.

3. The mixture according to one of claims 1 or 2,
wherein the second charge-neutral organic compound (b) has an electron affinity that is lower than the electron binding energy of the coordination compound (a) in its lowest electronically excited state, preferably wherein the second organic compound has an electron affinity higher than 2.0eV.

4. The mixture according to one of claims 1 to 3, wherein
the coordination compound (a) is imbedded into the at least one second charge-neutral organic compound (b) at 0.1 - 99.0 vol%, preferably at 1 - 90 vol%, and most preferably at 3 - 30 vol%, based on the mixture which is 100 vol%.

5. The mixture according to one of claims 1 to 4, wherein
the polycyclic organic ligand according to formula (1-1) is selected from aza cryptands according to formulae (1-2) to (1-4): 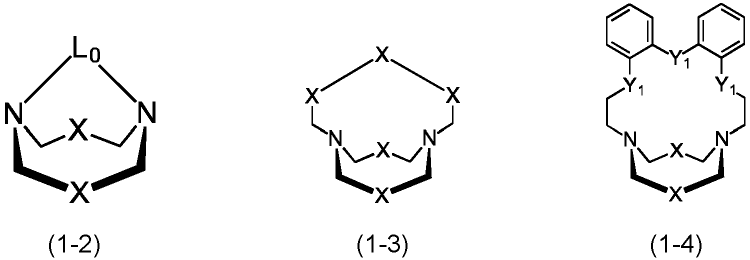 with
• X being independently in each occurrence selected from (2-1) to (2-9), preferably from (2-2), (2-4), or (2-5): 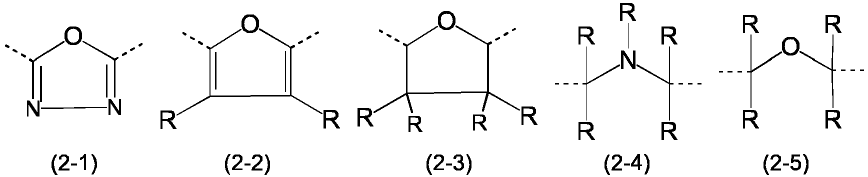 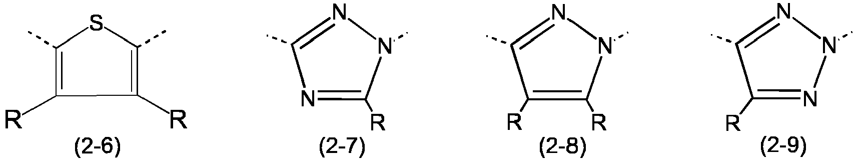
• **Y₁** being independently in each occurrence selected from B-R, N-R, P-R, O, S, preferably from N-R, O, and with
• **R** being identical or different in each occurrence H, D, or any covalently bound substituent, and
• the dashed lines indicating the covalent linkage to the remainder of the polycyclic ligand.

6. The mixture according to one of claims 1 to 5, wherein the coordination compound (a) comprises two singly negatively charged anions that are not covalently linked to the polycyclic organic ligand according to formula (1-1) and the polycyclic organic ligand according to formula (1-1) itself being charge neutral, preferably wherein the two singly negatively charged anions each individually comprise more than 1 atom, preferably more than 3 atoms, more preferably more than 18 atoms.

7. The mixture according to claim 6, wherein the two singly negatively charged anions are identically selected from (3-1) to (3-3) 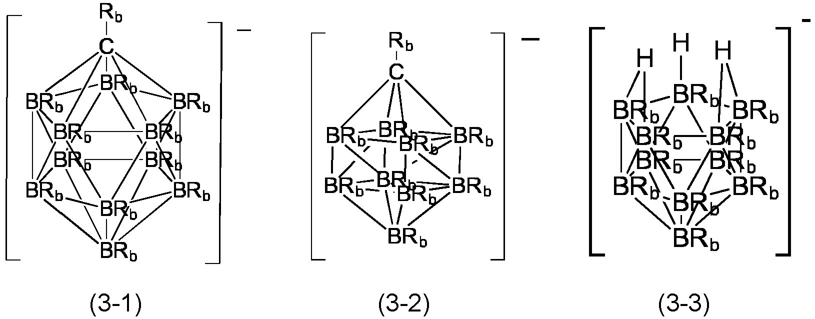 wherein
• **R_{b}** independently in each occurrence represents either hydrogen, deuterium, fluorine, chlorine, bromine, or an alkyl chain, preferably methyl.

8. The mixture according to one of claims 1 to 5 wherein the polycyclic organic ligand according to formula (1-1) is twofold negatively charged, preferably wherein the polycyclic organic ligand according to formula (1-1) comprises two covalently attached carborate cluster fragments selected from (3-4) or (3-5) 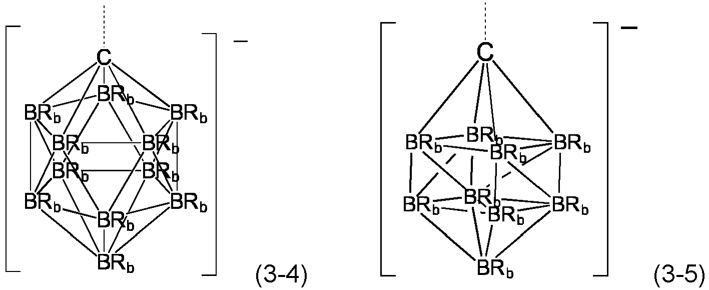 with
• the dashed lines indicating the covalent linkage to the remainder of the polycyclic ligand, and
• **R_{b}** independently in each occurrence representing either hydrogen, deuterium, fluorine, chlorine, bromine, or an alkyl chain, preferably methyl.

9. The mixture according to any of claim 1 to 7, wherein the coordination compound (a) is selected from E01 to E08

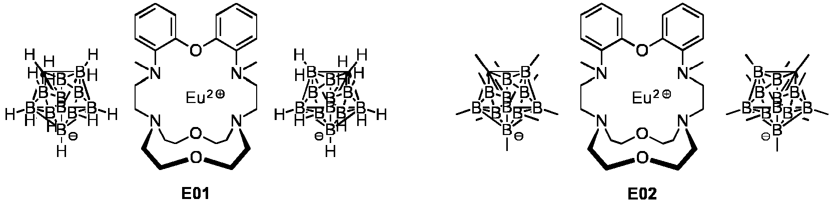

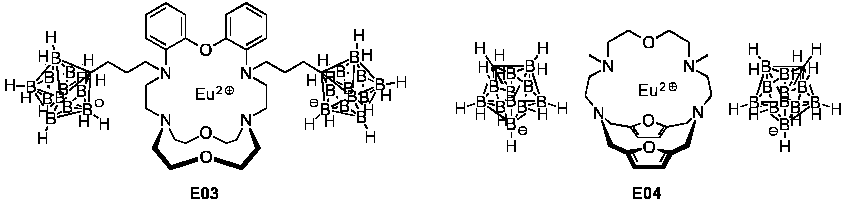

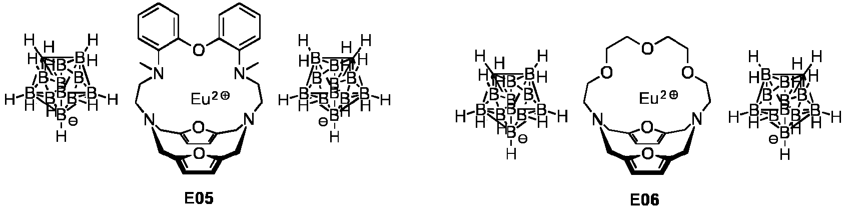

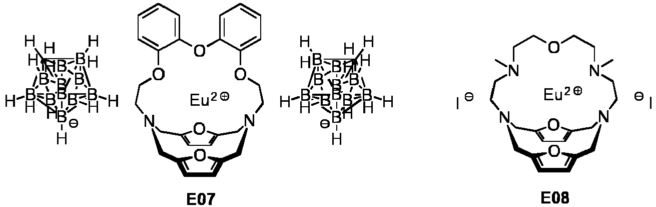

10. The mixture according to one of claims 1 to 9, wherein the second charge-neutral compound (b) comprises heteroarene fragments selected from benzene, pyridine, pyrrole, furan, carbazole, dibenzofuran, triazine, triazole, or benzofuran.

11. The use of a mixture according to any of claims 1 to 10 as active emitting material in electroluminescent electronics applications,.

12. An organic electronic device, comprising:
a first electrode,
a second electrode, and
a first organic layer arranged such that it is electrically interposed between the first and second electrodes, wherein the first organic layer comprises a mixture according to one of claims 1 to 10,
wherein the organic electronic device preferably is an organic light emitting diode, emitting preferably substantially in the blue spectra region at <500 nm.

13. The organic electronic device according to claim 12 comprising a second substantially organic layer which contains an organic material and which is in physical contact with the first organic layer, with the organic material in the second substantially organic layer
(i) having a higher electron binding energy than the charge-neutral coordination compound (a),
(ii) and/or having a higher triplet energy compared to the emission energy of the coordination compound (a) in its lowest electronically excited state,
(iii) and/or having an electron affinity that is lower than the electron binding energy of the coordination compound (a) in its lowest electronically excited state,
wherein preferably a sequence of the first organic layer and the second substantially organic layer is arranged such that they are electrically interposed between the first and second electrodes.

14. A method of forming an organic electronic device according to one of claim 12 or 13, the method comprising:
forming a layer of a mixture according to one of claims 1 to 10, by deposition from a gas phase, preferably using an evaporation and/or sublimation and/or carrier gas process, or by deposition from solution.

15. An organic electronic device, comprising:
a first electrode,
a second electrode, and
an organic layer arranged such that it is electrically interposed between the first and second electrodes, wherein the organic layer comprises a metal organic complex, wherein the metal organic complex comprises a divalent Europium and two singly negatively charged anions selected from (3-1) or two covalently attached anionic fragments selected from (3-4) or (3-5): 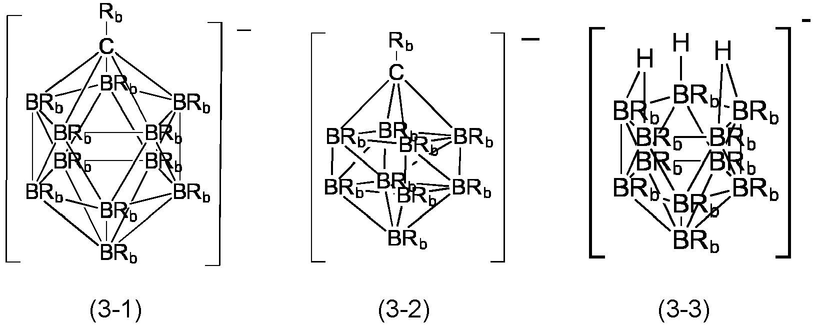 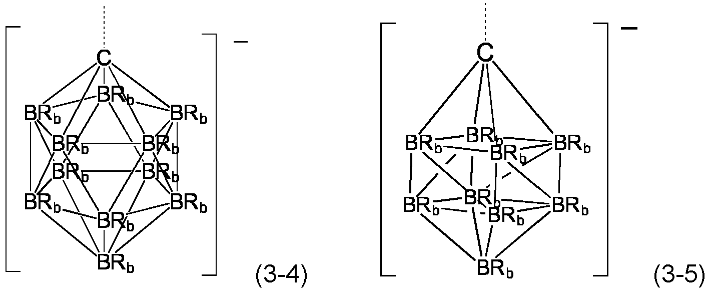 with
• the dashed lines indicating the covalent linkage to the remainder of the metal organic complex, and
• **R_{b}** independently in each occurrence represents either hydrogen, deuterium, fluorine, chlorine, bromine, or an alkyl chain, preferably methyl.

## Patentansprüche

1. Mischung von
(a) mindestens einer ladungsneutralen metallorganischen Koordinationsverbindung, die ein zweiwertiges Europium umfasst, das durch einen polycyclischen organischen Liganden mit der Formel (1-1) koordiniert ist: 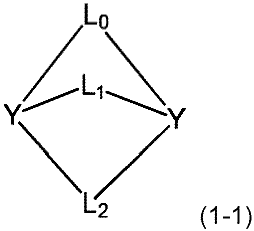 wobei
• Y unabhängig bei jedem Auftreten aus Si-R, C-R, B, N, P, vorzugsweise N, ausgewählt ist, wobei R eine einwertige organische Gruppe ist, die durch Entfernung eines Wasserstoffatoms von einem organischen Molekül, das mindestens ein Wasserstoffatom enthält, gebildet wird, und
• L₀, L₁, L₂ unabhängig jeweils eine zweiwertige organische Gruppe, die durch Entfernen von zwei Wasserstoffatomen von einem organischen Molekül, das mindestens zwei Wasserstoffatome enthält, gebildet wird, sind, wobei
• die kürzeste Abfolge von Atomen, die die beiden Y-Atome als Teil von L₁ und L₂ verknüpft, jeweils 4 bis 7 und vorzugsweise 5 Atome beträgt, wobei eines dieser 4 bis 7 und vorzugsweise 5 Atome, vorzugsweise ein nicht endständiges Kohlenstoffatom davon, jeweils unabhängig aus B, N, P, S, O, vorzugsweise N oder O, ausgewählt ist, und wobei
• die kürzeste Abfolge von Atomen, die die beiden Y-Atome als Teil von L₀ verknüpft, 8 oder mehr Atome beträgt, und
(b) mindestens einer zweiten organischen Verbindung, bei der es sich um ein ladungsneutrales Wirtsmaterial handelt,
wobei die zweite ladungsneutrale organische Verbindung eine höhere Elektronenbindungsenergie als die ladungsneutrale metallorganische Koordinationsverbindung aufweist, vorzugsweise wobei die zweite ladungsneutrale organische Verbindung (b) eine Elektronenbindungsenergie von mehr als 4,5 eV, vorzugsweise mehr als 5,3 eV und ganz besonders bevorzugt mehr als 6,0 eV aufweist, und wobei die Verbindungen (a) und (b) physikalisch gemischt sind oder wobei die zweite ladungsneutrale Verbindung (b) ein Molekulargewicht Mₙ über 1000 g/mol aufweist und die Koordinationsverbindung (a) und die zweite ladungsneutrale Verbindung (b) chemisch miteinander verknüpft sind, zum Beispiel über eine kovalente oder koordinative chemische Bindung.

2. Mischung nach Anspruch 1,
wobei die zweite ladungsneutrale organische Verbindung (b) eine höhere Triplettenergie im Vergleich zu der Energie der Koordinationsverbindung (a) in ihrem niedrigsten elektronisch angeregten Zustand aufweist, vorzugsweise
wobei die zweite organische Verbindung (b) eine Triplettenergie von mehr als 2,5 eV, vorzugsweise mehr als 2,6 eV und ganz besonders bevorzugt mehr als 2,7 eV aufweist.

3. Mischung nach einem der Ansprüche 1 oder 2,
wobei die zweite ladungsneutrale organische Verbindung (b) eine Elektronenaffinität aufweist, die niedriger als die Elektronenbindungsenergie der Koordinationsverbindung (a) in ihrem niedrigsten elektronisch angeregten Zustand ist, vorzugsweise
wobei die zweite organische Verbindung eine Elektronenaffinität von mehr als 2,0 eV aufweist.

4. Mischung nach einem der Ansprüche 1 bis 3, wobei die Koordinationsverbindung (a) in einer Menge von 0,1 - 99,0 Vol.-%, vorzugsweise 1 - 90 Vol.-% und ganz besonders bevorzugt 3 - 30 Vol.-%, bezogen auf die Mischung, die 100 Vol.-% beträgt, in die mindestens eine zweite ladungsneutrale organische Verbindung (b) eingebettet ist.

5. Mischung nach einem der Ansprüche 1 bis 4, wobei der polycyclische organische Ligand gemäß Formel (1-1) aus Azakryptanden gemäß den Formeln (1-2) bis (1-4) ausgewählt ist: 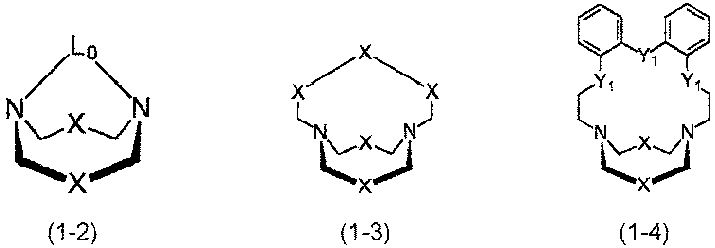 wobei
• X unabhängig bei jedem Auftreten aus (2-1) bis (2-9), vorzugsweise aus (2-2), (2-4) oder (2-5), ausgewählt ist: 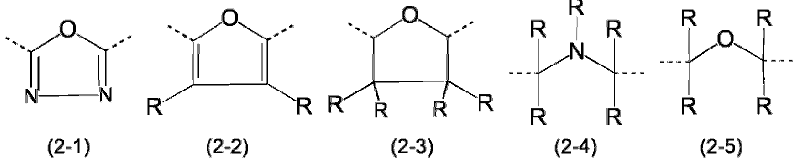 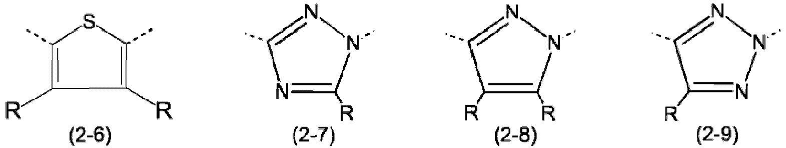
• wobei Y₁ bei jedem Auftreten unabhängig aus B-R, N-R, P-R, O, S, vorzugsweise aus N-R, O, ausgewählt ist und wobei
• R bei jedem Auftreten gleich oder verschieden H, D oder ein beliebiger kovalent gebundener Substituent ist und
• die gestrichelten Linien die kovalente Verknüpfung mit dem Rest des polycyclischen Liganden anzeigen.

6. Mischung nach einem der Ansprüche 1 bis 5, wobei die Koordinationsverbindung (a) zwei einfach negativ geladene Anionen umfasst, die nicht kovalent mit dem polycyclischen organischen Liganden gemäß Formel (1-1) verknüpft sind, und der polycyclische organische Ligand gemäß Formel (1-1) selbst ladungsneutral ist, vorzugsweise wobei die zwei einfach negativ geladenen Anionen jeweils einzeln mehr als 1 Atom, vorzugsweise mehr als 3 Atome, besonders bevorzugt mehr als 18 Atome, umfassen.

7. Mischung nach Anspruch 6, wobei die beiden einfach negativ geladenen Anionen gleich aus (3-1) bis (3-3) ausgewählt sind: 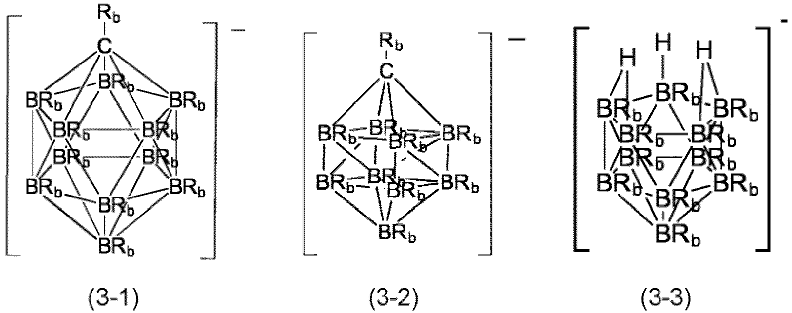 wobei
• R_{b} unabhängig bei jedem Auftreten entweder Wasserstoff, Deuterium, Fluor, Chlor, Brom oder eine Alkylkette, vorzugsweise Methyl, ist.

8. Mischung nach einem der Ansprüche 1 bis 5, wobei der polycyclische organische Ligand gemäß Formel (1-1) zweifach negativ geladen ist, vorzugsweise wobei der polycyclische organische Ligand gemäß Formel (1-1) zwei kovalent gebundene Carboratclusterfragmente umfasst, die aus (3-4) oder (3-5) ausgewählt sind: 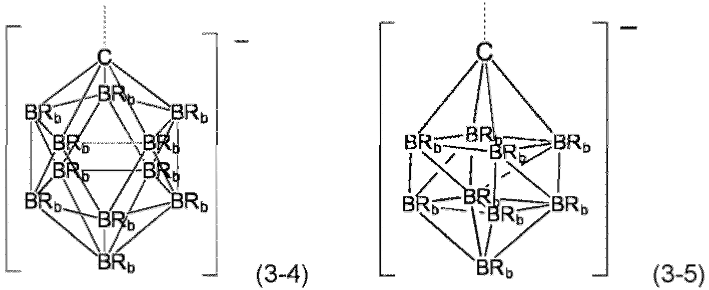 wobei
• die gestrichelten Linien die kovalente Verknüpfung mit dem Rest des polycyclischen Liganden anzeigen und
• R_{b} unabhängig bei jedem Auftreten entweder Wasserstoff, Deuterium, Fluor, Chlor, Brom oder eine Alkylkette, vorzugsweise Methyl, ist.

9. Mischung nach einem der Ansprüche 1 bis 7, wobei die Koordinationsverbindung (a) aus E01 bis E08 ausgewählt ist:

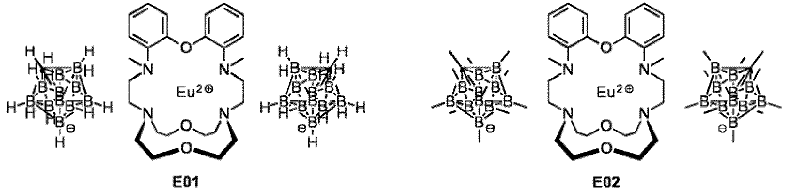

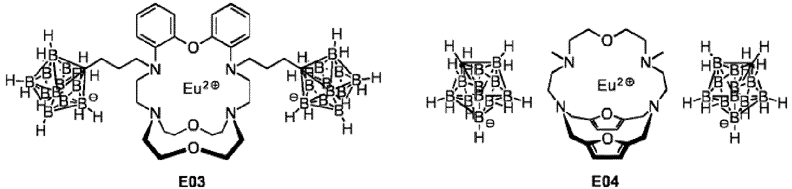

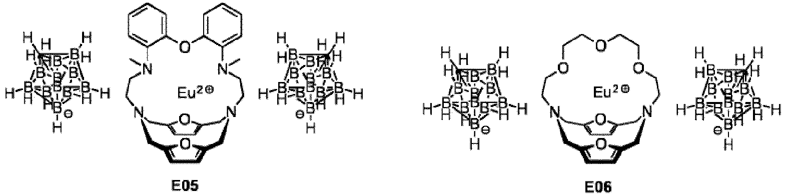

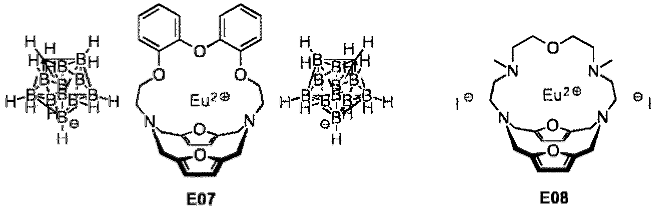

10. Mischung nach einem der Ansprüche 1 bis 9, wobei die zweite ladungsneutrale Verbindung (b) Heteroarenfragmente umfasst, die aus Benzol, Pyridin, Pyrrol, Furan, Carbazol, Dibenzofuran, Triazin, Triazol oder Benzofuran ausgewählt sind.

11. Verwendung einer Mischung nach einem der Ansprüche 1 bis 10 als aktives emittierendes Material in Elektrolumineszenz-Elektronikanwendungen.

12. Organische elektronische Vorrichtung, umfassend:
eine erste Elektrode,
eine zweite Elektrode und
eine erste organische Schicht, die so angeordnet ist, dass sie sich elektrisch zwischen der ersten und der zweiten Elektrode befindet, wobei die erste organische Schicht eine Mischung nach einem der Ansprüche 1 bis 10 umfasst,
wobei es sich bei der organischen elektronischen Vorrichtung vorzugsweise um eine organische Leuchtdiode handelt, die vorzugsweise weitgehend im blauen Spektralbereich bei <500 nm emittiert.

13. Organische elektronische Vorrichtung nach Anspruch 12, umfassend eine zweite weitgehend organische Schicht, die ein organisches Material enthält und die in physischem Kontakt mit der ersten organischen Schicht steht, wobei das organische Material in der zweiten weitgehend organischen Schicht
(i) eine höhere Elektronenbindungsenergie als die ladungsneutrale Koordinationsverbindung (a) aufweist
(ii) und/oder eine höhere Triplettenergie im Vergleich zu der Emissionsenergie der Koordinationsverbindung (a) in ihrem niedrigsten elektronisch angeregten Zustand aufweist
(iii) und/oder eine Elektronenaffinität aufweist, die niedriger als die Elektronenbindungsenergie der Koordinationsverbindung (a) in ihrem niedrigsten elektronisch angeregten Zustand ist,
wobei vorzugsweise eine Abfolge der ersten organischen Schicht und der zweiten weitgehend organischen Schicht so angeordnet ist, dass sie sich elektrisch zwischen der ersten und der zweiten Elektrode befinden.

14. Verfahren zur Bildung einer organischen elektronischen Vorrichtung nach Anspruch 12 oder 13, wobei das Verfahren Folgendes umfasst:
Bilden einer Schicht aus einer Mischung nach einem der Ansprüche 1 bis 10 durch Abscheidung aus einer Gasphase, vorzugsweise unter Verwendung eines Verdampfungs- und/oder Sublimations- und/oder Trägergasprozesses, oder durch Abscheidung aus Lösung.

15. Organische elektronische Vorrichtung, umfassend:
eine erste Elektrode,
eine zweite Elektrode und
eine organische Schicht, die so angeordnet ist, dass sie sich elektrisch zwischen der ersten und der zweiten Elektrode befindet, wobei die organische Schicht einen metallorganischen Komplex umfasst, wobei der metallorganische Komplex ein zweiwertiges Europium und zwei einfach negativ geladene Anionen, die aus (3-1) ausgewählt sind, oder zwei kovalent gebundene anionische Fragmente, die aus (3-4) oder (3-5) ausgewählt sind, umfasst: 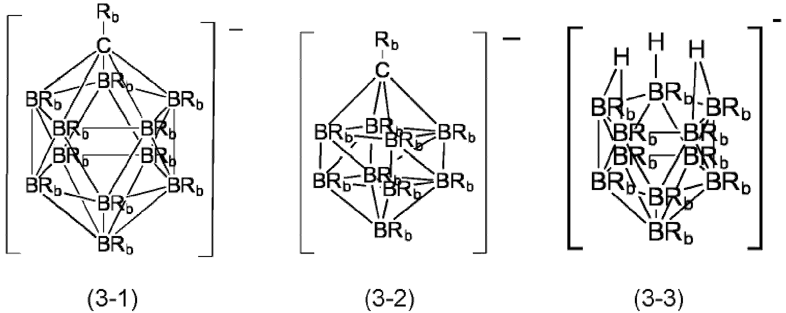 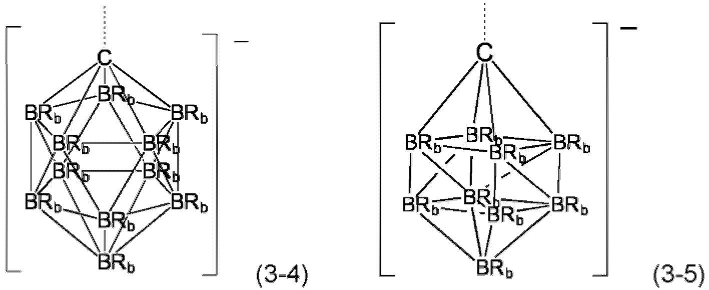 wobei
• die gestrichelten Linien die kovalente Verknüpfung mit dem Rest des metallorganischen Komplexes anzeigen und
• R_{b} unabhängig bei jedem Auftreten entweder Wasserstoff, Deuterium, Fluor, Chlor, Brom oder eine Alkylkette, vorzugsweise Methyl, ist.

## Revendications

1. Mélange de
(a) au moins un composé de coordination métal-organique de charge neutre, comprenant un europium divalent coordonné par un ligand organique polycyclique répondant à la formule (1-1) 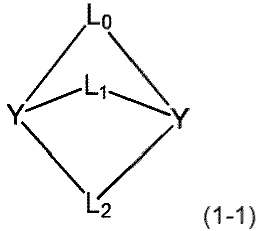 avec
• Y étant indépendamment dans chaque occurrence choisi parmi Si-R, C-R, B, N, P, de préférence N, R étant un groupe organique monovalent formé par élimination d'un atome d'hydrogène d'une molécule organique contenant au moins un atome d'hydrogène, et
• L₀, L₁, L₂ étant indépendamment chacun un groupe organique divalent formé par élimination de deux atomes d'hydrogène d'une molécule organique contenant au moins deux atomes d'hydrogène, avec
• la plus courte séquence d'atomes reliant les deux atomes Y faisant partie de L₁, et L₂ étant chacun de 4 à 7, de préférence 5 atomes, l'un de ces 4 à 7, de préférence 5 atomes, de préférence un atome de carbone non terminal, étant chacun indépendamment choisi parmi B, N, P, S, O, de préférence N, ou O, et avec
• la plus courte séquence d'atomes reliant les deux atomes Y en tant que partie de L₀ étant de 8 atomes ou plus, et
(b) au moins un second composé organique, qui est un matériau hôte à charge neutre,
le second composé organique à charge neutre ayant une énergie de liaison électronique plus élevée que le composé de coordination métal-organique à charge neutre, de préférence le second composé organique à charge neutre (b) ayant une énergie de liaison électronique supérieure à 4,5 eV, de préférence supérieure à 5,3 eV et le plus préférablement supérieure à 6,0 eV, et les composés (a) et (b) étant physiquement mélangés ou le second composé de charge neutre (b) ayant un poids moléculaire Mₙ supérieur à 1000 g/mol et le composé de coordination (a) et le second composé de charge neutre (b) étant chimiquement liés l'un à l'autre, par exemple par une liaison chimique covalente ou coordinative.

2. Mélange selon la revendication 1,
le second composé organique de charge neutre (b) ayant une énergie de triplet plus élevée par rapport à l'énergie du composé de coordination (a) dans son état électroniquement excité le plus bas, de préférence
le second composé organique (b) ayant une énergie de triplet supérieure à 2,5 eV, de préférence supérieure à 2,6 eV et le plus préférablement supérieure à 2,7 eV.

3. Mélange selon l'une des revendications 1 ou 2,
le second composé organique de charge neutre (b) ayant une affinité électronique inférieure à l'énergie de liaison électronique du composé de coordination (a) dans son état électroniquement excité le plus bas, de préférence
le second composé organique ayant une affinité électronique supérieure à 2,0 eV.

4. Mélange selon l'une des revendications 1 à 3,
le composé de coordination (a) étant incorporé dans l'au moins un second composé organique de charge neutre (b) à raison de 0,1 à 99,0 % vol, de préférence à raison de 1 à 90 % vol, et le plus préférablement à raison de 3 à 30 % vol, sur la base du mélange qui est de 100 % vol.

5. Mélange selon l'une des revendications 1 à 4,
le ligand organique polycyclique selon la formule (1-1) étant choisi parmi les aza cryptands selon les formules (1-2) à (1-4) : 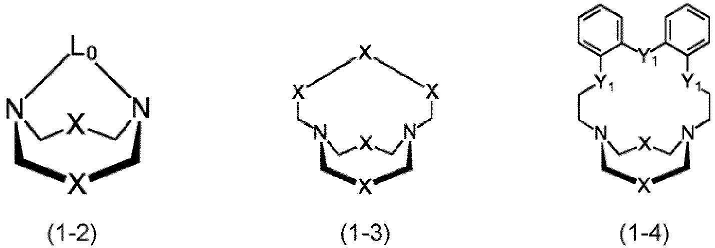 avec
• X étant indépendamment dans chaque occurrence choisi de (2-1) à (2-9), de préférence parmi (2-2), (2-4), ou (2-5) : 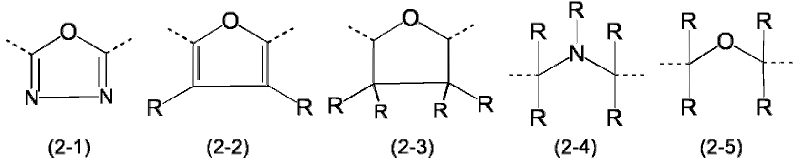 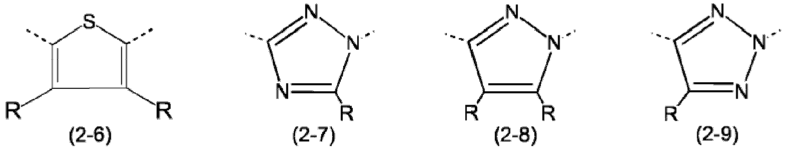
• Y₁ étant indépendamment dans chaque occurrence choisi parmi B-R, N-R, P-R, O, S, de préférence parmi N-R, O, et avec
• R étant identique ou différent dans chaque occurrence H, D, ou tout substituant lié de manière covalente, et
• les lignes en pointillé indiquant la liaison covalente avec le reste du ligand polycyclique.

6. Mélange selon l'une des revendications 1 à 5, le composé de coordination (a) comprenant deux anions singulièrement chargés négativement qui ne sont pas liés de manière covalente au ligand organique polycyclique selon la formule (1-1) et le ligand organique polycyclique selon la formule (1-1) étant lui-même de charge neutre, de préférence les deux anions singulièrement chargés négativement comprenant chacun individuellement plus de 1 atome, de préférence plus de 3 atomes, plus préférablement plus de 18 atomes.

7. Mélange selon la revendication 6, les deux anions singulièrement chargés négativement étant identiquement choisis de (3-1) à (3-3) 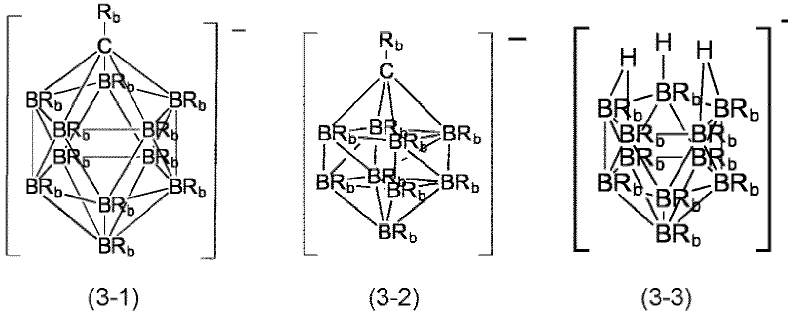 avec
• R_{b} représentant indépendamment à chaque occurrence soit l'hydrogène, soit le deutérium, soit le fluor, soit le chlore, soit le brome, soit une chaîne alkyle, de préférence méthyle.

8. Mélange selon l'une des revendications 1 à 5, le ligand organique polycyclique selon la formule (1-1) étant doublement chargé négativement, de préférence le ligand organique polycyclique selon la formule (1-1) comprenant deux fragments d'amas de carborate attachés de manière covalente choisis parmi (3-4) ou (3-5). 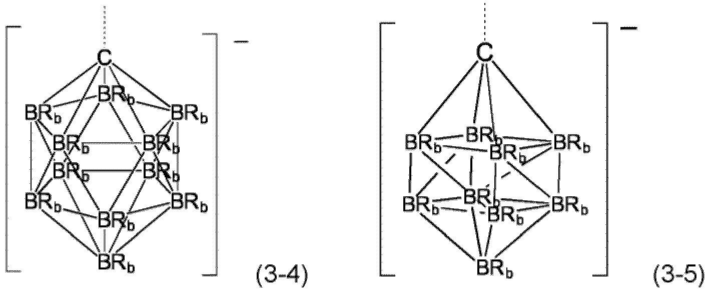 avec
• les lignes en pointillé indiquant la liaison covalente avec le reste du ligand polycyclique, et
• R_{b} représentant indépendamment à chaque occurrence soit l'hydrogène, soit le deutérium, soit le fluor, soit le chlore, soit le brome, soit une chaîne alkyle, de préférence méthyle.

9. Mélange selon l'une quelconque des revendications 1 à 7, le composé de coordination (a) étant choisi parmi E01 à E08.

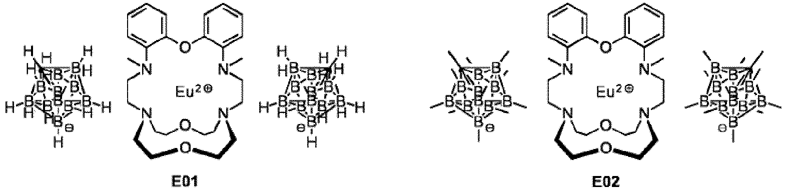

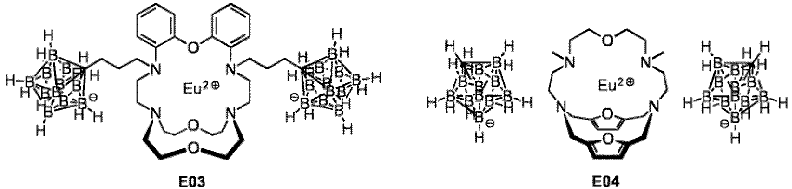

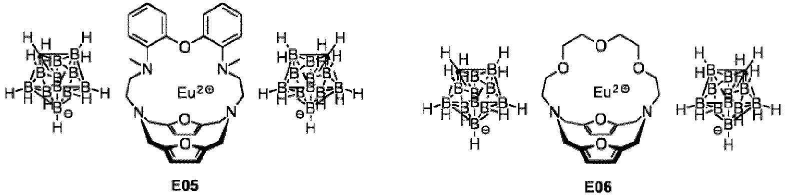

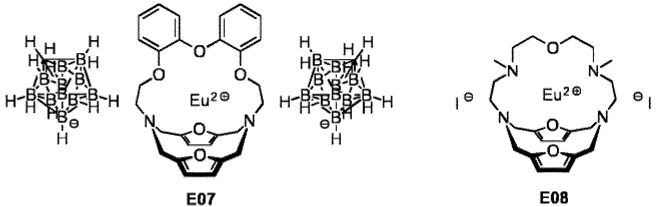

10. Mélange selon l'une des revendications 1 à 9, le second composé de charge neutre (b) comprenant des fragments d'hétéroarènes choisis parmi le benzène, la pyridine, le pyrrole, le furane, le carbazole, le dibenzofurane, la triazine, le triazole ou le benzofurane.

11. Utilisation d'un mélange selon l'une quelconque des revendications 1 à 10, en tant que matériau émetteur actif dans des applications électroniques électroluminescentes.

12. Dispositif électronique organique, comprenant :
une première électrode,
une seconde électrode, et
une première couche organique agencée de manière à être électriquement interposée entre la première et la seconde électrode, la première couche organique comprenant un mélange selon l'une des revendications 1 à 10,
le dispositif électronique organique étant de préférence une diode électroluminescente organique, émettant de préférence sensiblement dans la région du spectre bleu à <500 nm.

13. Dispositif électronique organique selon la revendication 12, comprenant une seconde couche sensiblement organique qui contient un matériau organique et qui est en contact physique avec la première couche organique, avec le matériau organique dans la seconde couche sensiblement organique
(i) ayant une énergie de liaison électronique plus élevée que celle du composé de coordination neutre (a),
(ii) et/ou ayant une énergie de triplet plus élevée par comparaison à l'énergie d'émission du composé de coordination (a) dans son état électroniquement excité le plus bas,
(iii) et/ou ayant une affinité électronique inférieure à l'énergie de liaison électronique du composé de coordination (a) dans son état d'excitation électronique le plus bas,
de préférence, une séquence de la première couche organique et de la seconde couche sensiblement organique étant agencée de telle sorte qu'elles sont électriquement interposées entre les première et seconde électrodes.

14. Procédé de formation d'un dispositif électronique organique selon l'une des revendications 12 ou 13, le procédé comprenant :
la formation d'une couche d'un mélange selon l'une des revendications 1 à 10, par dépôt à partir d'une phase gazeuse, de préférence en utilisant un procédé d'évaporation et/ou de sublimation et/ou de gaz porteur, ou par dépôt à partir d'une solution.

15. Dispositif électronique organique, comprenant :
une première électrode,
une seconde électrode, et
une couche organique agencée de telle sorte qu'elle est électriquement interposée entre la première et la seconde électrode, la couche organique comprenant un complexe métal-organique, le complexe métal-organique comprenant un Europium divalent et deux anions singulièrement chargés négativement choisis parmi (3-1) ou deux fragments anioniques attachés de façon covalente choisis parmi (3-4) ou (3-5) : 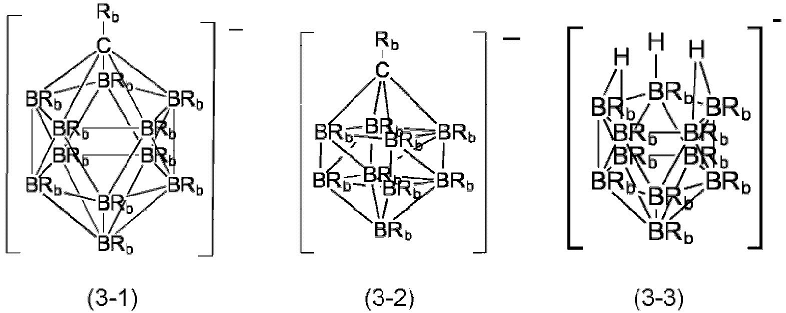 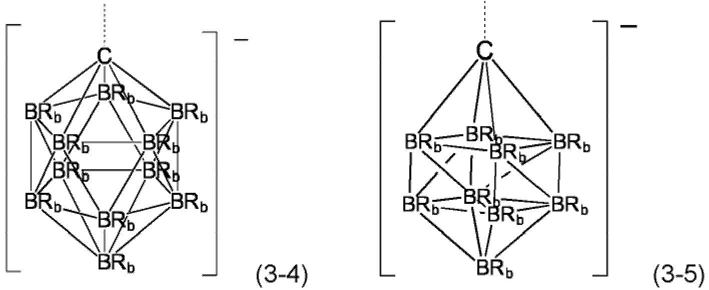 avec
• les lignes en pointillé indiquant la liaison covalente avec le reste du complexe métallo-organique, et
• R_{b} représentant indépendamment à chaque occurrence soit l'hydrogène, soit le deutérium, soit le fluor, soit le chlore, soit le brome, soit une chaîne alkyle, de préférence méthyle.
